# EUROPÄISCHE PATENTSCHRIFT

(11) **EP 3 487 865 B1**
(45) Veröffentlichungstag und Bekanntmachung des Hinweises auf die Patenterteilung: **23.11.2022**
(21) Anmeldenummer: 17749133.9
(22) Anmeldetag: 20.07.2017
(51) Int. Cl.: C07F 15/00, H01L 51/00, H05B 33/14, H01L 51/50, C09K 11/06

(54) **DI- UND OLIGONUKLEARE METALLKOMPLEXE MIT TRIPODALEN BIDENTATEN TEILLIGANDEN SOWIE DEREN VERWENDUNG IN ELEKTRONISCHEN VORRICHTUNGEN**
DINUCLEAR AND OLIGONUCLEAR METAL COMPLEXES CONTAINING TRIPODAL BIDENTATE PART LIGANDS AND THEIR USE IN ELECTRONIC DEVICES
COMPLEXES MÉTALLIQUES DINUCLÉAIRES ET OLIGONUCLÉAIRES COMPRENANT DES SOUS-UNITÉS DE LIGANDS TRIPODES BIDENTÉES AINSI QUE LEUR UTILISATION DANS DES DISPOSITIFS ÉLECTRONIQUES

(30) Priorität: 25.07.2016 EP 16180997
(43) Veröffentlichungstag der Anmeldung: 29.05.2019
(73) Patentinhaber: Merck Patent GmbH, 64293 Darmstadt (DE)
(72) Erfinder: STOESSEL, Philipp, 60389 Frankfurt am Main (DE); EHRENREICH, Christian, 64285 Darmstadt (DE)
(86) Internationale Anmeldenummer: PCT/EP2017/068290
(87) Internationale Veröffentlichungsnummer: WO 2018/019687

(56) Entgegenhaltungen:
- WO-A1-2016/124304
- WO-A1-2018/041769
- WO-A1-2018/069197
- WO-A1-2018/069273
- WO-A1-2018/077769
- US-A1- 2014 326 964
- TANIMA HAJRA, JITENDRA K. BERA, VADAPALLI CHANDRASEKHAR: "Multimetallic compounds containing cyclometalated Ir(III) units: Synthesis,structure, electrochemistry and photophysical properties", INORGANICA CHIMICA ACTA, Bd. 372, Nr. 1, 13. Januar 2011 (2011-01-13), Seiten 53-61, XP002775316, DOI: 10.1016/j.ica.2011.01.021

## Beschreibung

Die vorliegende Erfindung betrifft bi- und oligonukleare Metallkomplexe, welche sich für den Einsatz als Emitter in organischen Elektrolumineszenzvorrichtungen eignen.

Gemäß dem Stand der Technik werden in phosphoreszierenden organischen Elektrolumineszenzvorrichtungen (OLEDs) als Triplettemitter vor allem bis- und tris-ortho-metallierte Iridiumkomplexe mit aromatischen Liganden eingesetzt, wobei die Liganden über ein negativ geladenes Kohlenstoffatom und ein neutrales Stickstoffatom oder über ein negativ geladenes Kohlenstoffatom und ein neutrales Carben-Kohlenstoffatom an das Metall binden. Beispiele für solche Komplexe sind Tris(phenylpyridyl)-iridium(III) und Derivate davon, wobei als Liganden beispielsweise 1- oder 3-Phenylisochinoline, 2-Phenylchinoline oder Phenylcarbene einsetzt werden.

Eine Verbesserung der Stabilität der Komplexe konnte durch die Verwendung polypodaler Liganden erreicht werden, wie beispielsweise in WO 2004/081017 oder US 7,332,232 beschrieben. Auch wenn diese Komplexe Vorteile gegenüber Komplexen zeigen, die ansonsten die gleiche Ligandenstruktur aufweisen, deren einzelne Liganden jedoch nicht polypodal verbrückt sind, gibt es auch noch Verbesserungsbedarf. So sind auch bei Komplexen mit polypodalen Liganden noch Verbesserungen in Bezug auf die Eigenschaften bei Verwendung in einer organischen Elektrolumineszenzvorrichtung, insbesondere in Bezug auf Effizienz, Spannung und/oder Lebensdauer, wünschenswert.

T. Hajra et al. (Inorganica Chimica Acta 2011, 372(1), 53-61) offenbart eine Iridiumverbindung enthaltend drei Iridiumatome und eine hexadentaten tripodalen Liganden, an dem drei gleiche bidentate Teilliganden an jeweils ein Iridiumatom koordinieren. Auch US 2014/0326964 offenbart einen Iridiumkomplex für die Verwendung in OLEDs, in dem drei bidentate Teilliganden an drei unterschiedliche Iridiumatome koordinieren. Komplexe, in denen drei bidentate Teilliganden an dasselbe Iridiumatom koordinieren, sind nicht offenbart.

Aufgabe der vorliegenden Erfindung ist die Bereitstellung neuer Metallkomplexe, welche sich als Emitter für die Verwendung in OLEDs eignen. Insbesondere ist die Aufgabe, Emitter bereitzustellen, welche verbesserte Eigenschaften in Bezug auf Effizienz, Betriebsspannung und/oder Lebensdauer zeigen.

Überraschend wurde gefunden, dass bi- und oligonukleare Iridiumkomplexe, in denen zwei oder mehr Metallkomplexe, von denen mindestens einer ein Iridiumkomplex mit einem hexadentaten tripodalen Liganden ist, über einen Linker miteinander verknüpft sind, diese Aufgabe lösen und sich sehr gut für die Verwendung in einer organischen Elektrolumineszenzvorrichtung eignen. Diese Komplexe und organische Elektrolumineszenzvorrichtungen, welche diese Komplexe enthalten, sind der Gegenstand der vorliegenden Erfindung. Diese Komplexe zeigen gute Effizienz und Löslichkeit, sowie schmale Emissionsspektren.

Gegenstand der Erfindung ist eine Verbindung gemäß der folgenden Formel (1), 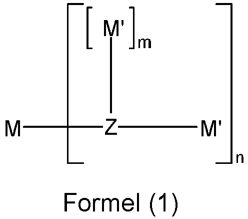 wobei für die verwendeten Symbole und Indizes gilt:
- M: ist ein Iridiumkomplex der folgenden Struktur 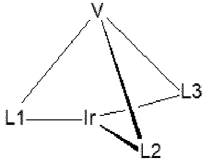
enthaltend einen hexadentaten tripodalen Liganden, in dem drei bidentate Teilliganden L1, L2 und L3 an ein Iridiumatom koordinieren und die drei bidentaten Teilliganden, die gleich oder verschieden sein können, über eine Brücke V der folgenden Formel (5a")verknüpft sind, 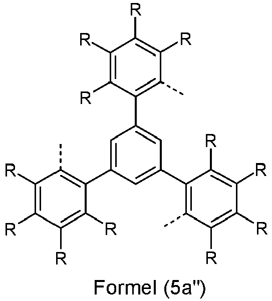
wobei die gestrichelte Bindung die Bindung der bidentaten Teilliganden an diese Struktur darstellt;
und wobei die bidentaten Teilliganden L1, L2 und L3 gleich oder verschieden bei jedem Auftreten ausgewählt sind aus den Strukturen der Formeln (L-1-1), (L-1-2), (L-2-1), (L-2-2), (L-3-3) oder (L-4) bis (L-31), 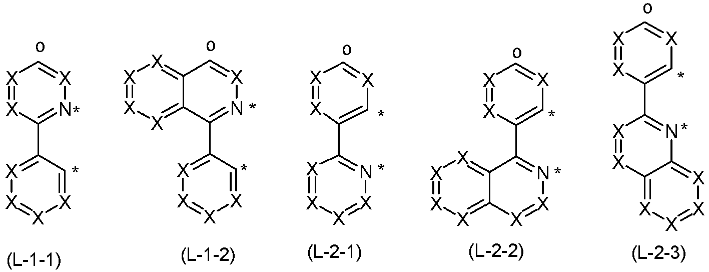 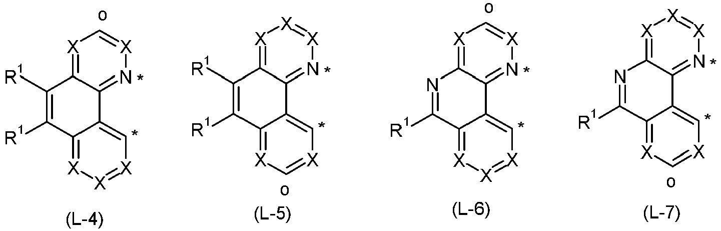 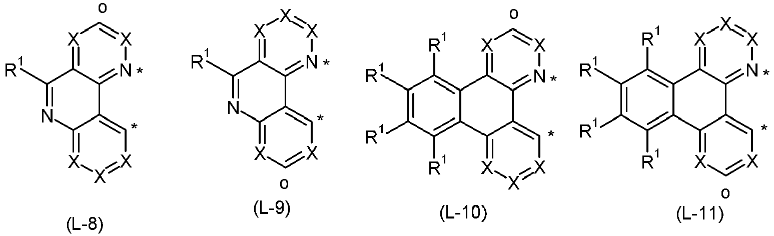 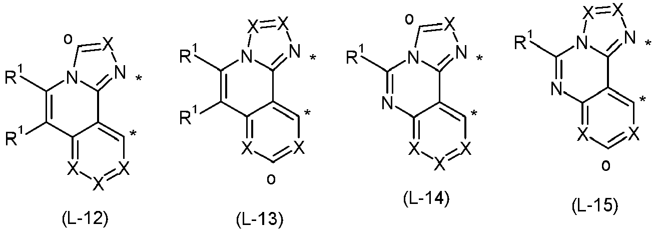 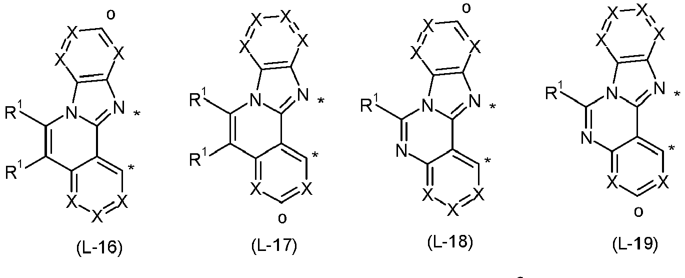 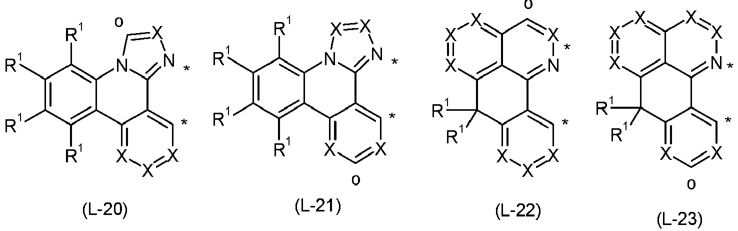 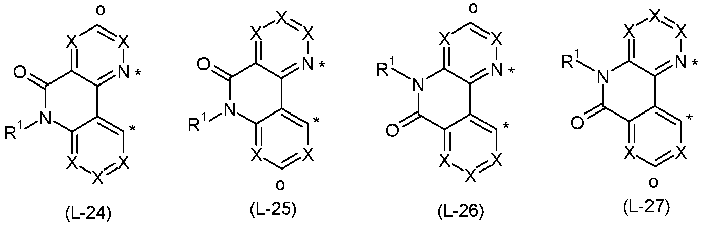 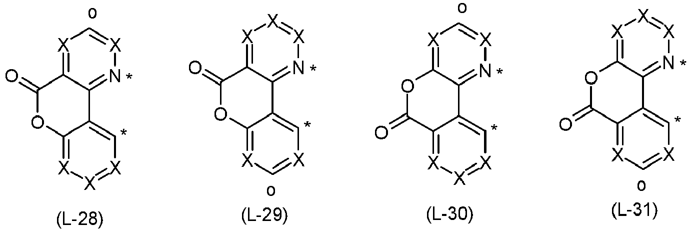
wobei X bei jedem Auftreten gleich oder verschieden CR oder N ist mit der Maßgabe, dass maximal zwei Symbole X pro Cyclus für N stehen, und wobei * die Position der Koordination an das Iridium andeutet und "o" die Position der Bindung an die Brücke der Formel (5a") andeutet, mit der Maßgabe, dass, wenn Z an den Teilliganden gebunden ist, ein Symbol X für C steht und Z an dieses Kohlenstoffatom gebunden ist;
- M': ist bei jedem Auftreten gleich oder verschieden M oder ein Iridiumkomplex, in dem drei bidentate Liganden, die gleich oder verschieden sein können, an ein Iridiumatom koordinieren; dabei sind die bidentaten Liganden ausgewählt aus den oben aufgeführten Strukturen (L-1-1), (L-1-2), (L-2-1), (L-2-2), (L-2-3) oder (L-4) bis (L-31), mit dem Unterschied, dass die Liganden nicht an eine Brücke der Formel (5a") gebunden sind;
- R: ist bei jedem Auftreten gleich oder verschieden H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R¹ substituiert sein kann, wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann, oder eine Aryloxy- oder Heteroaryloxygruppe mit 5 bis 40 aromatischen Ringatomen, die durch einen oder mehrere Reste R¹ substituiert sein kann; dabei können zwei Reste R auch miteinander ein Ringsystem bilden;
- R': ist bei jedem Auftreten gleich oder verschieden H, D, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten R¹ substituiert sein kann und wobei eine oder mehrere nicht benachbarte CH₂-Gruppen durch Si(R¹)₂ ersetzt sein können, oder ein aromatisches oder heteroaromatisches Ringsystem mit 5 bis 40 aromatischen Ringatomen, das jeweils durch einen oder mehrere Reste R¹ substituiert sein kann;
- R¹: ist bei jedem Auftreten gleich oder verschieden H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R² substituiert sein kann, wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann; dabei können zwei oder mehrere Reste R¹ miteinander ein Ringsystem bilden;
- R²: ist bei jedem Auftreten gleich oder verschieden H, D, F oder ein aliphatischer, aromatischer und heteroaromatischer organischer Rest, insbesondere ein Kohlenwasserstoffrest, mit 1 bis 20 C-Atomen, in dem auch ein oder mehrere H-Atome durch F ersetzt sein können;
- Z: ist bei jedem Auftreten gleich oder verschieden eine Einfachbindung oder ein Linker, der zwei oder mehrere Komplexe M und M' miteinander kovalent verknüpft, wobei der Linker ausgewählt ist aus der Gruppe bestehend aus einem aromatischen oder heteroaromatischen Ringsystem mit 5 bis 30 aromatischen Ringatomen, das jeweils durch einen oder mehrere Reste R¹ substituiert sein kann, oder einer Gruppe -Ar-[Alkylen-Ar]ₚ- mit p = 1, 2 oder 3, wobei Ar gleich oder verschieden bei jedem Auftreten jeweils für ein aromatisches oder heteroaromatisches Ringsystem mit 5 bis 30 aromatischen Ringatomen steht, welches durch einen oder mehrere Reste R¹ substituiert sein kann, und Alkylen für eine Alkylengruppe mit 1 bis 20 C-Atomen steht;
- n: ist 1, 2 oder 3;
- m: ist bei jedem Auftreten gleich oder verschieden 0, 1 oder 2.

Wenn zwei Reste R bzw. R¹ miteinander ein Ringsystem bilden, so kann dieses mono- oder polycyclisch, aliphatisch, heteroaliphatisch, aromatisch oder heteroaromatisch sein. Dabei können die Reste, die miteinander ein Ringsystem bilden, benachbart sein, d.h. dass diese Reste an dasselbe Kohlenstoffatom oder an Kohlenstoffatome, die direkt aneinander gebunden sind, gebunden sind, oder sie können weiter voneinander entfernt sein. So ist beispielsweise auch die Ringbildung eines Restes R, der an einer Gruppe A gebunden ist, mit einem Rest R, der an der Gruppe X¹ gebunden ist, möglich. Wenn eine solche Ringbildung zwischen einem Rest R, der an einer Gruppe A gebunden ist, mit einem Rest R, der an der Gruppe X¹ gebunden ist, erfolgt, so erfolgt diese Ringbildung bevorzugt durch eine Gruppe mit drei Brückenatomen, bevorzugt mit drei Kohlenstoffatomen und besonders bevorzugt durch eine Gruppe -(CR₂)₃-.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

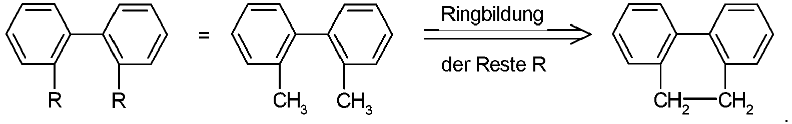

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

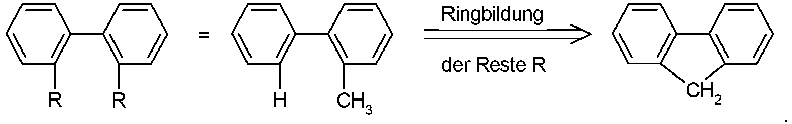

Die Bildung eines aromatischen Ringsystems soll durch das folgende Schema verdeutlicht werden:

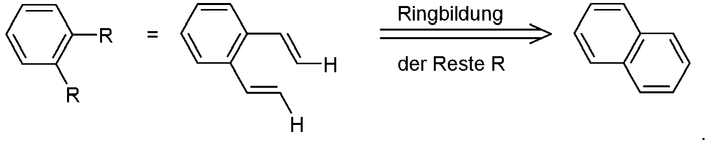

Dabei kann die Ringbildung an Resten erfolgen, die an direkt aneinander gebundene Kohlenstoffatome gebunden sind, oder an Resten, die an weiter entfernt liegende Kohlenstoffatome gebunden sind. Bevorzugt ist eine solche Ringbildung bei Resten, die an direkt aneinander gebundene Kohlenstoffatome oder an dasselbe Kohlenstoffatom gebunden sind.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryloder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₂₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1 -yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₂₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Der Linker Z kann an den Metallkomplex M entweder an die Gruppe der Formel (5a") gebunden sein oder an einen der Teilliganden.

Bei dem Liganden des Metallkomplexes M handelt es sich erfindungsgemäß um einen hexadentaten, tripodalen Liganden mit drei bidentaten Teilliganden. Die Struktur der hexadentaten, tripodalen Liganden kann schematisch durch die folgende Formel (Lig) dargestellt werden: 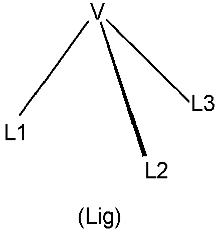 wobei V die Brücke gemäß Formel (5a") darstellt und L1, L2 und L3 gleich oder verschieden bei jedem Auftreten jeweils bidentate Teilliganden darstellen. Dabei bedeutet bidentat, dass der jeweilige Teilligand im Komplex M über zwei Koordinationsstellen an das Iridium koordiniert bzw. bindet. Tripodal bedeutet, dass der Ligand (Lig) drei Teilliganden aufweist, die an die Brücke V bzw. die Brücke der Formel (5a") gebunden sind. Da der Ligand drei bidentate Teilliganden aufweist, ergibt sich insgesamt ein hexadentater Ligand, also ein Ligand, der über sechs Koordinationsstellen an das Iridium koordiniert bzw. bindet. Der Begriff "bidentater Teilligand" bedeutet im Sinne dieser Anmeldung, dass es sich bei dieser Einheit um einen bidentaten Liganden handeln würde, wenn die Brücke der Formel (5a") und der Linker Z nicht vorhanden wären. Durch die formale Abstraktion eines Wasserstoffatoms an diesem bidentaten Liganden und die Anknüpfung an die Brücke der Formel (5a") und gegebenenfalls an Z ist dieser jedoch kein separater Ligand, sondern ein Teil des so entstehenden hexadentaten Liganden, der mit Z verknüpft ist, so dass hierfür der Begriff "Teilligand" verwendet wird.

Der mit diesem Liganden der Formel (Lig) gebildete Iridiumkomplex M kann somit schematisch durch die folgende Formel dargestellt werden: 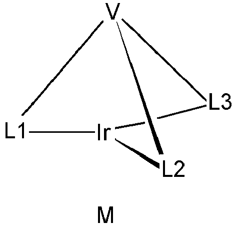 wobei V die Brücke gemäß Formel (5a") darstellt und L1, L2 und L3 gleich oder verschieden bei jedem Auftreten jeweils die oben beschriebenen bidentaten Teilliganden darstellen. Der Linker Z kann dabei entweder an die Brücke der Formel (5a") binden oder an einen oder mehrere der Teilliganden L1, L2 oder L3.

Die Bindung des Liganden an das Iridium kann sowohl eine Koordinationsbindung als auch eine kovalente Bindung sein bzw. der kovalente Anteil an der Bindung kann je nach Ligand variieren. Wenn hier die Rede davon ist, dass der Ligand bzw. der Teilligand an das Iridium koordiniert oder bindet, so bezeichnet dies im Sinne der vorliegenden Anmeldung jede Art der Bindung des Liganden bzw. Teilliganden an das Iridium, unabhängig vom kovalenten Anteil der Bindung.

Bevorzugt sind die erfindungsgemäßen Verbindungen dadurch gekennzeichnet, dass diese nicht geladen, d. h. elektrisch neutral, sind. Dabei ist es bevorzugt, wenn M, M' sowie der Linker Z nicht geladen ist. Dies wird auf einfache Weise dadurch erreicht, dass die Ladungen der drei bidentaten Teilliganden so gewählt werden, dass sie die Ladung des komplexierten Iridiumatoms kompensieren. Dabei ist jeder der drei bidentaten Teilliganden einfach negativ geladen, so dass die drei Teilliganden die Ladung des Ir(III) kompensieren.

Je nach Wahl der Indizes n und m können verschiedene bi- und oligonukleare Verbindungen gebildet werden, wie nachfolgend für einige Kombinationen von n und m schematisch ausgeführt: 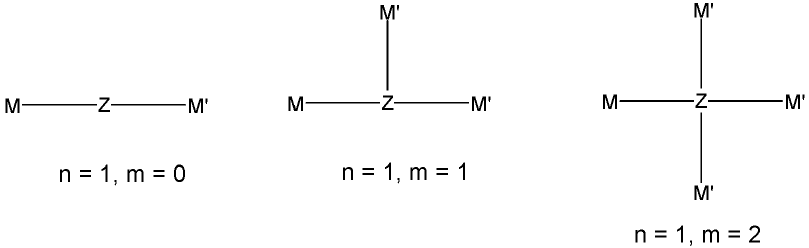 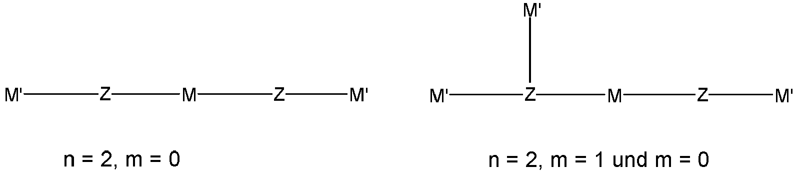 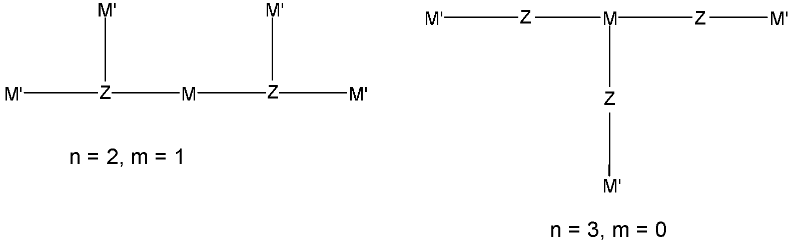 dabei weisen die Symbole die oben genannten Bedeutungen auf. Ganz analog lassen sich weitere oligonukleare Komplexe aus weiteren Kombinationen der Indizes n und m bilden.

In einer bevorzugten Ausführungsform der Erfindung ist n = 1 oder 2 und m = 0 oder 1. In einer besonders bevorzugten Ausführungsform ist n = 1 und m = 0.

Nachfolgend werden die bevorzugten Ausführungsformen für Z beschrieben. Wie oben beschrieben, steht Z für eine Einfachbindung oder einen der oben beschriebenen Linker. Wenn m = 0 ist, steht Z für eine Einfachbindung oder eine bivalente Gruppe. Wenn m = 1 ist, steht Z für eine trivalente Gruppe. Wenn m = 2 ist, steht Z für eine tetravalente Gruppe.

Bevorzugt ist Z ausgewählt aus der Gruppe bestehend aus einer Einfachbindung, einem aromatischen oder heteroaromatischen Ringsystem mit 5 bis 20 aromatischen Ringatomen, das jeweils durch einen oder mehrere Reste R¹ substituiert sein kann, oder einer Gruppe -Ar-[Alkylen-Ar]ₚ- mit p = 1, 2 oder 3. Dabei steht Ar gleich oder verschieden bei jedem Auftreten jeweils für ein aromatisches oder heteroaromatisches Ringsystem mit 5 bis 30 aromatischen Ringatomen, bevorzugt mit 6 bis 24 aromatischen Ringatomen, besonders bevorzugt mit 6 bis 13 aromatischen Ringatomen, welches durch einen oder mehrere Reste R¹ substituiert sein kann, und Alkylen für eine Alkylengruppe mit 1 bis 20 C-Atomen, bevorzugt mit 1 bis 10 C-Atomen, besonders bevorzugt mit 1 bis 4 C-Atomen. Dabei kann die Alkylengruppe geradkettig sein bzw. eine Alkylengruppe mit drei oder mehr C-Atomen kann auch verzweigt oder cyclisch sein.

In einer bevorzugten Ausführungsform der Erfindung ist Z gleich oder verschieden bei jedem Auftreten ausgewählt aus der Gruppe bestehend aus einer Einfachbindung oder einem aromatischen oder heteroaromatischen Ringsystem mit 6 bis 24 aromatischen Ringatomen, das jeweils durch einen oder mehrere Reste R¹ substituiert sein kann. Bevorzugte aromatische bzw. heteroaromatische Ringsysteme sind die Gruppen der folgenden Formeln (Z-1) bis (Z-8), 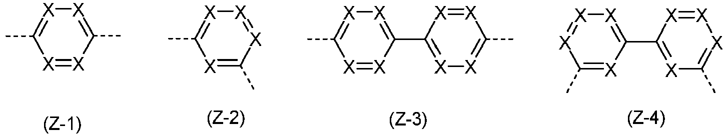 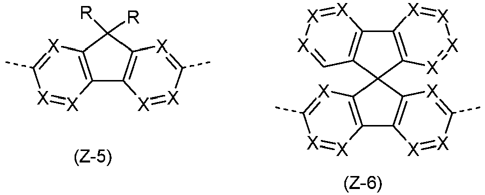 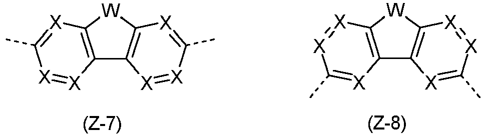 wobei die gestrichelten Bindungen die Verknüpfung dieser Gruppe andeuten, R die oben genannten Bedeutungen aufweist und weiterhin gilt:
- X: ist gleich oder verschieden bei jedem Auftreten CR oder N;
- W: ist gleich oder verschieden bei jedem Auftreten NR, O oder S.

Wenn Z für eine Gruppe -Ar-[Alkylen-Ar]ₚ- steht, ist Ar in diesen Gruppen auch gleich oder verschieden bei jedem Auftreten bevorzugt ausgewählt aus den oben abgebildeten Formeln (Z-1) bis (Z-8).

Bevorzugt stehen maximal zwei Symbole X in jeder der Formeln (Z-1) bis (Z-8), besonders bevorzugt maximal ein Symbol X pro Gruppe Z, für N, und die anderen Symbole X stehen für CR. Besonders bevorzugt stehen alle Symbole X für CR. Besonders bevorzugt sind daher die Gruppen Z der folgenden Formeln (Z-1a) bis (Z-8a), 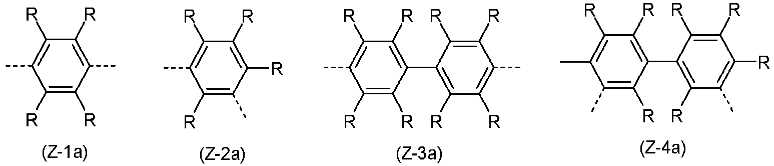 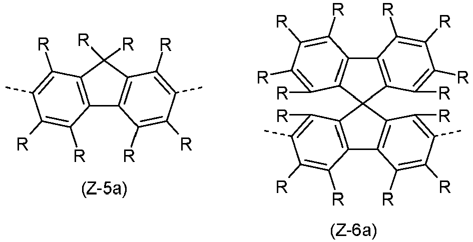 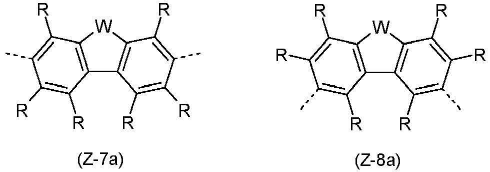 wobei die verwendeten Symbole die oben genannten Bedeutungen aufweisen.

Nachfolgend werden die bevorzugten Ausführungsformen für den Iridiumkomplex M beschrieben.

Besonders bevorzugt sind die Gruppen R in Formel (5a") gleich oder verschieden H, D oder eine Alkylgruppe mit 1 bis 4 C-Atomen. Ganz besonders bevorzugt ist R = H. Besonders bevorzugt ist also die Struktur der folgenden Formeln (5a‴), 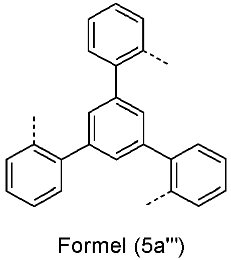 wobei die Symbole die oben genannten Bedeutungen aufweisen.

Im Folgenden werden die bidentaten Teilliganden beschrieben, die in M mit der Brücke der Formel (5a") bzw. den oben genannten bevorzugten Ausführungsformen verknüpft sind. Wie oben beschrieben, sind die bidentaten Liganden ausgewählt aus den Strukturen der Formeln (L-1-1), (L-1-2), (L-2-1), (L-2-2), (L-2-3) oder (L-4) bis (L-31). Dabei ist jeder der bidentaten Teilliganden monoanionisch.

Die drei bidentaten Teilliganden können gleich oder verschieden sein. Wenn die bidentaten Teilliganden gleich sind, sind sie bevorzugt auch gleich substituiert. Wenn alle drei bidentaten Teilliganden gleich gewählt sind, entstehen dadurch C₃-symmetrische Iridiumkomplexe, wenn auch die Einheit der Formel (5a") C₃-symmetrisch ist, was vorteilhaft bezüglich der Synthese der Liganden ist. Es kann aber auch vorteilhaft sein, die drei bidentaten Teilliganden unterschiedlich zu wählen bzw. zwei Teilliganden gleich und den dritten Teilliganden davon verschieden zu wählen, so dass C₁-symmetrische Metallkomplexe entstehen, weil dies größere Variationsmöglichkeiten der Liganden zulässt, so dass sich die gewünschten Eigenschaften des Komplexes, wie beispielsweise die Lage von HOMO und LUMO bzw. die Emissionsfarbe leichter variieren lassen. Außerdem lässt sich so auch die Löslichkeit der Komplexe verbessern, ohne lange aliphatische oder aromatische, löslichkeitsvermittelnde Gruppen anbringen zu müssen. In einer bevorzugten Ausführungsform der Erfindung sind die drei bidentaten Teilliganden entweder gleich gewählt oder zwei der bidentaten Teilliganden sind gleich gewählt und der dritte bidentate Teilligand ist unterschiedlich von den ersten beiden bidentaten Teilliganden.

Bevorzugte Teilliganden (L-1) sind die Strukturen der folgenden Formeln (L-1-1a) und (L-1-2b), und besonders bevorzugte Teilliganden (L-2) sind die Strukturen der folgenden Formeln (L-2-1a) bis (L-2-3a), 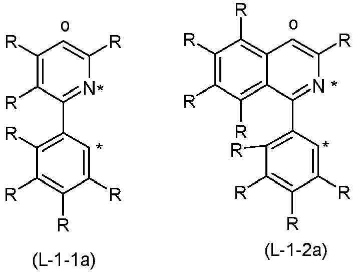 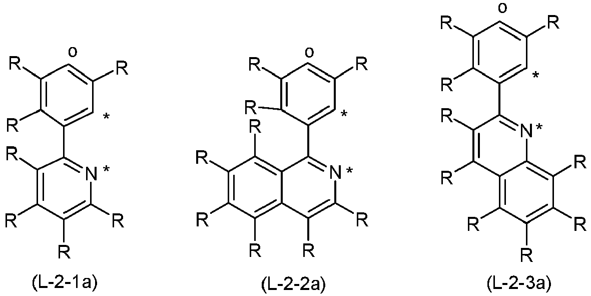 wobei die verwendeten Symbole die oben genannten Bedeutungen aufweisen und "o" die Position der Bindung an die Brücke der Formel (5a") bzw. die bevorzugten Ausführungsformen darstellt und mit der Maßgabe, dass, wenn Z an den Teilliganden gebunden ist, ein Rest R nicht vorhanden ist und Z an dieses Kohlenstoffatom gebunden ist.

In einer bevorzugten Ausführungsform der Teilliganden der Formeln (L-4) bis (L-31) steht insgesamt ein Symbol X für N und die anderen Symbole X stehen für CR, oder alle Symbole X stehen für CR mit der Maßgabe, dass, wenn Z an diesen Teilliganden gebunden ist, ein Symbol X für C steht und Z an dieses Kohlenstoffatom gebunden ist.

In einer weiteren Ausführungsform der Erfindung ist es bevorzugt, falls in den Teilliganden (L-1-1) bis (L-2-3) oder (L-4) bis (L-31) eines der Atome X für N steht, wenn benachbart zu diesem Stickstoffatom eine Gruppe R als Substituent gebunden ist, welche ungleich Wasserstoff oder Deuterium ist.

Dabei ist dieser Substituent R bevorzugt eine Gruppe, ausgewählt aus CF₃, OCF₃, Alkyl- oder Alkoxygruppen mit 1 bis 10 C-Atomen, insbesondere verzweigten oder cyclischen Alkyl- oder Alkoxygruppen mit 3 bis 10 C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Im Folgenden werden die Metallkomplexe M' beschrieben. M' ist erfindungsgemäß bei jedem Auftreten gleich oder verschieden M oder ein Iridiumkomplex, in dem drei bidentate Liganden, die gleich oder verschieden sein können, an ein Iridiumatom koordinieren. Dabei sind die bidentaten Liganden ausgewählt aus den oben aufgeführten Strukturen (L-1-1), (L-1-2), (L-2-1), (L-2-2), (L-2-3) oder (L-4) bis (L-31), mit dem Unterschied, dass die Liganden nicht an eine Brücke der Formel (5a") gebunden sind.

Wenn M' ein Iridiumkomplex ist, in dem drei bidentate Liganden an ein Iridiumatom koordineren, dann bindet Z an einen der drei bidentaten Liganden. Der entsprechende Ligand, an den Z bindet, wird im Sinne dieser Erfindung weiterhin als bidentater Ligand bezeichnet, auch wenn es sich durch die Verknüpfung mit Z-M um einen Teilliganden handelt.

In einer bevorzugten Ausführungsform der Erfindung ist M' gleich oder verschieden M, wobei auch dieselben Bevorzugungen gelten, wie oben für M beschrieben. Es handelt sich bevorzugt bei M und M' also um Iridiumkomplexe mit tripodalem, hexadentaten Liganden.

In einer bevorzugten Ausführungsform der Erfindung sind M und M' identisch. Dies kann Vorteile aufgrund der einfacheren synthetischen Zugänglichkeit der Komplexe haben.

In einer weiteren bevorzugten Ausführungsform sind M und M' unterschiedlich und weisen insbesondere auch unterschiedliche Emissionsfarben auf. So kann beispielsweise die Kombination eines rot emittierenden Komplexes M bzw. M' mit einem gelb oder grün emittierenden Komplex M' bzw. M zu einer Co-Dotierung innerhalb desselben Moleküls führen.

Im Folgenden werden bevorzugte Substituenten beschrieben, wie sie an den oben beschriebenen Teilliganden und Liganden, aber auch an der bivalenten Arylengruppe in der Struktur der Formel (5a") vorliegen können.

In einer bevorzugten Ausführungsform der Erfindung enthält der erfindungsgemäße Metallkomplex zwei Substituenten R, die an benachbarte Kohlenstoffatome gebunden sind und die miteinander einen aliphatischen Ring gemäß einer der nachfolgend beschriebenen Formeln bilden. Dabei können die beiden Substituenten R, die diesen aliphatischen Ring bilden, an der Brücke der Formeln (5a") bzw. den bevorzugten Ausführungsformen vorliegen und/oder an einem oder mehreren der bidentaten Teilliganden vorliegen. Der aliphatische Ring, der durch die Ringbildung von zwei Substituenten R miteinander gebildet wird, wird bevorzugt durch eine der folgenden Formeln (50) bis (56) beschrieben, 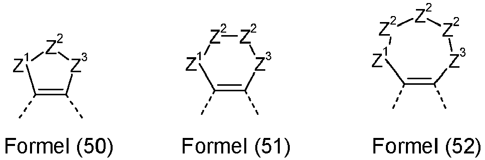 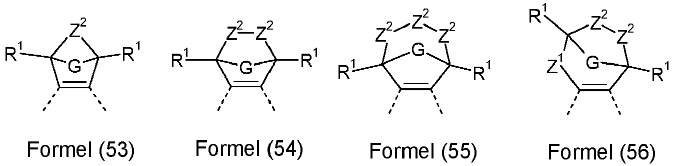
wobei R¹ und R² die oben genannten Bedeutungen aufweisen, die gestrichelten Bindungen die Verknüpfung der beiden Kohlenstoffatome im Liganden andeuten und weiterhin gilt:
   - Z¹, Z³: ist gleich oder verschieden bei jedem Auftreten C(R³)₂, O, S, NR³ oder C(=O);
   - Z²: ist C(R¹)₂, O, S, NR³ oder C(=O);
   - G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
   - R³: ist gleich oder verschieden bei jedem Auftreten H, F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, wobei die Alkyl- oder Alkoxygruppe jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

In einer bevorzugten Ausführungsform der Erfindung ist R³ ungleich H.

In den oben abgebildeten Strukturen der Formeln (50) bis (56) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, wenn diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden sind. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (50) bis (52) dadurch erreicht, dass Z¹ und Z³, wenn diese für C(R³)₂ stehen, so definiert sind, dass R³ ungleich Wasserstoff ist. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen. So wird die Abwesenheit von aziden benzylischen Protonen ist in Formeln (53) bis (56) dadurch erreicht, dass es sich dabei um eine bicyclische Struktur handelt, wodurch R¹, wenn es für H steht, deutlich weniger azide als benzylische Protonen, da das korrespondierende Anion der bicyclischen Struktur nicht mesomeriestabilisiert ist. Auch wenn R¹ in Formeln (53) bis (56) für H steht, handelt es sich dabei daher um ein nicht-azides Proton im Sinne der vorliegenden Anmeldung.

In einer bevorzugten Ausführungsform der Struktur gemäß Formel (50) bis (56) steht maximal eine der Gruppen Z¹, Z² und Z³ für ein Heteroatom, insbesondere für O oder NR³, und die anderen Gruppen stehen für C(R³)₂ bzw. C(R¹)₂ oder Z¹ und Z³ stehen gleich oder verschieden bei jedem Auftreten für O oder NR³ und Z² steht für C(R¹)₂. In einer besonders bevorzugten Ausführungsform der Erfindung stehen Z¹ und Z³ gleich oder verschieden bei jedem Auftreten für C(R³)₂ und Z² steht für C(R¹)₂ und besonders bevorzugt für C(R³)₂ oder CH₂.

Bevorzugte Ausführungsformen der Formel (50) sind somit die Strukturen der Formel (50-A), (50-B), (50-C) und (50-D), und eine besonders bevorzugte Ausführungsform der Formel (50-A) sind die Strukturen der Formel (50-E) und (50-F), 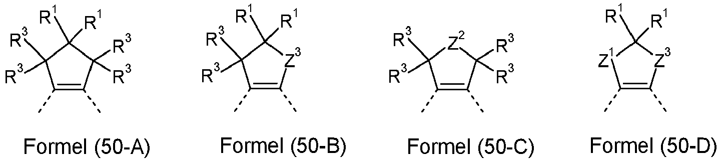 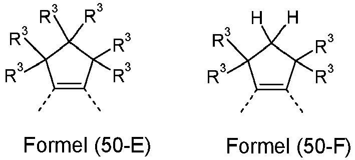 wobei R¹ und R³ die oben genannten Bedeutungen aufweisen und Z¹, Z² und Z³ gleich oder verschieden bei jedem Auftreten für O oder NR³ steht.

Bevorzugte Ausführungsformen der Formel (51) sind die Strukturen der folgenden Formeln (51-A) bis (51-F), 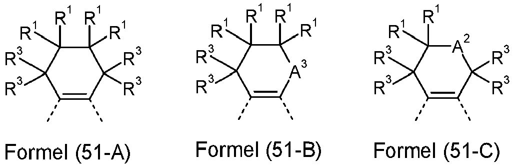 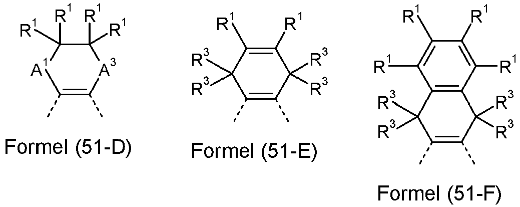 wobei R¹ und R³ die oben genannten Bedeutungen aufweisen und Z¹, Z² und Z³ gleich oder verschieden bei jedem Auftreten für O oder NR³ steht.

Bevorzugte Ausführungsformen der Formel (52) sind die Strukturen der folgenden Formeln (52-A) bis (52-E), 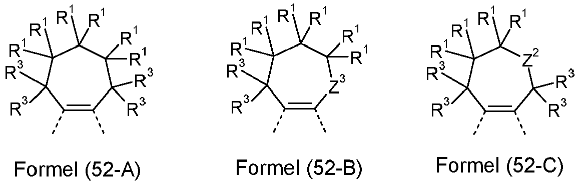 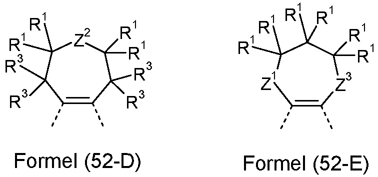 wobei R¹ und R³ die oben genannten Bedeutungen aufweisen und Z¹, Z² und Z³ gleich oder verschieden bei jedem Auftreten für O oder NR³ steht.

In einer bevorzugten Ausführungsform der Struktur gemäß Formel (53) stehen die Reste R¹, die an den Brückenkopf gebunden sind, für H, D, F oder CH₃. Weiterhin bevorzugt steht Z² für C(R¹)₂ oder O, und besonders bevorzugt für C(R³)₂. Bevorzugte Ausführungsformen der Formel (53) sind somit eine Strukturen der Formel (53-A) und (53-B), und eine besonders bevorzugte Ausführungsform der Formel (53-A) ist eine Struktur der Formel (53-C), 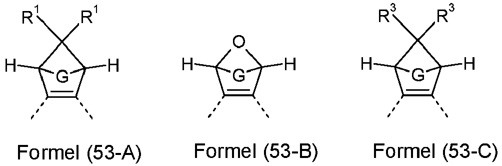 wobei die verwendeten Symbole die oben genannten Bedeutungen aufweisen.

In einer bevorzugten Ausführungsform der Struktur gemäß Formel (54), (55) und (56) stehen die Reste R¹, die an den Brückenkopf gebunden sind, für H, D, F oder CH₃. Weiterhin bevorzugt steht Z² für C(R¹)₂. Bevorzugte Ausführungsformen der Formel (54), (55) und (56) sind somit die Strukturen der Formeln (54-A), (55-A) und (56-A), 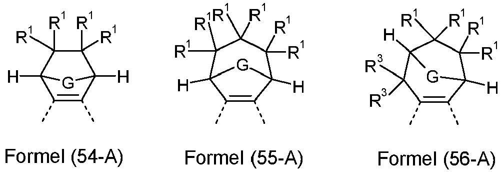 wobei die verwendeten Symbole die oben genannten Bedeutungen aufweisen.

Weiterhin bevorzugt steht die Gruppe G in den Formeln (53), (53-A), (53-B), (53-C), (54), (54-A), (55), (55-A), (56) und (56-A) für eine 1,2-Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer weiteren bevorzugten Ausführungsform der Erfindung steht R³ in den Gruppen der Formel (50) bis (56) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in den Gruppen der Formeln (50) bis (56) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (50) sind die im Folgenden abgebildeten Gruppen:

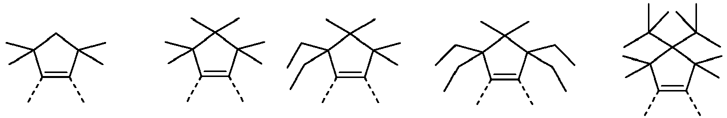

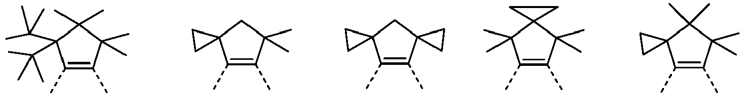

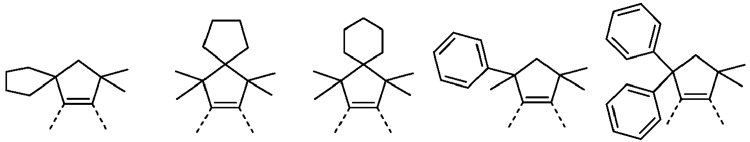

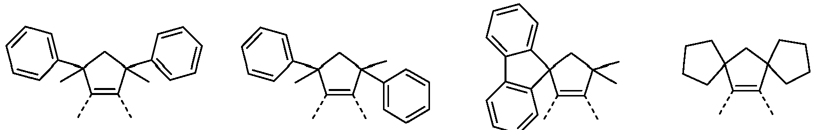

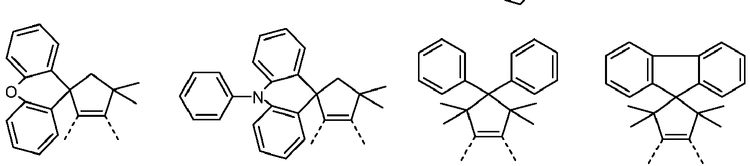

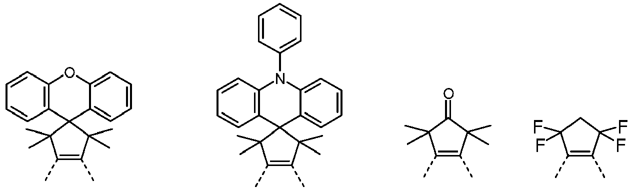

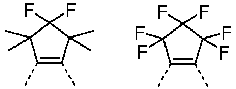

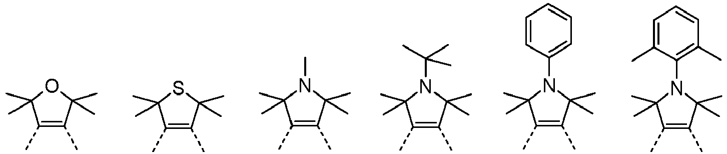

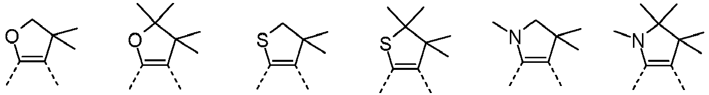

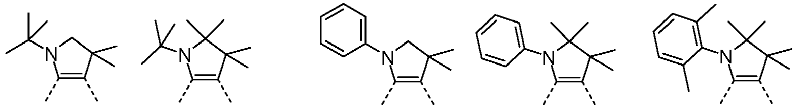

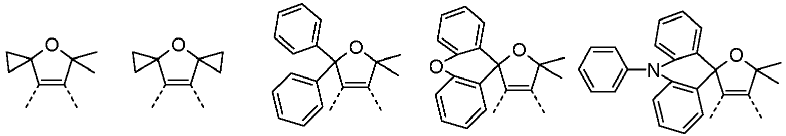

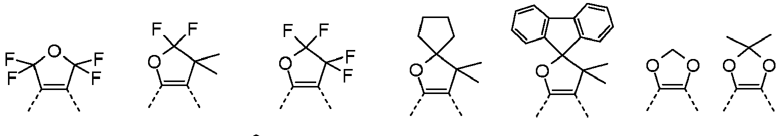

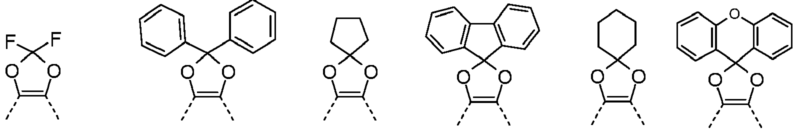

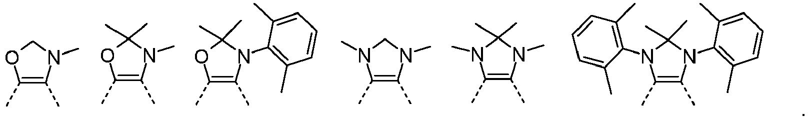

Beispiele für besonders geeignete Gruppen der Formel (51) sind die im Folgenden abgebildeten Gruppen:

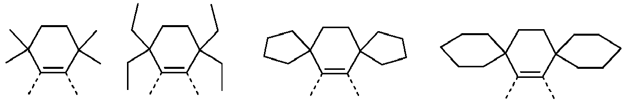

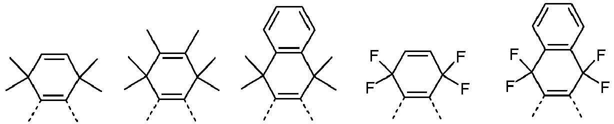

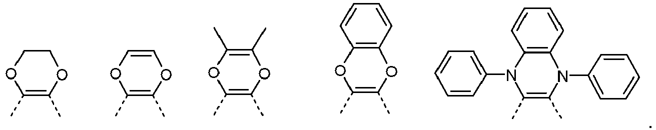

Beispiele für besonders geeignete Gruppen der Formel (52), (55) und (56) sind die im Folgenden abgebildeten Gruppen:

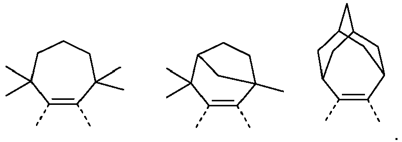

Beispiele für besonders geeignete Gruppen der Formel (53) sind die im Folgenden abgebildeten Gruppen:

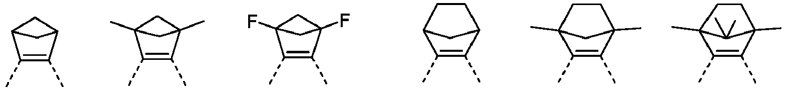

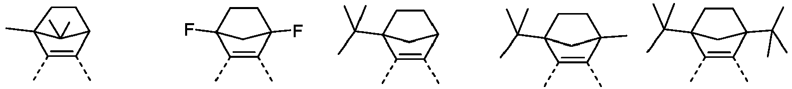

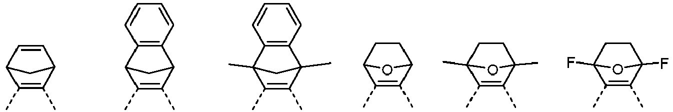

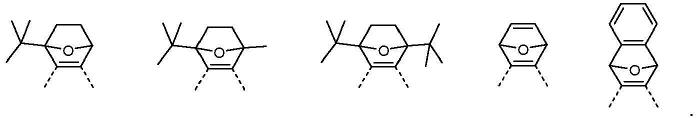

Beispiele für besonders geeignete Gruppen der Formel (54) sind die im Folgenden abgebildeten Gruppen:

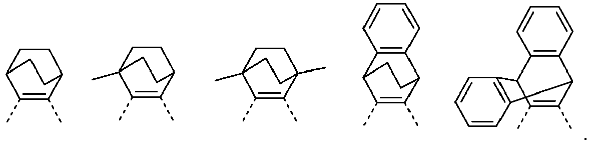

Wenn in den bidentaten Teilliganden bzw. Liganden bzw. in den bivalenten Arylen- bzw. Heteroarylengruppen der Formel (4), welche in den Formeln (2) bzw. (3) bzw. den bevorzugten Ausführungsformen gebunden sind, Reste R gebunden sind, so sind diese Reste R bei jedem Auftreten gleich oder verschieden bevorzugt ausgewählt aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, wobei die Alkyl oder Alkenylgruppe jeweils mit einem oder mehreren Resten R¹ substituiert sein kann, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Rest R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, insbesondere mit 6 bis 13 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden.

Bevorzugte Reste R¹, die an R gebunden sind, sind bei jedem Auftreten gleich oder verschieden H, D, F, N(R²)₂, CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden. Besonders bevorzugte Reste R¹, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder ein aromatisches oder heteroaromatisches Ringsystem mit 5 bis 13 aromatischen Ringatomen, insbesondere mit 6 bis 13 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein monooder polycyclisches, aliphatisches Ringsystem bilden.

Bei den erfindungsgemäßen Verbindungen handelt es sich um chirale Strukturen. Je nach genauer Struktur der Komplexe und Liganden ist die Bildung von Diastereomeren und mehreren Enantiomerenpaaren möglich.

Die erfindungsgemäßen Komplexe umfassen sowohl die Mischungen der verschiedenen Diastereomere bzw. die entsprechenden Racemate wie auch die einzelnen isolierten Diastereomere bzw. Enantiomere.

Werden einkernige Komplex-Synthesebausteine zum Aufbau der mehrkernigen erfindungsgemäßen Komplexe verwendet, werden diese üblicherweise als Racemat der Δ- und Λ-Isomeren eingesetzt. Dies führt in den mehrkernigen erfindungsgemäßen Verbindungen zu Diastereomerengemischen, z. B. für zweikernige Verbindungen zu Δ,Δ-/Λ,Λ- und (meso)-Δ,Λ-Formen. Diese werden, sofern nicht anderes vermerkt, als Diastereomerengemisch weiter um- bzw. eingesetzt. Daneben besteht die Möglichkeit, diese durch chomatographische Methoden oder durch fraktionierte Kristallisation zu trennen.

Werden die enatiomerenreinen Δ-bzw. Λ-Isomeren einkerniger Komplex-Synthesebausteine zum Aufbau der mehrkernigen erfindungsgemäßen Komplexe verwendet, können z. B. für zweikernige Verbindungen Δ,Δ- bzw. Λ,Λ- bzw. (meso)Δ,Λ-Formen gezielt dargestellt werden. Analoges gilt auch für drei und höher-kernige erfindungsgemäßen Komplexe.

Die dazu notwendigen Δ- bzw. Λ-Isomeren einkerniger Komplex-Synthesebausteine können wie folgt erhalten werden. Werden in der Synthese der einkernigen Komplex-Synthesebausteine C₃- bzw. C₃ᵥ-symmetrische Liganden eingesetzt, fällt üblicherweise ein racemisches Gemisch der C₃-symmetrischen Komplexe, also des Δ- und des Λ-Enantiomers, an. Diese können durch gängige Methoden (Chromatographie an chiralen Materialien / Säulen oder Racemattrennung durch Kristallisation) getrennt werden. Dies ist im folgenden Schema am Beispiel eines C₃-symmetrischen Liganden, der drei Phenylpyridin-Teilliganden trägt, gezeigt und gilt in analoger Form auch für alle anderen C₃- bzw. C₃ᵥ-symmetrischen Liganden.

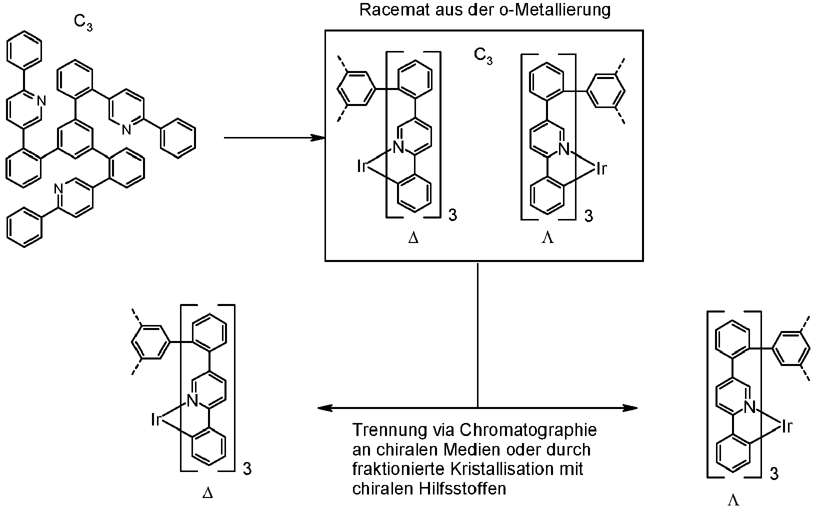

Die Racemattrennung via fraktionierter Kristallisation von diastereomeren Salzpaaren kann nach üblichen Methoden erfolgen. Hierzu bietet es sich an, die neutralen Ir(III)-Komplexe zu oxidieren (z. B. mit Peroxiden, H₂O₂ oder elektrochemisch), die so erzeugten kationischen Ir(IV)-Komplexe mit dem Salz einer enantiomerenreinen, monoanionischen Base (chirale Base) zu versetzen, die so erzeugten diasteromeren Salze durch fraktionierte Kristallisation zu trennen und diese dann mit Hilfe eines Reduktionsmittels (z. B. Zink, Hydrazinhydrat, Ascorbinsäure, etc.) zu den enantiomerenreinen neutralen Komplex zu reduzieren, wie im Folgenden schematisch dargestellt.

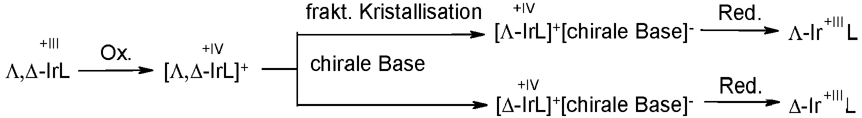

Daneben ist eine enantiomerenreine bzw. enantiomerenanreichernde Synthese durch Komplexierung in einem chiralen Medium (z. B. R- oder S-1,1 -Binaphthol) möglich.

Analoge Verfahren können auch mit Komplexen Cₛ-symmetrischer Liganden durchgeführt werden.

Werden in der Komplexierung C₁-symmetrische Liganden eingesetzt, fällt üblicherweise ein Diastereomerengemisch der Komplexe an, das durch gängige Methoden (Chromatographie, Kristallisation) getrennt werden kann.

Enantiomerenreine C₃-symmetrische Komplexe können auch gezielt synthetisiert werden, wie im folgenden Schema dargestellt. Dazu wird ein enantiomerenreiner C₃-symmetrischer Ligand dargestellt, komplexiert, das erhaltene Diasteroemerengemisch wird getrennt, und anschließend wird die chirale Gruppe abgespalten.

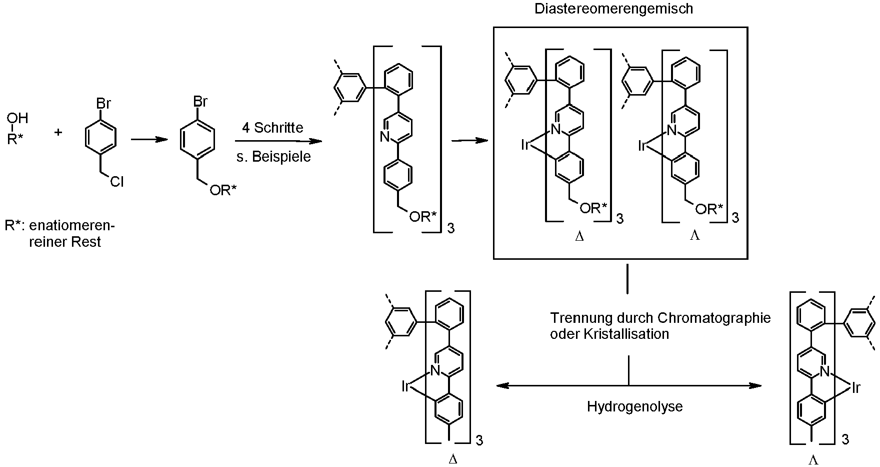

Die so erhaltenen Δ- bzw. Λ-Isomeren einkerniger Komplex-Synthesebausteine können abschließend funktionalisiert, z. B. halogeniert bzw. boryliert, werden und dann via Kupplungsreaktionen, z. B. Suzuki-Kupplung, zu mehrkernigen erfindungsgemäßen Komplexen verknüpft werden.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Die erfindungsgemäßen Komplexe können insbesondere auf zwei Wegen dargestellt werden. Zum einen kann der 12-, 18-, 24-, etc. -zähnige Ligand dargestellt und dann an die Metalle durch eine o-Metallierungsreaktion koordiniert werden. Generell wird hierzu ein Iridiumsalz mit dem entsprechenden freien Liganden umgesetzt.

Daher ist ein weiterer Gegenstand der vorliegenden Erfindung ein Verfahren zur Herstellung der erfindungsgemäßen Verbindung durch Umsetzung der entsprechenden freien Liganden mit Metallalkoholaten der Formel (57), mit Metallketoketonaten der Formel (58), mit Metallhalogeniden der Formel (59) oder mit Metallcarboxylaten der Formel (60),

lr(OR)₃ Formel (57)

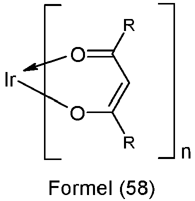

IrHaI₃ Formel (59)

lr(OOCR)₃ Formel (60)

Formel (59) Formel (60) wobei R die oben angegebenen Bedeutungen hat, HaI = F, Cl, Br oder I ist und die Iridiumedukte auch als die entsprechenden Hydrate vorliegen können. Dabei steht R bevorzugt für eine Alkylgruppe mit 1 bis 4 C-Atomen.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-Tetramethylheptan-3,5-dionato)iridium, und IrCl₃·xH₂O, wobei x üblicherweise für eine Zahl zwischen 2 und 4 steht.

Die Synthese der Komplexe wird bevorzugt durchgeführt wie in WO 2002/060910 und in WO 2004/085449 beschrieben. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMSO) oder Sulfone (Dimethylsulfon, Sulfolan, etc.). Geeignete Schmelzhilfen sind Verbindungen, die bei Rautemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, R- oder S-Binaphthol oder auch das entsprechende Racemat, 1,2-, 1,3-, 1,4-Bis-phenoxybenzol, Triphenylphosphinoxid, 18-Krone-6, Phenol, 1-Naphthol, Hydrochinon, etc.. Dabei ist die Verwendung von Hydrochinon besonders bevorzugt.

Zum anderen können zwei bzw. mehrere mit Halogen oder Boronsäure- bzw. Boronsäureester-Gruppen funktionalisierte Metallkomplexe in Kupplungsreaktionen, bevorzugt einer Suzuki-Kupplung, miteinander oder mit entsprechenden Aryl-/Heteroaryl-halogeniden bzw. Aryl-/Heteroarylboronsäuren oder -boronsäureestern zur erfindungsgemäßen Verbindung umgesetzt werden. Wie eine solche Synthese durchgeführt werden kann, kann den Beispielen entnommen werden.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Metallkomplexe können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Insbesondere auch die Verwendung von ankondensierten aliphatischen Gruppen, wie sie beispielsweise durch die oben offenbarten Formeln (50) bis (56) dargestellt werden, führt zu einer deutlichen Verbesserung der Löslichkeit der Metallkomplexe. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Für die Verarbeitung der erfindungsgemäßen Metallkomplexe aus flüssiger Phase, beispielsweise durch Spin-Coating oder durch Druckverfahren, sind Formulierungen der erfindungsgemäßen Metallkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, enthaltend mindestens einen erfindungsgemäßen Iridiumkomplex und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Der oben beschriebene erfindungsgemäße Metallkomplex bzw. die oben aufgeführten bevorzugten Ausführungsformen können in der elektronischen Vorrichtung als aktive Komponente oder als Sauerstoff-Sensibilisatoren verwendet werden. Ein weiterer Gegenstand der vorliegenden Erfindung ist somit die Verwendung einer erfindungsgemäßen Verbindung in einer elektronischen Vorrichtung oder als Sauerstoff-Sensibilisator oder als Photokatalysator. Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Metallkomplex enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens einen erfindungsgemäßen Metallkomplex. Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden. Insbesondere wenn das Metall Ruthenium ist, ist der Einsatz als Photosensibilisator in einer farbstoffsensibilisierten Solarzelle ("Grätzel-Zelle") bevorzugt.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren. Eine bevorzugte Ausführungsform für weiß emittierende OLEDs sind Tandem-OLEDs. Weiß emittierende organische Elektrolumineszenzvorrichtungen können für Beleuchtungsanwendungen oder mit Farbfilter auch für Vollfarb-Displays verwendet werden.

In einer bevorzugten Ausführungsform der Erfindung enthält die organische Elektrolumineszenzvorrichtung den erfindungsgemäßen Metallkomplex als emittierende Verbindung in einer oder mehreren emittierenden Schichten.

Wenn der erfindungsgemäße Metallkomplex als emittierende Verbindung in einer emittierenden Schicht eingesetzt wird, wird er bevorzugt in Kombination mit einem oder mehreren Matrixmaterialien eingesetzt. Die Mischung aus dem erfindungsgemäßen Metallkomplex und dem Matrixmaterial enthält zwischen 0.1 und 99 Gew.-%, vorzugsweise zwischen 1 und 90 Gew.-%, besonders bevorzugt zwischen 3 und 40 Gew.-%, insbesondere zwischen 5 und 25 Gew.-% des erfindungsgemäßen Metallkomplexes bezogen auf die Gesamtmischung aus Emitter und Matrixmaterial. Entsprechend enthält die Mischung zwischen 99.9 und 1 Gew.-%, vorzugsweise zwischen 99 und 10 Gew.-%, besonders bevorzugt zwischen 97 und 60 Gew.-%, insbesondere zwischen 95 und 75 Gew.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015 oder WO 2015/169412, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben. Ebenso bevorzugt ist die Verwendung von zwei elektronentransportierenden Matrixmaterialien, beispielsweise Triazinderivaten und Lactamderivaten, wie z. B. in WO 2014/094964 beschrieben.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Metallkomplexe als Co-Matrix für längerwellig emittierende Triplettemitter, beispielsweise für grün oder rot emittierende Triplettemitter, eingesetzt werden. Dabei kann es auch bevorzugt sein, wenn sowohl der kürzerwellig wie auch der längerwellig emittierende Metallkomplex eine erfindungsgemäße Verbindung ist.

Die erfindungsgemäßen Metallkomplexe lassen sich auch in anderen Funktionen in der elektronischen Vorrichtung einsetzen, beispielsweise als Lochtransportmaterial in einer Lochinjektions- oder -transportschicht, als Ladungserzeugungsmaterial, als Elektronenblockiermaterial, als Lochblockiermaterial oder als Elektronentransportmaterial, beispielsweise in einer Elektronentransportschicht. Ebenso lassen sich die erfindungsgemäßen Metallkomplexe als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden. In einer bevorzugten Ausführungsform der Erfindung wird die Schicht, die die erfindungsgemäße Verbindung enthält, aus Lösung aufgebracht.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:
1. Die erfindungsgemäßen Metallkomplexe lassen sich in sehr hoher Ausbeute und sehr hoher Reinheit bei außergewöhnlich kurzen Reaktionszeiten und vergleichsweise geringen Reaktionstemperaturen synthetisieren.
2. Die erfindungsgemäßen Metallkomplexe weisen eine hervorragende thermische Stabilität auf.
3. Die erfindungsgemäßen Metallkomplexe zeigen, wenn sowohl M wie auch M' Komplexe mit tripodalem hexadentatem Liganden sind, weder thermisch noch photochemisch fac/mer- bzw. mer/fac-Isomerisierung, was zu Vorteilen in der Anwedung dieser Komplexe führt.
4. Die erfindungsgemäßen Metallkomplexe weisen teilweise ein sehr schmales Emissionsspektrum auf, was zu einer hohen Farbreinheit der Emission führt, wie sie insbesondere für Displayanwendungen wünschenswert ist.
5. Organische Elektrolumineszenzvorrichtungen enthaltend die erfindungsgemäßen Metallkomplexe als emittierende Materialien weisen eine sehr gute Lebensdauer auf.
6. Organische Elektrolumineszenzvorrichtungen enthaltend die erfindungsgemäßen Metallkomplexe als emittierende Materialien weisen eine hervorragende Effizienz auf.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### 1. Literaturbekannte Synthone LS:

| | | | |
|---|---|---|---|
| 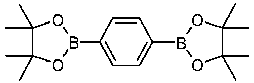 | 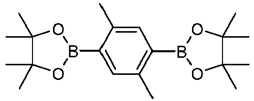 | | 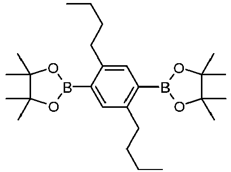 |
| 99770-93-1 LS1 | 303006-89-5 LS2 | | 1462818-64-9 LS3 |
| 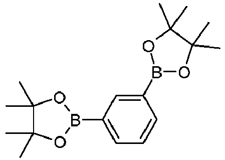 | 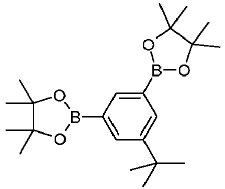 | | 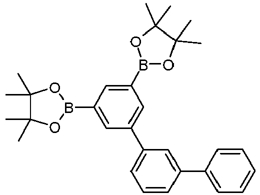 |
| 196212-27-8 LS4 | 254101-32-1 LS5 | | 1182371-94-3 LS6 |
| 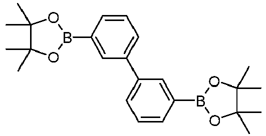 | 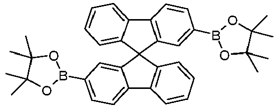 | | 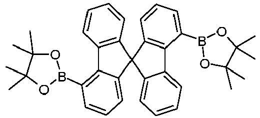 |
| 850264-92-5 LS7 | 676168-63-1 LS8 | | 1257321-47-3 LS9 |
| 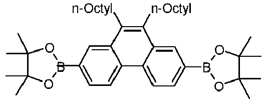 | 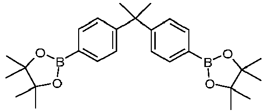 | | 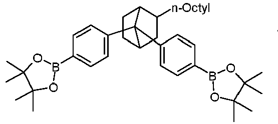 |
| 1332339-96-4 LS10 | 736138-28-6 LS11 | | 1187437-46-2 LS12 |
| 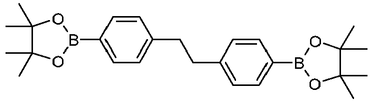 | | 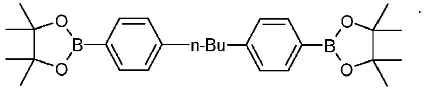 | |
| 1422172-96-0 LS13 | | 1346850-65-4 LS14 | |
| 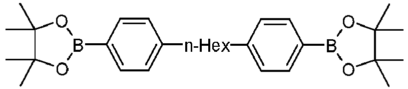 | | 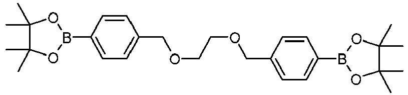 | |
| 1257064-91-7 LS15 | | 1257064-90-6 LS16 | |
| 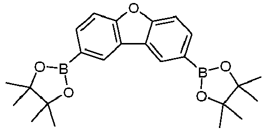 | 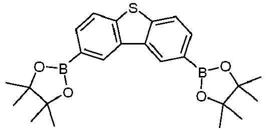 | 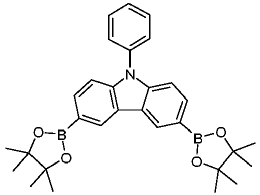 | |
| 1197989-83-5 LS17 | 552855-12-6 LS18 | 618442-57-2 LS19 | |
| 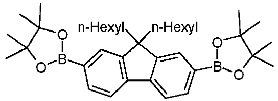 | 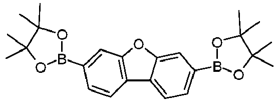 | 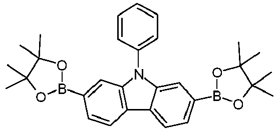 | |
| 254755-24-3 LS20 | 1821662-15-0 LS21 | 1035631-57-2 LS22 | |
| 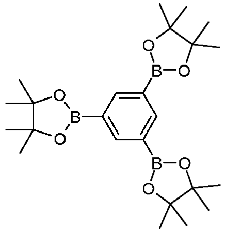 | 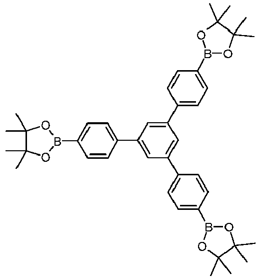 | 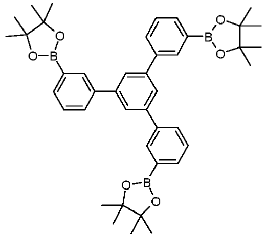 | |
| 365564-05-2 LS23 | 1017967-97-3 LS24 | 1573170-54-3 LS25 | |
| 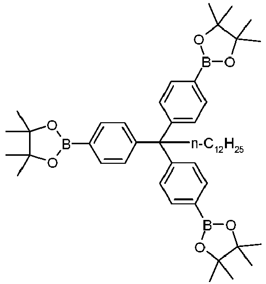 | 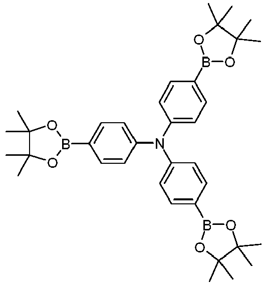 | 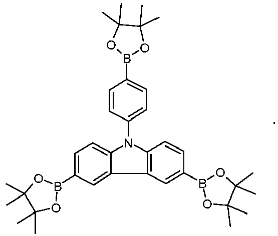 | |
| 1374411-54-7 LS26 | 267221-90-9 LS27 | 1415223-65-2 LS28 | |
| 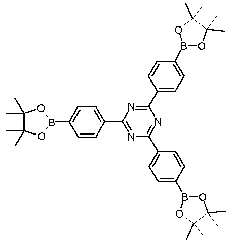 | | 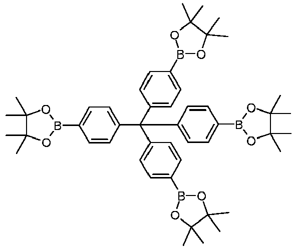 | |
| 1447947-87-6 LS29 | | 875772-13-7 LS30 | |
| 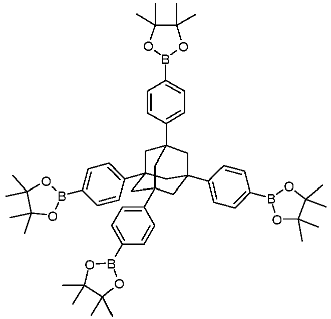 | | | |
| 1636119-48-6 LS31 | | | |
| 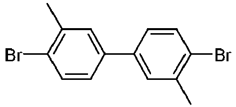 | 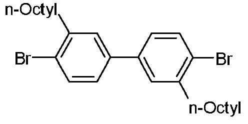 | | 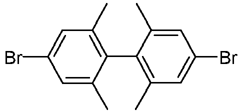 |
| 61794-96-5 LS100 | 450398-41-1 LS101 | | 22409-76-3 LS102 |
| 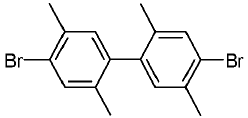 | 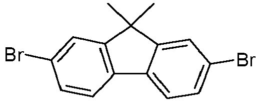 | | 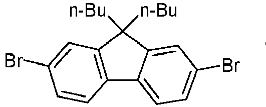 |
| 492434-55-6 LS103 | 28320-32-3 LS104 | | 188200-91-1 LS105 |
| 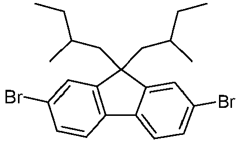 | 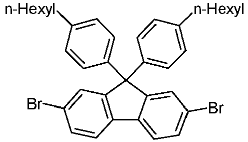 | | 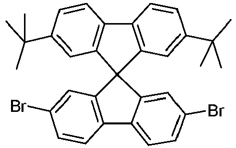 |
| 500343-25-9 LS106 | 1059179-65-5 LS107 | | 439791-57-8 LS108 |
| 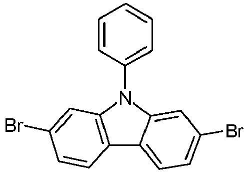 | 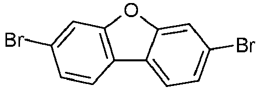 | | 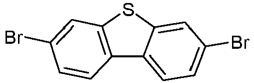 |
| 444796-09-2 LS109 | 67019-91-4 LS110 | | 83834-10-0 LS111 |
| 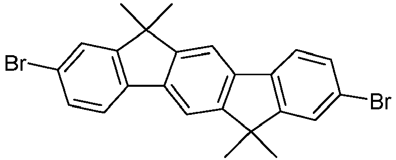 | | 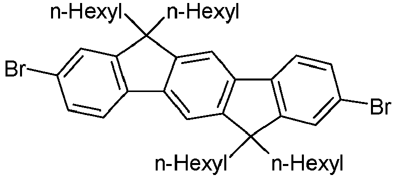 | |
| 822705-64-1 LS112 | | 822705-69-6 LS113 | |

### 2. Darstellung der organischen und metallorganischen Synthone:

### 2.1 Darstellung der organischen Synthone S:

### Beispiel S1: 1,3,5-Tris-(6-brom-1,1,3,3-tetramethylindan-5-yl)benzol

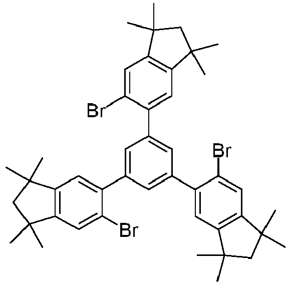

### a) 1-(6-Brom-1,1,3,3-tetramethyl-indan-5-yl)-ethanon

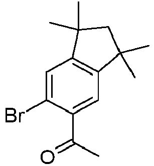

Durchführung nach I. Pravst et al., Teterhedron Lett., 2006, 47, 4707.

Ein Gemisch aus 21.6 g (100 mmol) 1-(1,1,3,3-Tetramethyl-indan-5-yl)-ethanon, [17610-14-9], 39.2 g (220 mmol) N-Bromsuccinimid, 1.6 g (2.5 mmol) [Cp*RhCl₂]₂[12354-85-7], 3.4 g (10 mmol) Silber(I)hexafluoro-antimonat [26042-64-8], 20.0 g (110 mmol) Kupfer(II)acetat [142-71-2] und 500 ml 1,2-Dichlorethan wird 20 h bei 120 °C gerührt. Nach Erkalten filtriert man von den Feststoffen über ein Kieselgelbett ab, entfernt das Lösungsmittel im Vakuum und kristallisiert den Rückstand dreimal aus Acetonitril um. Ausbeute: 12.1 g (41 mmol), 41 %. Reinheit: ca. 97 %ig n. ¹H-NMR.

### b) 1,3,5-Tris-(6-brom-1,1,3,3-tetramethylindan-5-yl)benzol, S1

Ein Gemisch aus 12.1 g (41 mmol) 1-(6-Brom-1,1,3,3-tetramethyl-indan-5-yl)-ethanon und 951 mg (5 mmol) Toluolsulfonsäure-Monohydrat [6192-52-5] (oder Trifluormethansulfonsäure, Variante B) wird 48 h bei 150 °C am Wasserabscheider gerührt. Nach Erkalten nimmt man den Rückstand in 300 ml Ethylacetat auf, wäscht dreimal mit je 100 ml Wasser, einmal mit 100 ml gesättigter Kochsalzlösung und trocknet dann über Magnesiumsulfat. Das Rohprodukt wird an Kieselgel mit n-Heptan:Ethylacetat (5:1) chromatographiert. Ausbeute: 4.3 g (5 mmol), 38 %. Reinheit: ca. 97 %ig n. ¹H-NMR.

Analog können folgende Verbindungen dargestellt werden:

| Bsp. | Keton bzw. Bromketon Variante | Produkt | Ausbeute |
|---|---|---|---|
| S2 | 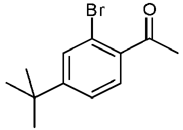 | 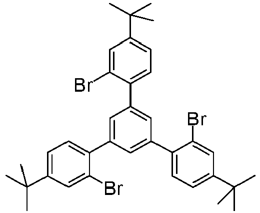 | 33% |
| | 147438-85-5 B | | |
| S3 | 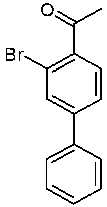 | 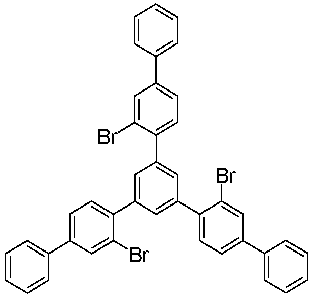 | 60% |
| | 628735-63-7 B | | |
| S4 | 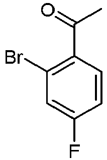 | 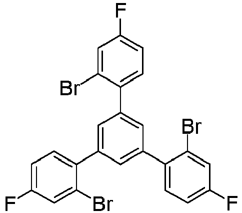 | 63% |
| | 1006-39-9 | | |

Folgende literaturbekannte Verbindungen können als Synthone eingesetzt werden:

| Synthon | |
|---|---|
| 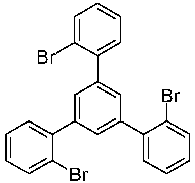 | |
| 380626-56-2 S5 | |

### Beispiel S6:

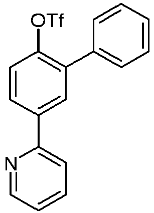

### a) S6a

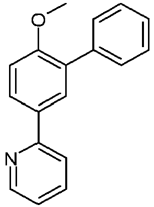

Ein Gemisch aus 22.6 g (100 mmol) (6-Methoxy-[1,1'-biphenyl]-3-yl)-boronsäure [459423-16-6], 16.6 g (105 mmol) 2-Brompyridin [109-04-6], 21.2 g (200 mmol) Natriumcarbonat, 1.2 g (1 mmol) Tetrakis-triphenylphosphino-palladium [14221-01-3], 300 ml Toluol, 100 ml Ethanol, 300 ml Wasser wird unter gutem Rühren 18 h unter Rückfluss erhitzt. Nach Erkalten trennt man die organische Phase ab, wäscht diese zweimal mit je 300 ml Wasser, einmal mit 300 ml gesättigter NaCI-Lösung und trocknet über Magnesiumsulfat. Das nach Einengen der organischen Phase erhaltene Öl wird am Ölpumpenvakuum bei 80 °C getrocknet und ohne weitere Reinigung umgesetzt. Ausbeute: 25.6 g (98 mmol), 98 %; Reinheit: ca. 95 % n. ¹H-NMR.

### b) S6b

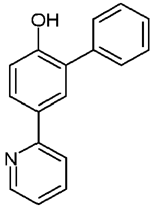

Ein Gemisch aus 26.1 g (100 mmol) S6a und 81.9 g (700 mmol) Pyridiniumhydrochlorid wird 3 h auf 190 °C erhitzt. Nach Erkalten gießt man die Reaktionsmischung in 500 ml Wasser ein, extrahiert fünfmal mit je 200 ml Dichlormethan, wäscht die organische Phase zweimal mit 200 ml Wasser und einmal mit 200 ml gesättigter NaCI-Lösung, entfernt das Lösungsmittel im Vakuum, gibt zur azeotropen Trocknung 300 ml Toluol zu und destilliert dieses im Vakuum komplett ab. Das so erhaltene zähe Öl wird ohne weitere Reinigung umgesetzt. Ausbeute: 21.0 g (85 mmol), 85 %; Reinheit: ca. 95 % n. ¹H-NMR.

### c) S6

Eine auf 0 °C gekühlte Lösung von 24.7 g (100 mmol) S6b in einem Gemisch aus 300 ml Dichlormethan und 80 ml Pyridin wird unter gutem Rühren tropfenweise mit 34 ml (200 mmol) Trifluormethansulfonsäureanhydrid [358-23-6] versetzt. Man lässt die Reaktionsmischung auf RT erwärmen, rührt 16 h nach, gießt unter Rühren auf 1000 ml Eiswasser und extrahiert dieses dann dreimal mit 300 ml Dichlormethan. Die vereinigten organischen Phasen werden zweimal mit je 300 ml Eiswasser und einmal mit 500 ml gesättigter NaCI-Lösung gewaschen und dann über Natriumsulfat getrocknet. Das nach Entfernen des Dichlormethans im Vakuum verbliebene Wachs wird aus Acetonitril umkristallisiert. Ausbeute: 32.6 g (86 mmol), 86 %; Reinheit: ca. 95 % n. ¹H-NMR.

### Analog kann S7 erhalten werden, wobei anstelle von 2-Brompyridin 2-Brom-4-tert-butylpyridin [50488-34-1]eingesetzt wird:

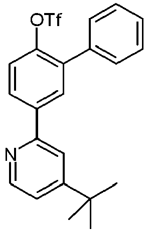

### Beispiel S10: 5-Brom-2-[1,1,2,2,3,3-hexamethyl-indan-5-yl]-pyridin

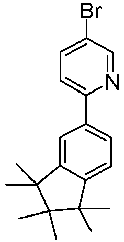

Ein Gemisch aus 164.2 g (500 mmol) 2-(1,1,2,2,3,3-Hexamethyl-indan-5-yl)-4,4,5,5-tetramethyl-[1,3,2]dioxa-borolan [152418-16-9] (analog können Boronsäuren eingesetzt werden), 142.0 g (500 mmol) 5-Brom-2-iod-pyridin [223463-13-6], 159.0 g (1.5 mol) Natriumcarbonat, 5.8 g (5 mmol) Tetrakis(triphenylphosphino)-palladium(0), 700 ml Toluol, 300 ml Ethanol und 700 ml Wasser wird unter gutem Rühren 16 h unter Rückfluss erhitzt. Nach dem Abkühlen werden 1000 ml Toluol zugegeben, die organische Phase wird abgetrennt, die wässrige Phase wird mit 300 ml Toluol nachextrahiert. Die vereinigten organischen Phasen werden einmal mit 500 ml gesättigter Kochsalzlösung gewaschen. Nach Trocknen der organischen Phase über Natriumsulfat und Entfernen des Lösemittels im Vakuum kristallisiert man das Rohprodukt zweimal aus ca. 300 ml EtOH um. Ausbeute: 130.8 g (365 mmol), 73 %. Reinheit: ca. 95 % n. ¹H-NMR.

Analog können folgende Verbindungen dargestellt werden:

| Bsp. | Boronsäure/-ester Pyridin | Produkt | Ausbeute |
|---|---|---|---|
| S11 | 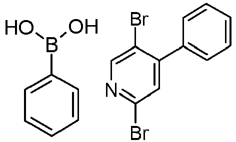 | 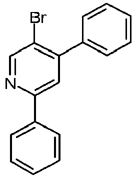 | 73% |
| | 98-80-6 / 1381937-40-1 | | |

### Beispiel S20:

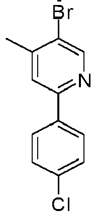

Ein Gemisch aus 25.1 g (100 mmol) 2,5-Dibrom-4-methylpyridin [3430-26-0], 15.6 g (100 mmol) 4-Chlorphenylboronsäure [1679-18-1], 27.6 g (200 mmol) Kaliumcarbonat,1.57 g (6 mmol) Triphenylphosphin [603-35-0], 676 mg (3 mmol) Palladium(II)acetat [3375-31-3], 200 g Glaskugeln (3 mm Durchmesser), 200 ml Acetonitril und 100 ml Ethanol wird 48 h unter Rückfluss erhitzt. Nach Erkalten entfernt man die Lösemittel im Vakuum, gibt 500 ml Toluol zu, wäscht zweimal mit je 300 ml Wasser, einmal mit 200 ml gesättigter Kochsalzlösung, trocknet über Magnesiumsulfat, filtriert über ein vorgeschlämmtes Kieselgelbett ab und wäscht dieses mit 300 ml Toluol nach. Nach Entfernen des Toluols im Vakuum kristallisiert man einmal aus Methanol/Ethanol (1:1 vv) und einmal aus n-Heptan um. Ausbeute: 17.3 g (61 mmol), 61 %. Reinheit: ca. 95 %ig n. ¹H-NMR.

### Beispiel S21:

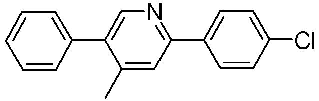

Ein Gemisch aus 28.3 g (100 mmol) S20, 12.8 g (105 mmol) Phenylboronsäure, 31.8 g (300 mmol) Natriumcarbonat, 787 mg (3 mmol) Triphenylphosphin, 225 mg (1 mmol) Palladium(II)acetat, 300 ml Toluol, 150 ml Ethanol und 300 ml Wasser wird 48 h unter Rückfluss erhitzt. Nach Erkalten wird mit 300 ml Toluol erweitert, die organische Phase wird abgetrennt, einmal mit 300 ml Wasser, einmal mit 200 ml gesättigter Kochsalzlösung gewaschen und über Magnesiumsulfat getrocknet. Nach Entfernen des Lösungsmittels wird der Rückstand an Kieselgel (Toluol/Ethylacetat, 9:1 vv) chromatographiert. Ausbeute: 17.1 g (61 mmol), 61 %. Reinheit: ca. 97 %ig n. ¹H-NMR.

Analog können die folgenden Verbindungen synthetisiert werden:

| Bsp. | Boronester | Produkt | Ausbeute |
|---|---|---|---|
| S22 | 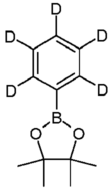 | 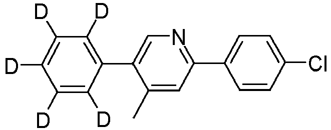 | 56% |
| | 245043-33-8 | | |
| S23 | 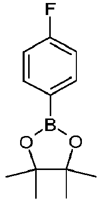 | 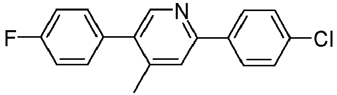 | 61 % |
| | 214360-58-4 | | |
| S24 | 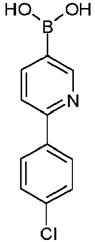 | 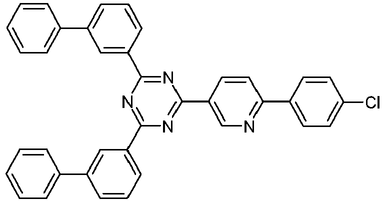 | 70% |
| | 1264513-60-1 | | |
| | 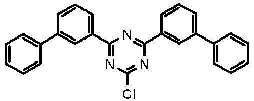 | | |
| | 1205748-61-3 | | |

### Beispiel S30: 2-[1,1,2,2,3,3-Hexamethyl-indan-5-yl]-5-(4,4,5,5-tetramethyl-[1,3,2]dioxaborolan-2-yl)-pyridin

### Variante A:

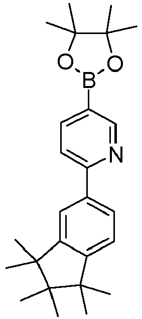

Ein Gemisch aus 35.8 g (100 mmol) S10, 25.4 g (100 mmol) Bis(pinacolato)diboran [73183-34-3], 49.1 g (500 mmol) Kaliumacetat, 1.5 g (2 mmol) 1,1-Bis(diphenylphosphino)ferrocendichlorpalladium(II)-Komplex mit DCM [95464-05-4], 200 g Glaskugeln (3 mm Durchmesser), 700 ml 1,4-Dioxan und 700 ml Toluol wird 16 h unter Rückfluss erhitzt. Nach Abkühlen wird die Suspension über ein Celite-Bett filtriert und das Lösemittel im Vakuum entfernt. Der schwarze Rückstand wird mit 1000 ml heißem Cyclohexan digeriert, es wird noch heiß über ein Celite-Bett abfiltriert, dann auf ca. 200 ml eingeengt, wobei das Produkt zu kristallisieren beginnt. Die Kristallisation wird über Nacht im Kühlschrank vervollständigt, die Kristalle werden abfiltriert und mit wenig n-Heptan gewaschen. Aus der Mutterlauge kann eine zweite Produktfraktion gewonnen werden. Ausbeute: 31.6 g (78 mmol) 78 %. Reinheit: ca. 95 %ig n. ¹H-NMR.

### Variante B: Umsetzung von Arylchloriden

Wie Variante A, jedoch wird an Stelle von 1,1-Bis(diphenylphosphino)-ferrocendichlorpalladium(II)-Komplex mit DCM 1.5 mmol SPhos [657408-07-6] und 1.0 mmol Palladium(II)acetat eingesetzt.

Analog können folgende Verbindungen dargestellt werden, wobei zur Reinigung anstelle von n-Heptan auch Cyclohexan, Toluol, Acetonitril, Ethylacetat bzw. Gemische der genannten Lösungsmittel verwendet werden können:

| Bsp. | Bromid/Triflat - Variante A Chlorid - Variante B | Produkt | Ausbeute |
|---|---|---|---|
| S31 | 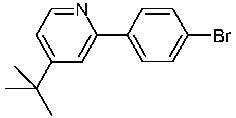 1246851-70-6 | 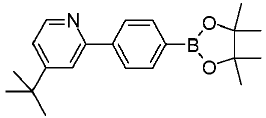 | 88% |
| S32 | 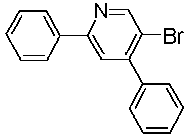 S11 | 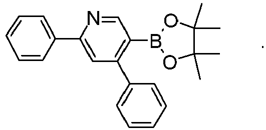 | 70% |
| S33 | 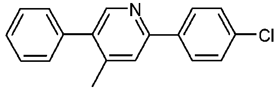 S21 | 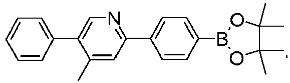 | 86% |
| S34 | 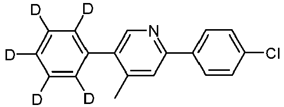 S22 | 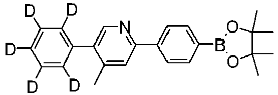 | 79% |
| S35 | 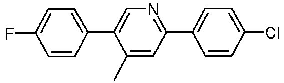 S23 | 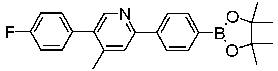 | 77 % |
| S36 | 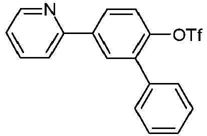 S6 | 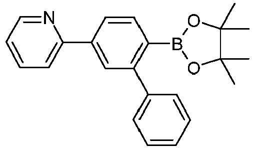 | 64% |
| S37 | 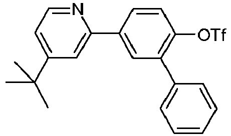 S7 | 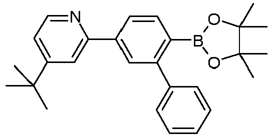 | 69% |
| S38 | 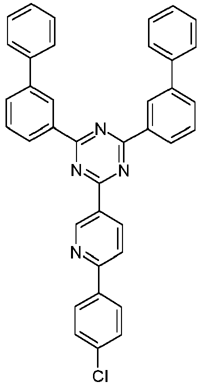 S24 | 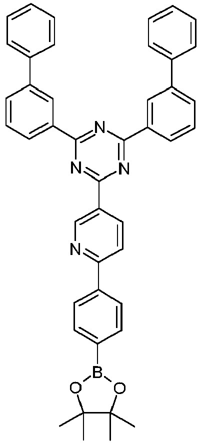 | 74% |

### Beispiel S100:

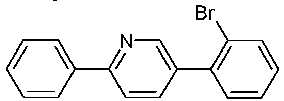

Ein Gemisch aus 28.1 g (100 mmol) 2-Phenyl-5-[4,4,5,5-tetramethyl-1,3,2-dioxaborolan-2-yl)pyridin [879291-27-7], 28.2 g (100 mmol) 1-Brom-2-iod-benzol [583-55-1], 31.8 g (300 mmol) Natriumcarbonat, 787 mg (3 mmol) Triphenylphosphin, 225 mg (1 mmol) Palladium(II)acetat, 300 ml Toluol, 150 ml Ethanol und 300 ml Wasser wird 24 h unter Rückfluss erhitzt. Nach Erkalten wird mit 500 ml Toluol erweitert, die organische Phase wird abgetrennt, einmal mit 500 ml Wasser, einmal mit 500 ml gesättigter Kochsalzlösung gewaschen und über Magnesiumsulfat getrocknet. Nach Entfernen das Lösungsmittels wird der Rückstand aus Ethylacetat/n-Heptan umkristallisiert oder an Kieselgel (Toluol/Ethylacetat, 9:1 vv) chromatographiert. Ausbeute: 22.7 g (73 mmol), 73 %. Reinheit: ca. 97 %ig n. ¹H-NMR.

Analog können die folgenden Verbindungen synthetisiert werden:

| Bsp. | Boronester | Produkt | Ausbeute |
|---|---|---|---|
| S101 | 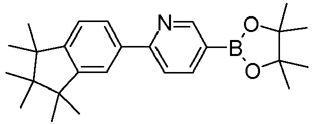 S30 | 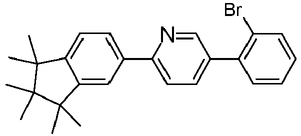 | 70% |
| S102 | 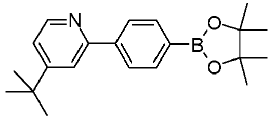 S31 | 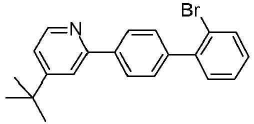 | 70% |
| S103 | 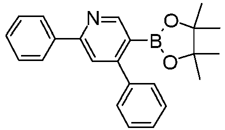 S32 | 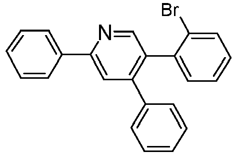 | 75% |
| S104 | 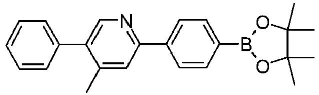 S33 | 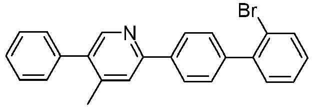 | 69% |
| S105 | 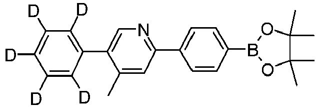 S34 | 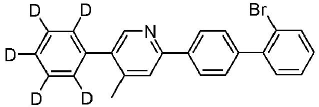 | 67 % |
| S106 | 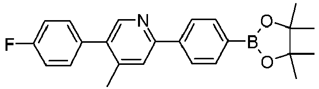 S35 | 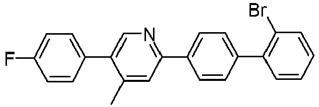 | 63% |
| S107 | 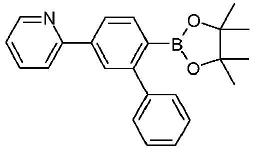 S36 | 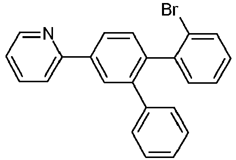 | 73% |
| S108 | 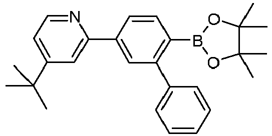 S37 | 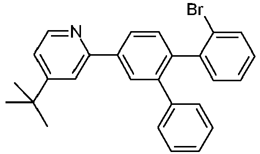 | 70% |
| S109 | 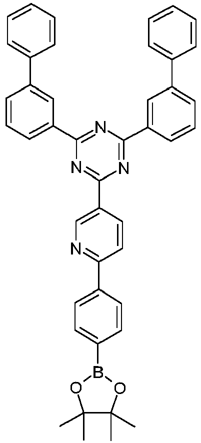 S38 | 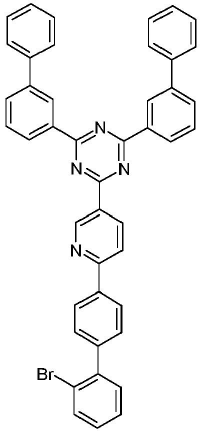 | 66% |

### Beispiel S200:

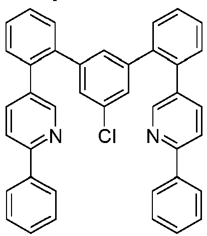

Ein gut gerührtes Gemisch aus 36.5 g (100 mmol) 2,2'-5[5-(Chlor)-1,3-phenylen-]bis[4,4,5,5-tetramethyl-1,3,2-dioxaborolan [1417036-49-7], 65.2 g (210 mmol) S100, 42.4 g (400 mmol) Natriumcarbonat, 1.57 g (6 mmol) Triphenylphosphin, 500 mg (2 mmol) Palladium(II)acetat, 500 ml Toluol, 200 ml Ethanol und 500 ml Wasser wird 48 h unter Rückfluss erhitzt. Nach Erkalten wird mit 500 ml Toluol erweitert, die organische Phase wird abgetrennt, einmal mit 500 ml Wasser, einmal mit 500 ml gesättigter Kochsalzlösung gewaschen, über Magnesiumsulfat getrocknet und dann über ein mit Toluol vorgeschlämmtes Celite-Bett filtriert. Nach Entfernen des Lösungsmittels im Vakuum wird der Rückstand aus Acetonitril, gegebenenfalls unter Zusatz von Ethylacetat, umkristallisiert. Ausbeute: 39.4 g (69 mmol), 69 %. Reinheit: ca. 95 %ig n. ¹H-NMR.

Die Rohprodukte können chromatographisch (Torrent Combi Flash der Fa. Axel Semrau) gereinigt werden.

Analog können die folgenden Verbindungen synthetisiert werden:

| Bsp. | Bromid | Produkt | Ausbeute |
|---|---|---|---|
| S201 | 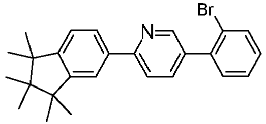 S101 | 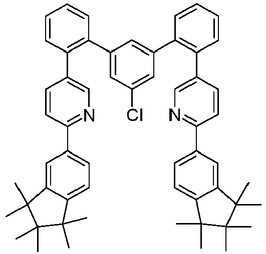 | 70% |
| S202 | 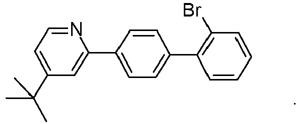 S102 | 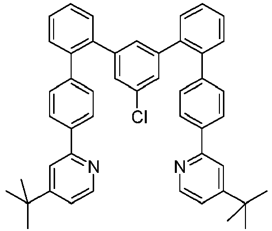 | 68 5 |
| S203 | 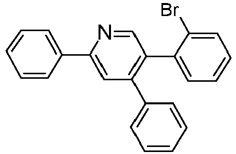 S103 | 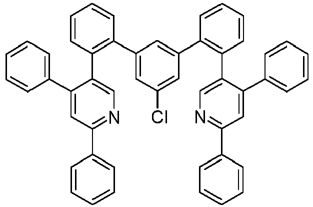 | 74 % |
| S204 | 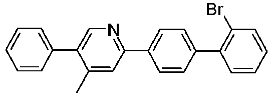 S104 | 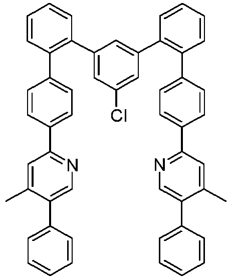 | 70 % |
| S205 | 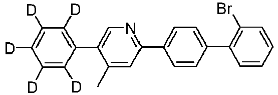 S105 | 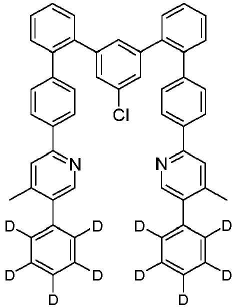 | 69 % |
| S206 | 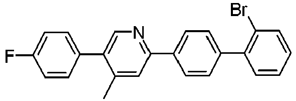 S106 | 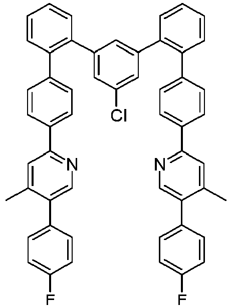 | 65 % |
| S207 | 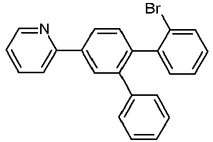 S107 | 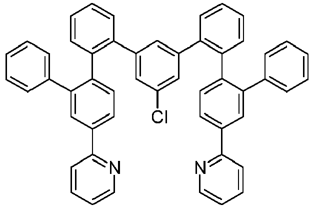 | 77 % |
| S208 | 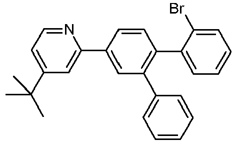 S108 | 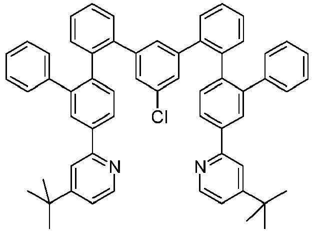 | 73 % |
| S209 | 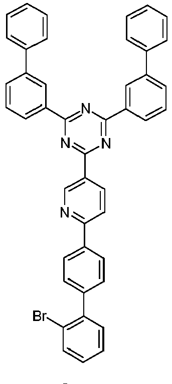 S109 | 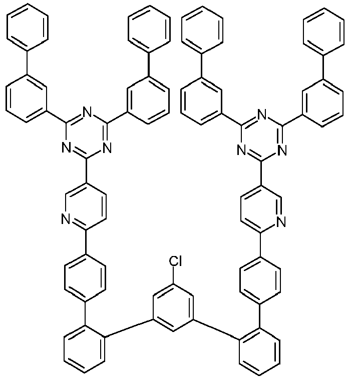 | 69 % |

### Beispiel S300:

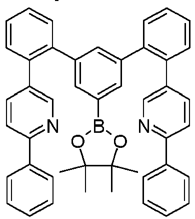

Ein Gemisch aus 57.1 g (100 mmol) S200, 27.9 g (110 mmol) Bis(pinacolato)diboran [73183-34-3], 29.4 g (300 mmol) Kaliumacetat, 534 mg (1.3 mmol) SPhos [657408-07-6], 225 mg (1 mmol) Palladium(II)-acetat, 100 g Glaskugeln (3 mm Durchmesser) und 500 ml 1,4-Dioxan wird 16 h unter Rückfluss erhitzt. Nach Abkühlen wird die Suspension im Vakuum vom 1,4-Dioxan befreit, der Rückstand wird in 500 ml Ethylacetat aufgenommen, zweimal mit 300 ml Wasser und einmal mit 200 ml gesättigter Kochsalzlösung gewaschen, über Magnesiumsulfat getrocknet und dann über ein vorgeschlämmtes Celite-Bett filtriert, welches mit etwas Ethylacetat nachgewaschen wird. Das Filtrat wird zur Trockene eingeengt und anschließend aus Ethylacetat/Methanol umkristallisiert. Ausbeute: 53.7 g (81 mmol), 81 %. Reinheit: ca. 97 %ig n. ¹H-NMR.

Analog können die folgenden Verbindungen synthetisiert werden:

| Bsp. | Edukt | Produkt | Ausbeute |
|---|---|---|---|
| S301 | 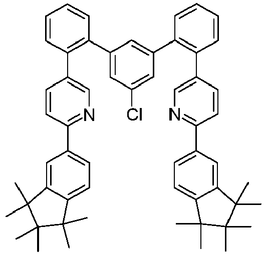 S201 | 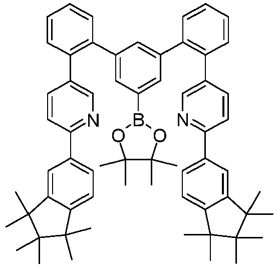 | 83% |
| S302 | 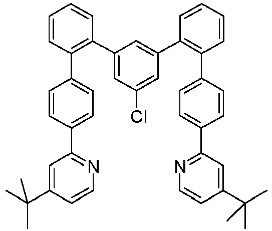 S202 | 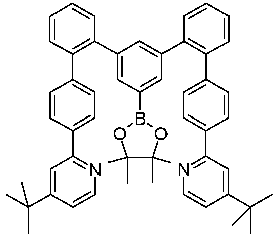 | 87 % |
| S303 | 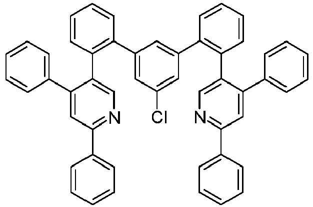 S203 | 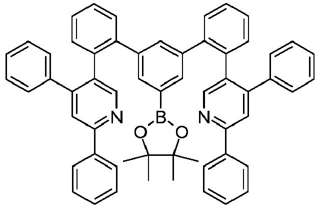 | 85 % |
| S304 | 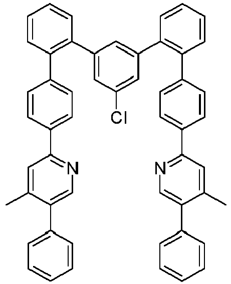 S204 | 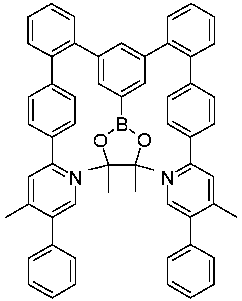 | 80 % |
| S305 | 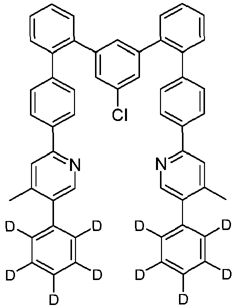 S205 | 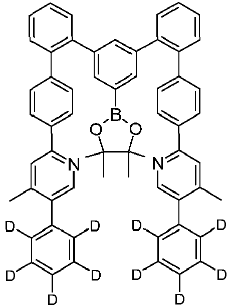 | 82 % |
| S306 | 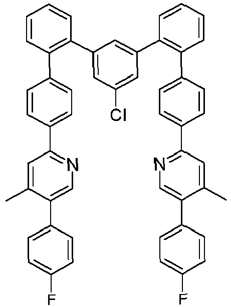 S206 | 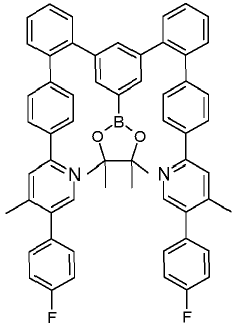 | 77 % |
| S307 | 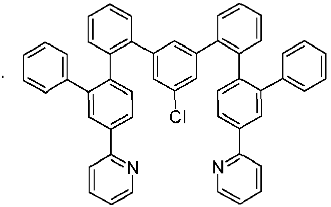 S207 | 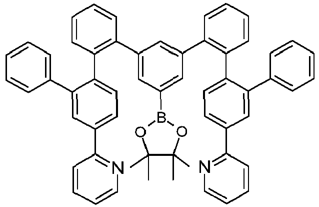 | 88 % |
| S308 | 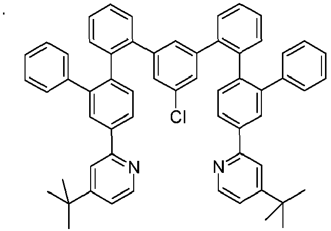 S208 | 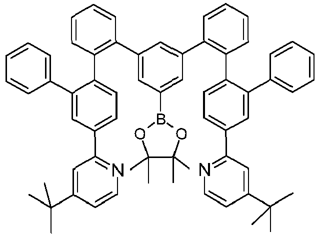 | 84 % |
| S309 | 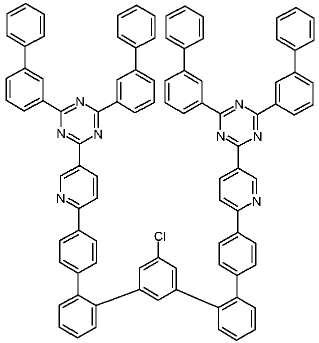 S209 | 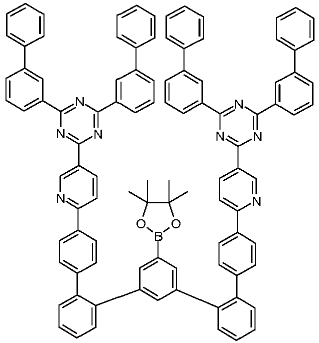 | 89 % |

### 2.2 Darstellung der hexadentaten Liganden L:

### Beispiel L1:

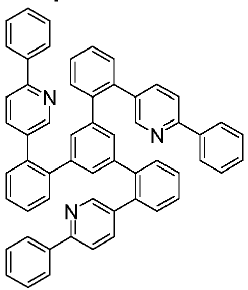

Ein Gemisch aus 54.1 g (100 mmol) 1,3,5-Tris(2-bromphenyl)benzol, [380626-56-2], 98.4 g (350 mmol) 2-Phenyl-5-(4,4,5,5-tetramethyl-[1,3,2]-dioxaborolan-2-yl)-pyridin, 106.0 g (1 mol) Natriumcarbonat, 5.8 g (5 mmol) Tetrakis(triphenylphosphino)-palladium(0), 750 ml Toluol, 200 ml Ethanol und 500 ml Wasser wird unter sehr gutem Rühren 24 h unter Rückfluss erhitzt. Nach 24 h fügt man 300 ml 5 Gew.-%ige wässrige Acetylcystein-Lösung zu, rührt weitere 16 h unter Rückfluss, lässt erkalten, trennt die wässrige Phase ab und engt die organische Phase zur Tockene ein. Man nimmt den braunen Schaum nach Einengen der organischen Phase aus der Suzuki-Kupplung in 300 ml eines Gemischs aus Dichlormethan:Ethylacetat (8:1, vv) auf und filtriert über ein mit Dichlormethan: Ethylacetat (8:1, vv) vorgeschlämmtes Kieselgelbett (Durchmesser 15 cm, Länge 20 cm), um braune Anteile zu entfernen. Nach Einengen wird der verbliebene Schaum aus 800 ml Ethylacetat unter Zusatz von 400 ml Methanol in der Siedehitze und dann ein zweites Mal aus 1000 ml reinem Ethylacetat umkristallisiert und anschließend im Hochvakuum (p ca. 10⁻⁵ mbar, T 280 °C) Kugelrohr-sublimiert. Ausbeute: 50.6 g (66 mmol), 66 %. Reinheit: ca. 99.7 %ig n. ¹H-NMR.

Analog können folgende Verbindungen dargestellt werden, wobei die Reinigung auch chromatographisch (z.B. Torrent CombiFlash der Fa. Axel Semrau) erfolgen kann:

| Bsp. | Bromid Boronester | Produkt Variante | Ausbeute |
|---|---|---|---|
| L2 | S1 | 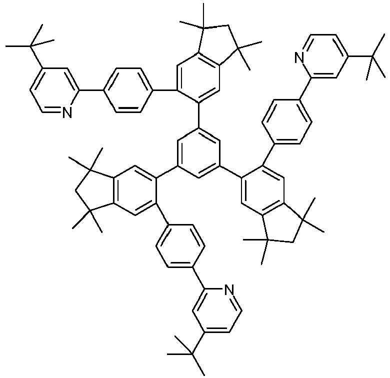 | 63% |
| | S31 | | |
| L3 | S2 | 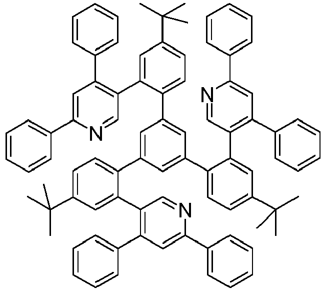 | 70% |
| | S32 | | |
| L4 | S3 | 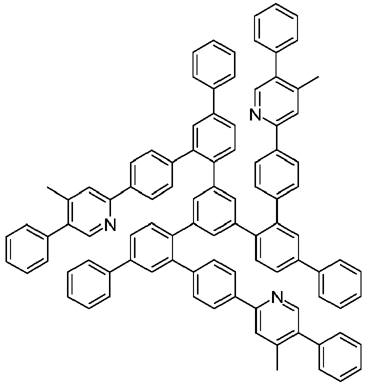 | 64% |
| | S33 | | |
| L5 | S4 | 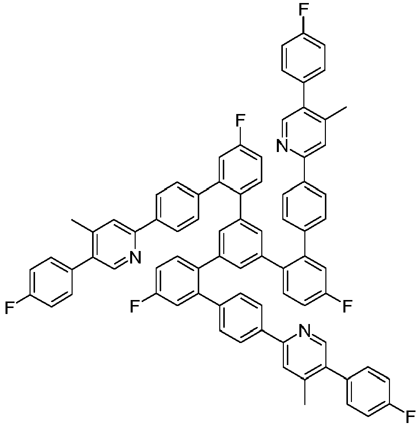 | 58% |
| | S35 | | |

### Beispiel L100:

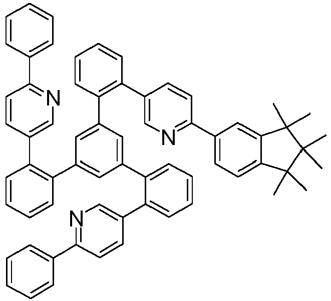

Ein Gemisch aus 66.3 g (100 mmol) S300, 43.4 g (105 mmol) S101, 63.7 g (300 mmol) Trikaliumphosphat, 1.23 g (3 mmol) SPhos [657408-07-6], 449 mg (2 mmol) Palladium(II)acetat, 500 ml Toluol, 300 ml Dioxan und 300 ml Wasser wird 6 h unter Rückfluss erhitzt. Nach Abkühlen wird die organische Phase abgetrennt, zweimal mit 300 ml Wasser und einmal mit 200 ml gesättigter Kochsalzlösung gewaschen, über Magnesiumsulfat getrocknet und dann über ein mit Toluol vorgeschlämmtes Celite-Bett filtriert, welches mit Toluol nachgewaschen wird. Das Filtrat wird zur Trockene eingeengt und der Rückstand wird anschließend zweimal aus Ethylacetat/Methanol umkristallisiert. Ausbeute: 58.8 g (66 mmol), 66 %. Reinheit: ca. 97 % n. ¹H-NMR.

Analog können die folgenden Verbindungen synthetisiert werden:

| Bsp. | Boronester Bromid | Produkt | Ausbeute |
|---|---|---|---|
| L101 | S301 | 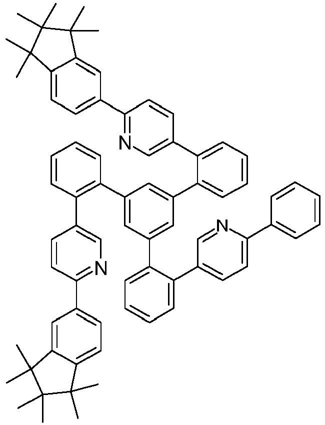 | 70% |
| | S100 | | |
| L102 | S301 | 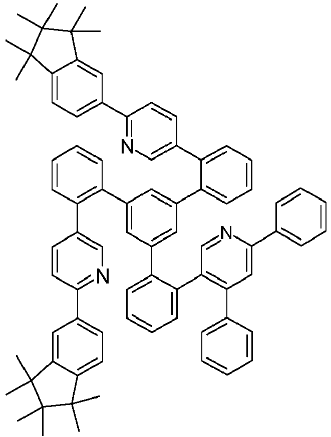 | 72 % |
| | S103 | | |
| L103 | S302 | 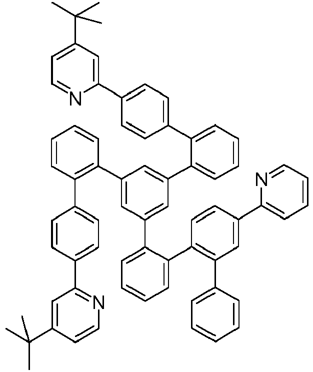 | 68% |
| | S107 | | |
| L104 | S302 | 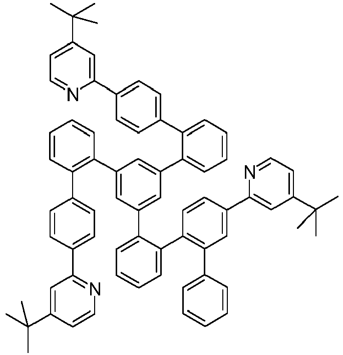 | 79% |
| | S108 | | |
| L105 | S303 | 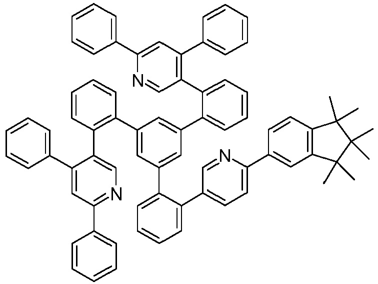 | 75% |
| | S101 | | |
| L106 | S304 | 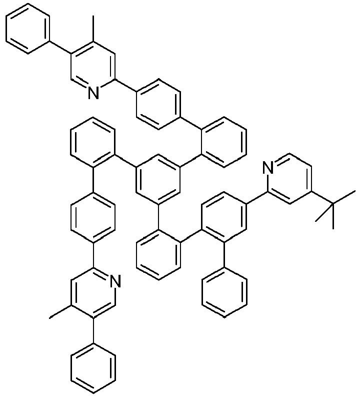 | 68% |
| | S108 | | |
| L107 | S305 | 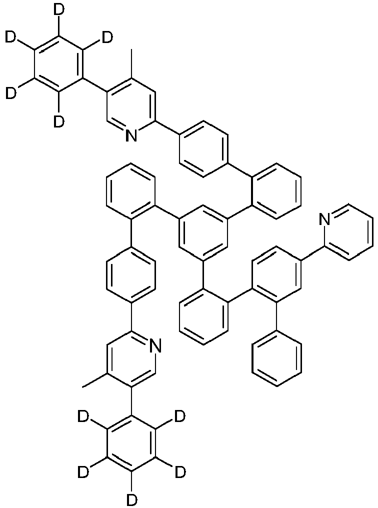 | 67 % |
| | S107 | | |
| L108 | S306 | 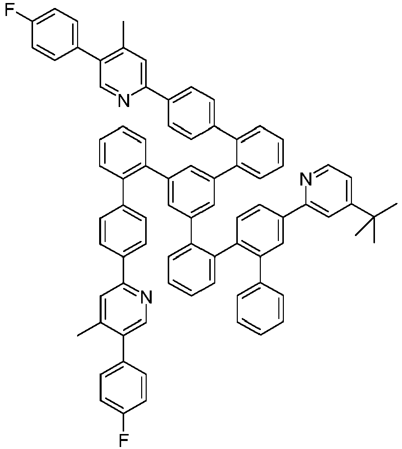 | 70% |
| | S108 | | |
| L109 | S307 | 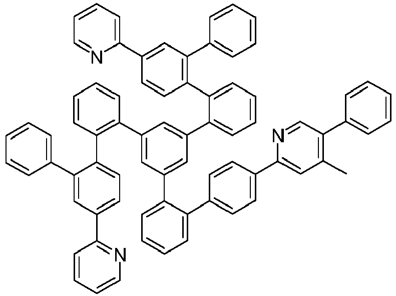 | 76% |
| | S104 | | |
| L110 | S308 | 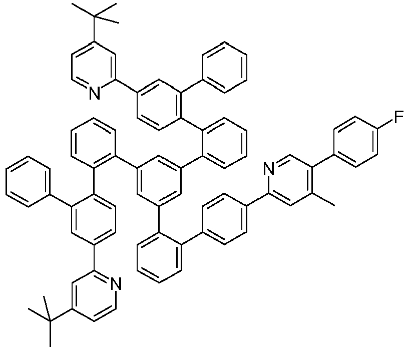 | 69% |
| | S106 | | |
| L111 | S309 | 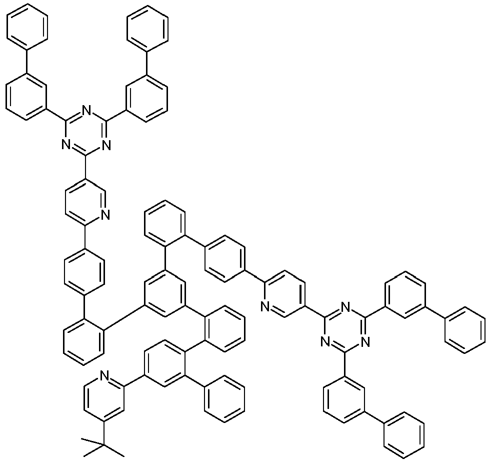 | 67 % |
| | S108 | | |
| L112 | S308 | 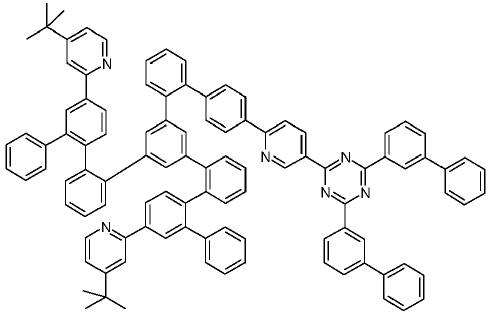 | |
| | S109 | | |

### 2.3 Darstellung der einkernigen Metallkomplexe:

### Beispiel Ir(L1):

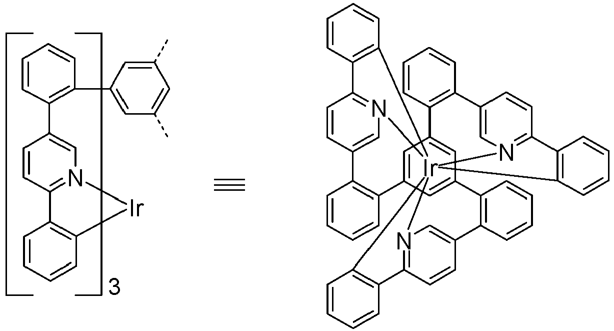

Ein Gemisch aus 7.66 g (10 mmol) des Liganden L1, 4.90 g (10 mmol) Tris-acetylacetonato-iridium(III) [15635-87-7] und 120 g Hydrochinon [123-31-9] wird in einem 500 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen. Der Kolben wird in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 250 - 260 °C, gemessen am Pt-100 Thermofühler, der in die aufgeschmolzene, gerührte Reaktionsmischung eintaucht, erhitzt. Während der nächsten 1.5 h wird das Reaktionsgemisch bei 250 - 260 °C gehalten, wobei wenig Kondensat abdestilliert und sich im Wasserabscheider sammelt. Nach Erkalten wird der Schmelzkuchen mechanisch zerkleinert und mit 500 ml Methanol ausgekocht. Die so erhaltene beige Suspension wird über eine Umkehrfritte filtriert, der beige Feststoff wird einmal mit 50 ml Methanol gewaschen und dann im Vakuum getrocknet. Rohausbeute: quantitativ. Der so erhaltene Feststoff wird in 1500 ml Dichlormethan gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten und am Rotationsverdampfer weitgehend eingeengt, wobei gleichzeitig kontinuierlich MeOH bis zur Kristallisation zugetropft wird. Nach Absaugen, Waschen mit wenig MeOH und Trocknen im Vakuum erfolgt die weitere Reinigung des gelben Produkts durch dreimalige kontinuierliche Heißextraktion mit Toluol:Acetonitril (3:1, vv) und fünfmalige Heißextraktion mit Toluol (Vorlagemenge jeweils ca. 150 ml, Extraktionshülse: Standard Soxhletthülsen aus Cellulose der Fa. Whatman) unter sorgfältigem Luft-und Lichtausschluss. Ausbeute: 8.52 g (8.9 mmol), 89 %. Reinheit: > 99.9 % nach HPLC.

Analog können folgende Verbindungen dargestellt werden:

| Bsp. | Ligand | Produkt Reaktionszeit* Reaktionstemperatur* Extraktionsmittel* | Ausbeute |
|---|---|---|---|
| Ir(L2) | L2 | Ir(L2) | 87 % |
| | | 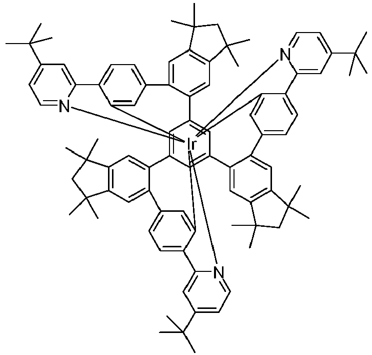 | |
| | | Ethylacetat Acetonitril (1:2 vv) | |
| Ir(L3) | L3 | Ir(L3) Toluol | 84 % |
| Ir(L4) | L4 | Ir(L4) Butylacetat | 85 % |
| Ir(L5) | L5 | Ir(L5) Toluol | 80 % |
| Ir(L100) | L100 | Ir(L100) | 61 % |
| | | 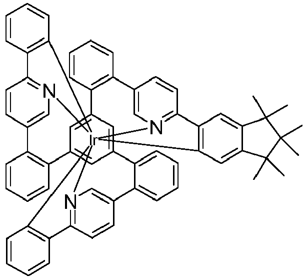 | |
| | | Ethylacetat | |
| Ir(L101) | L101 | Ir(L101) | 63 % |
| | | Butylacetat | |
| Ir(L102) | L102 | Ir(L102) | 49 % |
| | | wie Ir(L101) | |
| Ir(L103) | L103 | Ir(L103) | 58 % |
| | | wie Ir(L101) | |
| Ir(L104) | L104 | Ir(L104) | 71 % |
| | | wie Ir(L101) | |
| Ir(L105) | L105 | Ir(L105) | 66 % |
| | | wie Ir(L101) | |
| Ir(L106) | L106 | Ir(L106) | 70 % |
| | | wie Ir(L101) | |
| Ir(L107) | L107 | Ir(L107) | 70 % |
| | | wie Ir(L101) | |
| Ir(L108) | L108 | Ir(L108) | 67 % |
| | | wie Ir(L101) | |
| Ir(L109) | L109 | Ir(L109) | 63 % |
| | | wie Ir(L101) | |
| Ir(L110) | L110 | Ir(L110) | 65 % |
| | | wie Ir(L101) | |
| Ir(L111) | L111 | Ir(L111) | 61 % |
| | | Toluol | |
| Ir(L112) | L112 | Ir(L112) | 57 % |
| | | Dichlormethan / Acetonitril (1:3 vv) | |

| | | | |
|---|---|---|---|
| *: Angabe sofern abweichend von allgemeiner Vorschrift | | | |

### 2.4 Halogenierung der einkernigen Metallkomplexe:

### Allgemeine Durchführung:

Eine Lösung bzw. Suspension von 10 mmol eines Komplexes, der in para-Position zum Iridium A × C-H-Gruppen trägt, in 500 ml bis 2000 ml Dichlormethan, je nach Löslichkeit des Metallkomplexes, wird unter Licht- und Luftausschluss bei -30 bis +30 °C mit A × 10.5 mmol N-Halogen-succinimid (Halogen: Cl, Br, I; A = 1 entspricht Mono-, A = 2 entspricht Di-, A = 3 entspricht Trihalogenierung) versetzt und 20 h gerührt. In DCM schlecht lösliche Komplexe können auch in anderen Lösungsmitteln (TCE, THF, DMF, Chlorbenzol, etc.) und bei erhöhter Temperatur umgesetzt werden. Anschließend wird das Lösungsmittel im Vakuum weitgehend entfernt. Der Rückstand wird mit 100 ml Methanol ausgekocht, der Feststoff wird abgesaugt, dreimal mit ca. 30 ml Methanol gewaschen und dann im Vakuum getrocknet. Unterstöchiometrische Bromierungen, z. B. Mono- und Di-Bromierungen von Komplexen mit 3 C-H-Gruppen para-Position zum Iridium, verlaufen meist weniger selektiv als die stöchiometrischen Bromierungen. Die Rohprodukte dieser Bromierungen können chromatographisch (CombiFlash Torrent der Fa. A. Semrau) oder durch fraktionierte Kristallisation getrennt werden.

### Beispiel Ir(L1-3Br):

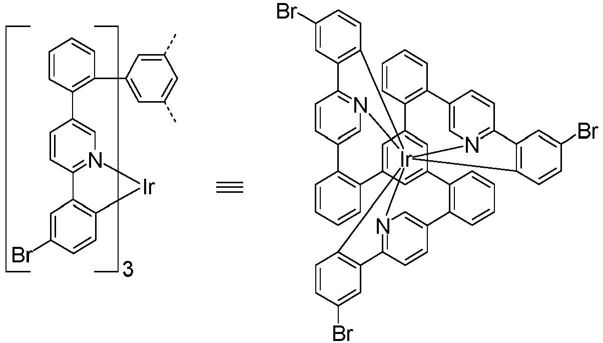

Eine bei 0 °C gerührte Suspension von 9.6 g (10 mmol) Ir(L1) in 2000 ml Dichlormethan (DCM) wird auf einmal mit 5.6 g (31.5 mmol) N-Bromsuccinimid versetzt und dann weitere 20 h gerührt. Nach Entfernen von ca. 1900 ml des DCMs im Vakuum wird die gelbe Suspension mit 100 ml Methanol versetzt, unter Rühren ausgekocht, der Feststoff wird abgesaugt, dreimal mit ca. 30 ml Methanol gewaschen und dann im Vakuum getrocknet. Ausbeute: 11.3 g (9.5 mmol) 95 %; Reinheit: > 99.0 %ig nach NMR.

Analog können folgende Komplexe dargestellt werden:

| Bsp. | Edukt > bromierter Komplex Bedingungen (wenn abweichend von allgemeiner Vorschrift) | Ausbeute |
|---|---|---|
| Tribromierung | | |
| Ir(L3-3Br) | 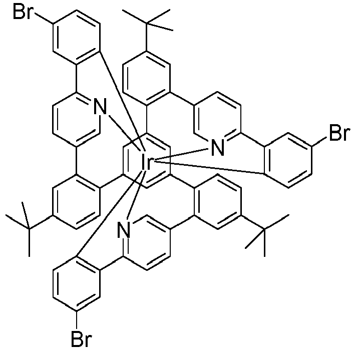 | 92 % |
| Ir(L4-3Br) | 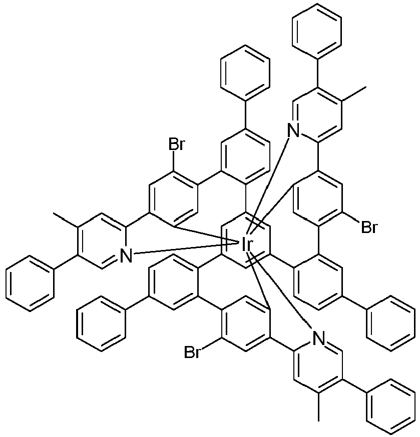 | 90 % |

| Dibromierung | | |
|---|---|---|
| Ir(L1-2Br) | 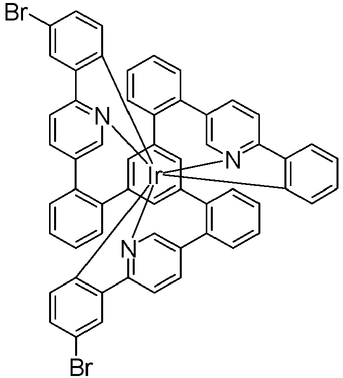 | 33 % |
| | Ir(L1) + 21 mmol NBS > Ir(L1-2Br) DMSO / 60 °C | |
| Ir(L1 00-2Br) | 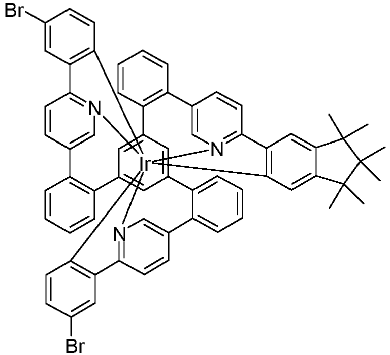 | 95% |
| | Ir(L100) + 21 mmol NBS > Ir(L100-2Br) DCM | |
| Ir(L103-2Br) | 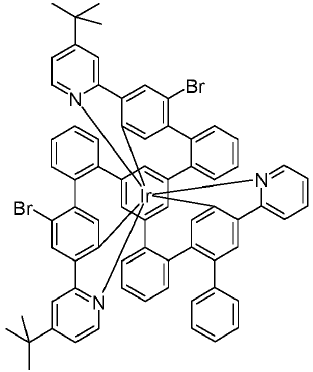 | 93 % |
| | Ir(L103) + 21 mmol NBS > Ir(L103-2Br) DCM | |
| Ir(L104-2Br) | 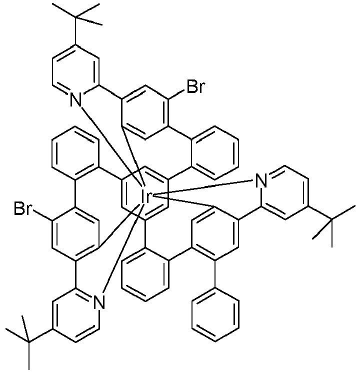 | 94 % |
| | Ir(L104) + 21 mmol NBS > Ir(L104-2Br) DCM | |
| Ir(L105-2Br) | 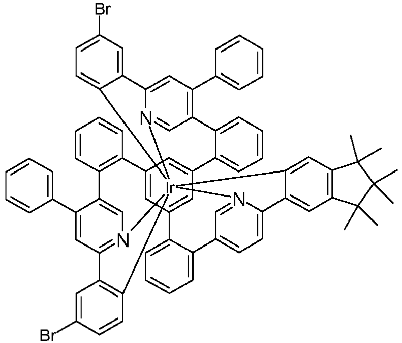 | 93 % |
| | Ir(L105) + 21 mmol NBS > Ir(L105-2Br) DCM | |
| Ir(L106-2Br) | 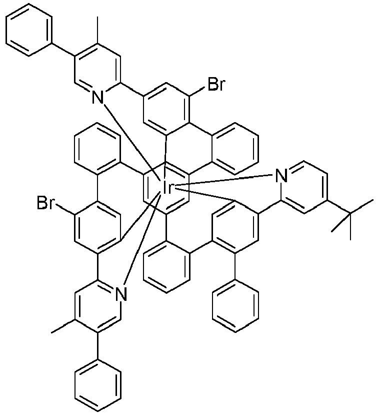 | 91 % |
| | Ir(L106) + 21 mmol NBS > Ir(L106-2Br) DCM | |
| Ir(L107-2Br) | 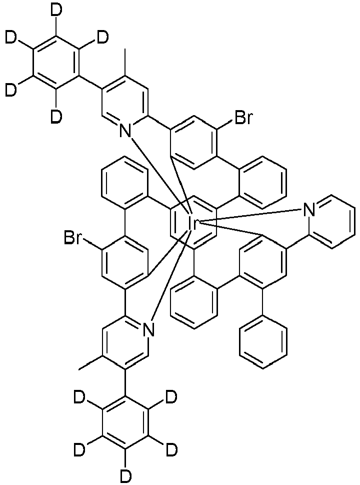 | 90 % |
| | Ir(L107) + 21 mmol NBS > Ir(L107-2Br) DCM | |
| Ir(L108-2Br) | 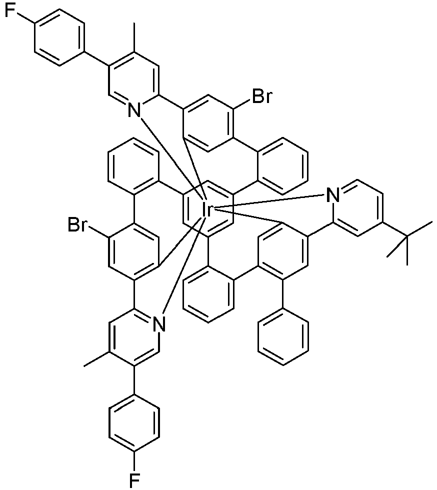 | 92 % |
| | Ir(L108) + 21 mmol NBS > Ir(L108-2Br) DCM | |
| Ir(L111-2Br) | 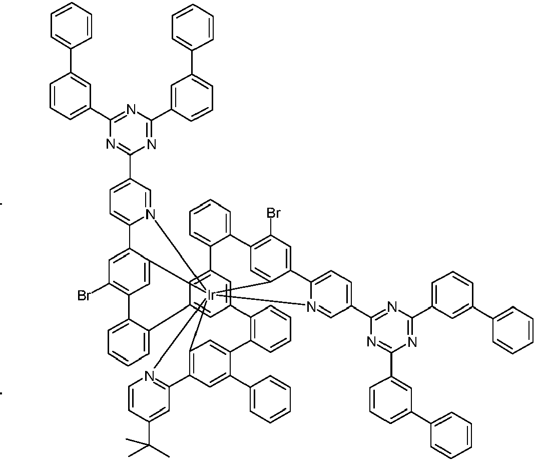 | 87 % |
| | Ir(L111) + 21 mmol NBS > Ir(L111-2Br) DCM | |

| Monobromierung | | |
|---|---|---|
| | | |
| Ir(L1-1Br) | 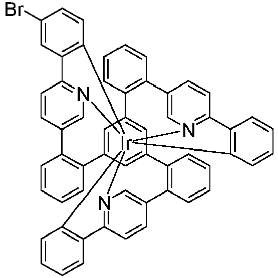 | 24 % |
| | Ir(L1) + 10.5 mmol NBS > Ir(L1-1Br) DMSO / 60 °C | |
| Ir(L2-1Br) | 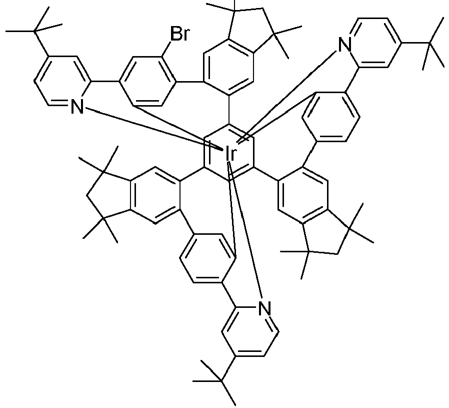 | 33 % |
| | Ir(L2) + 10.5 mmol NBS > Ir(L2-1Br) DCM | |
| Ir(L3-1Br) | 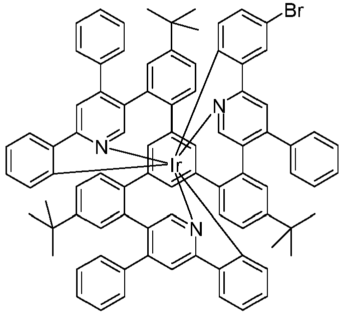 | 30 % |
| | Ir(L3) + 10.5 mmol NBS > Ir(L3-1Br) DCM | |
| Ir(L4-1Br) | 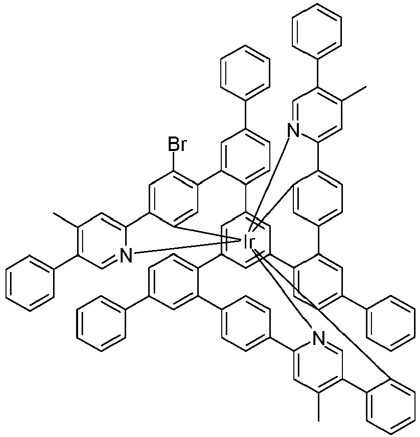 | 30 % |
| | Ir(L4) + 10.5 mmol NBS > Ir(L4-1Br) DCM | |
| Ir(L5-1Br) | 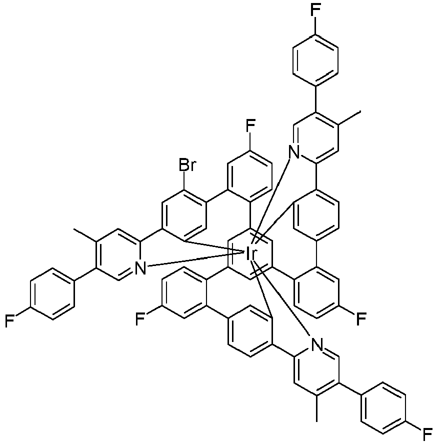 | 29 % |
| | Ir(L5) + 10.5 mmol NBS > Ir(L5-1Br) DCM | |
| Ir(L100-1Br) | 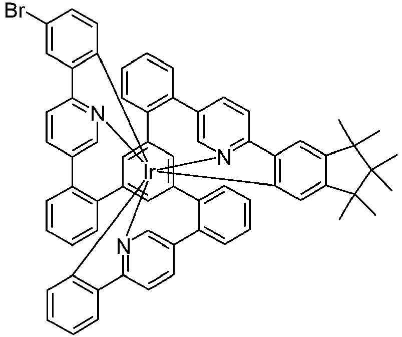 | 27 % |
| | Ir(L100) + 10.5 mmol NBS > Ir(L100-1Br) DCM / Diastereomerengemisch | |
| Ir(L101-1Br) | 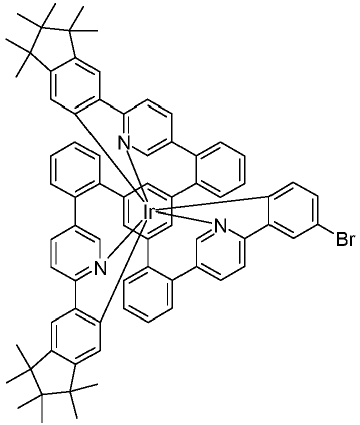 | 91 % |
| | Ir(L101) + 10.5 mmol NBS > Ir(L101-1Br) DCM | |
| Ir(L102-1Br) | 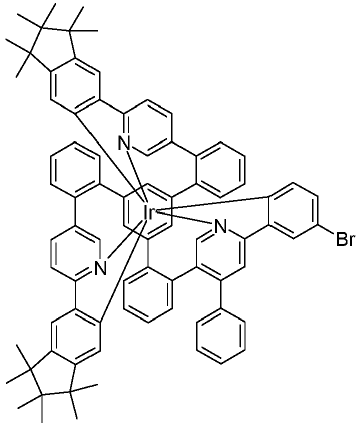 | 93 % |
| | Ir(L102) + 10.5 mmol NBS > Ir(L102-1Br) DCM | |
| Ir(L109-1Br) | 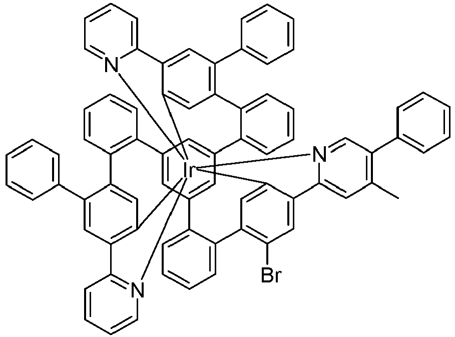 | 92 % |
| | Ir(L109) + 10.5 mmol NBS > Ir(L109-1Br) DCM | |
| Ir(L110-1Br) | 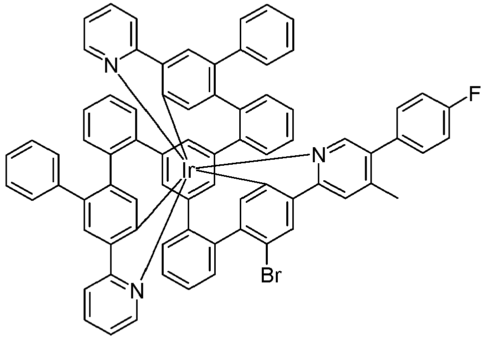 | 90 % |
| | Ir(L110) + 10.5 mmol NBS > Ir(L110-1Br) DCM | |
| Ir(L112-1Br) | 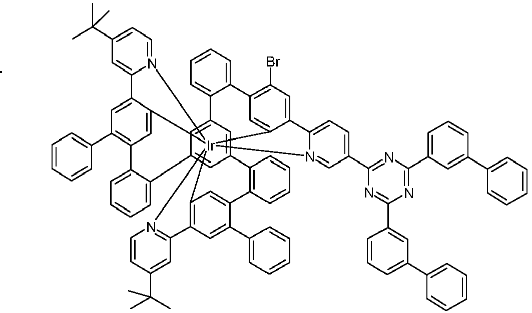 | 86 % |
| | Ir(L112) + 10.5 mmol NBS > Ir(L11-1Br) DCM | |

### 2.5 Borylierung der einkernigen Metallkomplexe mit Bromfunktion:

Ein Gemisch von 10 mmol des bromierten Komplexes, 12 mmol Bis-(pinacolato)diboran [73183-34-3] pro Brom-Funktion, 30 mmol Kaliumacetat, wasserfrei pro Bromfunktion, 0.2 mmol Tricyclohexylphosphin, 0.1 mmol Palladium(II)acetat (Variante A) oder 0.2 mmol dppfPdCl₂ * CH₂Cl₂ [95464-05-4] (Variante B) und 300 ml Lösungsmittel (Dioxan, DMSO, NMP, Toluol, etc.) wird 4-16 h bei 80-160 °C gerührt. Nach Entfernen des Lösungsmittels im Vakuum wird der Rückstand in 300 ml Dichlormethan, THF oder Ethylacetat aufgenommen, über ein Celite-Bett filtriert, das Filtrat wird bis zur beginnenden Kristallisation im Vakuum eingeengt und abschließend noch tropfenweise mit ca. 100 ml Methanol versetzt, um die Kristallisation zu vervollständigen. Die Verbindungen können aus Dichlormethan, Ethylacetat oder THF unter Zusatz von Methanol umkristallisiert werden.

### Synthese von Ir(L1-3BE) - Variante A:

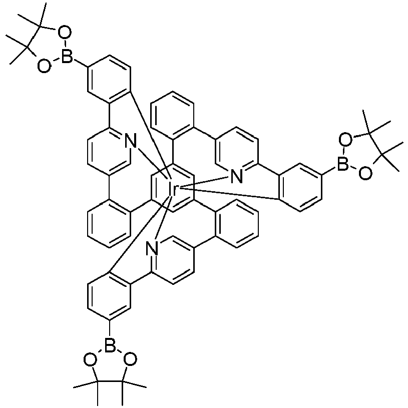

Einsatz von 11.9 g (10 mmol) Ir(L1-3Br) und 9.1 g (36 mmol) Bis(pinacolato)diboran [73183-34-3], Dioxan/Toluol 1:1 vv, 120 °C, 16 h, aufnehmen und Celite-Filtration in THF, Umkristallisation aus THF:Methanol. Ausbeute: 7.3 g (5.5 mmol) 55 %; Reinheit: ca. 99.8 %ig nach HPLC.

Analog können folgende Verbindungen dargestellt werden:

| Bsp. | Produkt Edukt / Variante | Ausbeute |
|---|---|---|
| Diborylierung | | |
| | | |
| Ir(L1-2BE) | 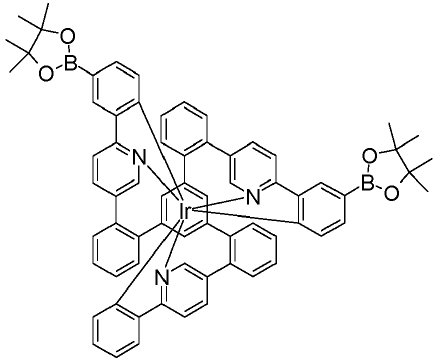 Ir(L1-2Br) / A | 64% |
| Ir(L100-2BE) | 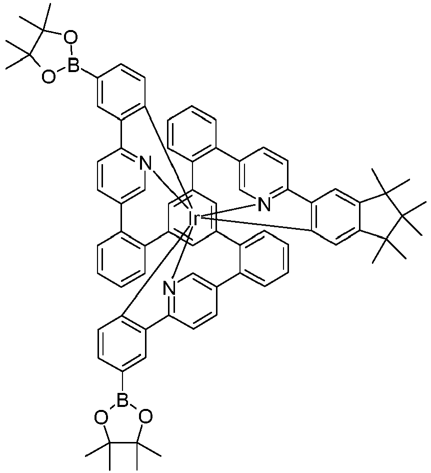 Ir(L100-2Br) / A | 92 % |
| Ir(L103-2BE) | 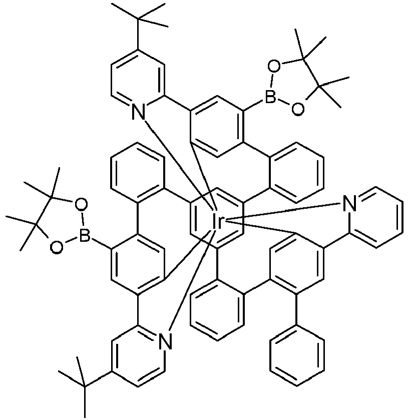 Ir(L103-2Br) / B | 90% |
| Ir(L104-2BE) | 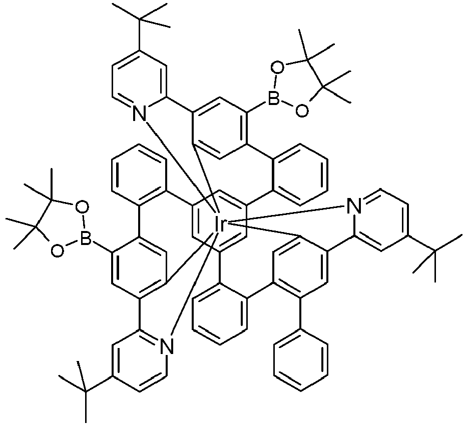 Ir(L104-2Br) / B | 90% |
| Monoborylierung | | |
| Ir(L1-1BE) | 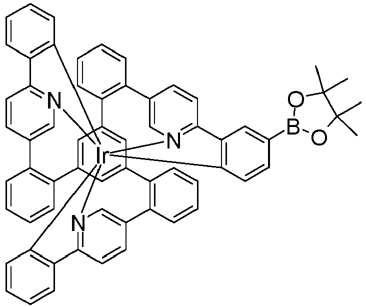 Ir(L1-1Br) / A | 78% |
| Ir(L2-1BE) | 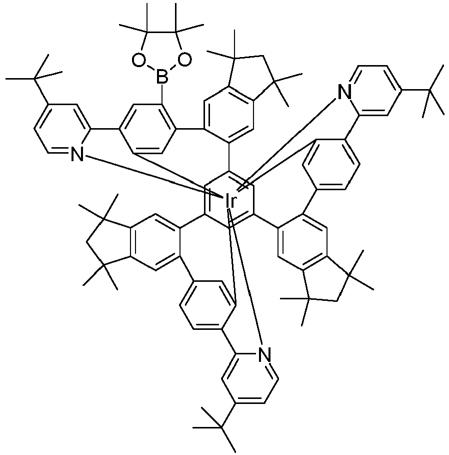 Ir(L2-1Br) / B | 80% |
| Ir(L3-1BE) | 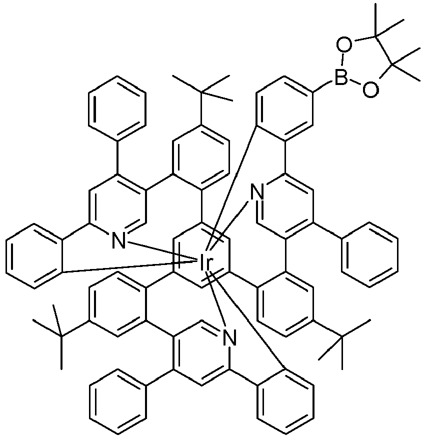 Ir(L3-1Br) / A | 86% |
| Ir(L4-1BE) | 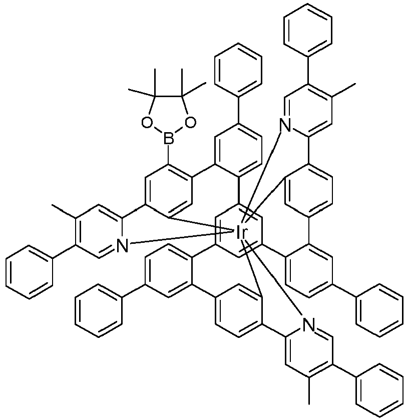 Ir(L4-1Br) / B | 80% |
| Ir(L5-1BE) | 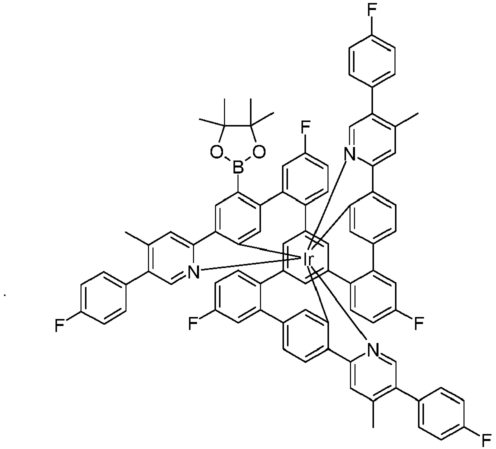 Ir(L5-1Br) / B | 75% |
| Ir(L100-1BE) | 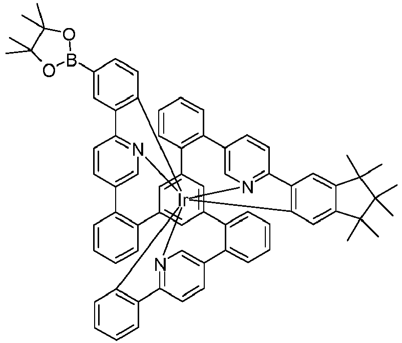 Ir(L100-1Br) / A | 79% |
| Ir(L101-BE) | 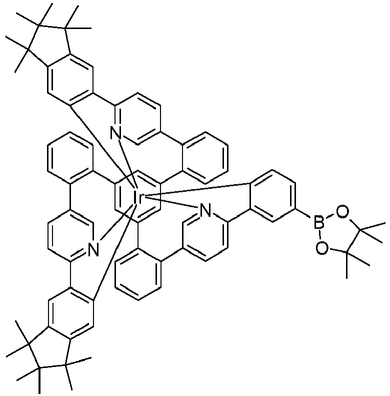 Ir(L101-1Br) / A | 77 % |
| Ir(L102-1BE) | 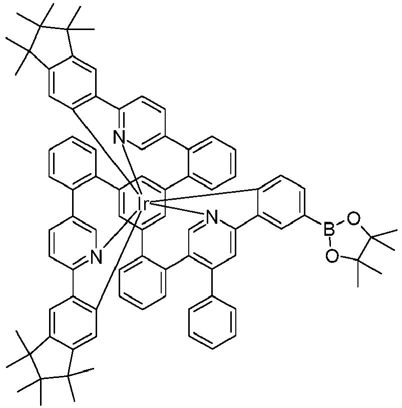 Ir(L102-1Br) / A | 74% |
| Ir(L109-1BE) | 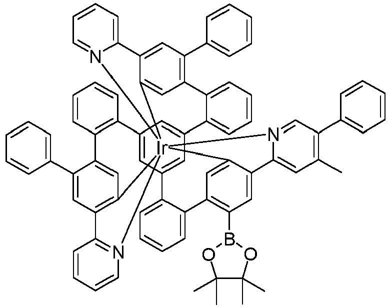 Ir(L109-1Br) / B | 78% |
| Ir(L110-1BE) | 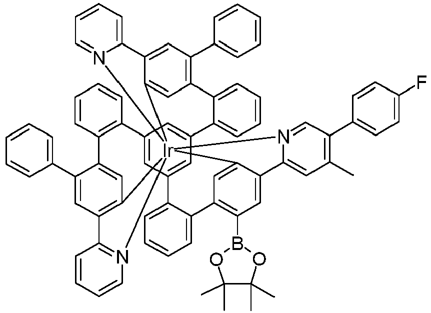 Ir(L110-1Br) / B | 80% |
| Ir(L112-1BE) | 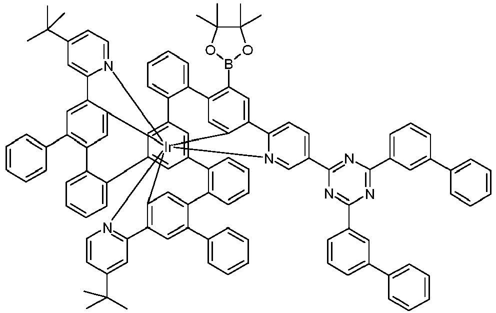 Ir(L112-1Br) / B | 78% |

### 2.6 Suzuki-Kupplung von borylierten Metallkomplexen mit Chlor-Brom-Aromaten

Ein Gemisch von 1 Äquivalent des Metalloboronester, 1.0-1.1 Äquivalenten des Chlor-brom-Aromaten, 3 Äquivalenten Trikaliumphosphat [7778-53-2] pro Boronesterfunktion, 300 ml Toluol, 100 ml Dioxan und 100 ml Wasser wird mit 0.06 Äquivalenten Tri-o-tolylphosphin [6163-58-2] und 0.01 Äquivalenten Palladium(II)acetat [3975-31-3] pro Boronesterfunktion versetzt und 18 h unter Rückfluss gut gerührt. Nach Erkalten saugt man vom ausgefallenen Feststoff ab. Fällt kein Feststoff aus, trennt man die organische Phase ab, wäscht diese zweimal mit je 300 ml Wasser, einmal mit 300 ml gesättigter Kochsalzlösung, trocknet über Magnesiumsulfat, filtriert vom Magnesiumsulfat über ein mit Toluol vorgeschlämmtes Celite-Bett ab und engt das Filtrat zur Tockene ein. Das so erhaltene Rohprodukt wird durch Umkristallisation, chromatographisch oder Flash-chromatographisch (CombiFlash Torrent der Fa. Axel Semrau) gereinigt. Die weitere Reinigung erfolgt durch wiederholte kontinuierliche Heißextraktion, wobei das Produkt in einem Heißextraktor in einer Cellulosehülse (Fa. Whatman) vorgelegt und mit einem geeigneten Heißextraktionsmittel, z. B. Toluol, Chlorbenzol, Anisol, Ethylacetat, Butylacetat, Acetonitril, Dichlormethan, etc. (Vorlagemenge ca. 150-200 ml) wiederholt (typischerweise zweimal) heißextrahiert wird, bis eine Reinheit > 99.0 % erreicht wird.

### Synthese von Ir(L200-2Cl):

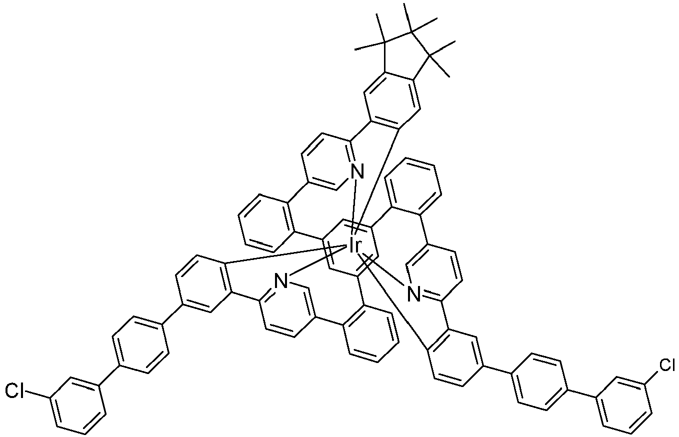

Einsatz von 5.9 g (22 mmol) 4'-Brom-3-chlor-1,1'-biphenyl [91354-09-5], 12.4 g (10 mmol) Ir(L100-2BE), 12.7 g (60 mmol) Trikaliumphosphat, 365 mg (1.2 mmol) Tri-o-tolylphosphin und 45 mg (0.2 mmol) Palladium-(II)acetat. Chromatographische Reinigung mit DCM an Kieselgel, dann zweimalige Heißextraktion mit Toluol. Ausbeute: 9.2 g (6.3 mmol) 63 %; Reinheit: ca. 99.5 %ig nach HPLC.

Analog können folgende Verbindungen dargestellt werden:

| Bsp. | Produkt Chlor-brom-Aromat / Metalloboronester | Ausbeute |
|---|---|---|
| | Dichloride | |
| Ir(L201-2Cl) | 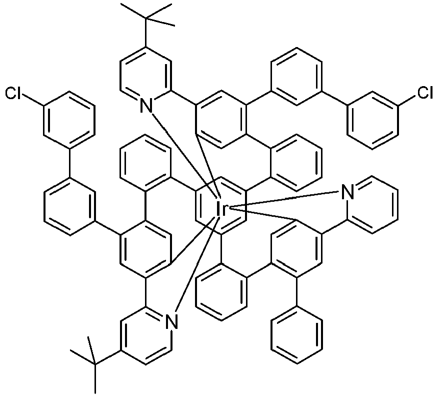 | 65% |
| | Ir(L103-2BE) | |
| | 844856-42-4 | |
| Ir(L202-2Cl) | 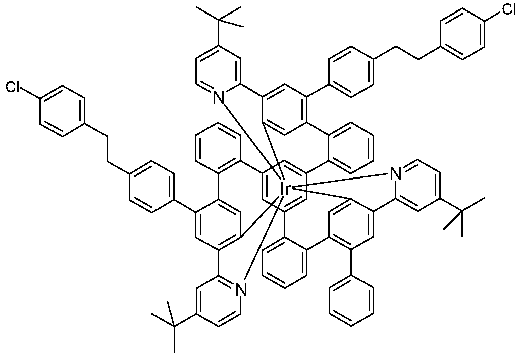 | 58% |
| | Ir(L104-2BE) | |
| | 108545-62-6 | |

| | Monochloride | |
|---|---|---|
| Ir(L250-1Cl) | 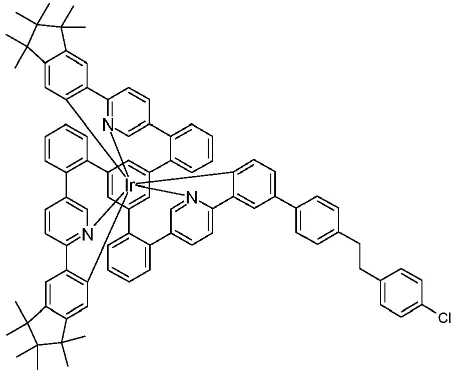 | |
| | Ir(L101-1BE) | |
| | 844856-42-4 | |
| Ir(L251-1Cl) | 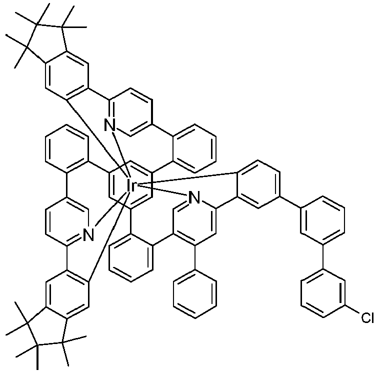 | |
| | Ir(L102-1Br) | |
| | 844856-42-4 | |
| Ir(L252-1Cl) | 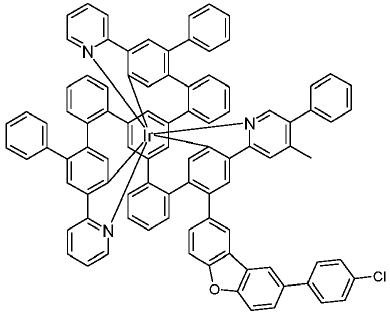 | |
| | Ir(L109-1Br) | |
| | 1426323-63-8 | |
| Ir(L253-1Cl) | 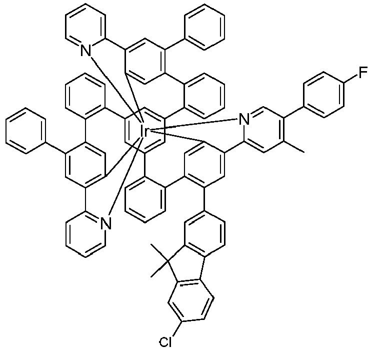 | |
| | Ir(L110-1Br) | |
| | 605630-37-3 | |
| Ir(L254-1Cl) | 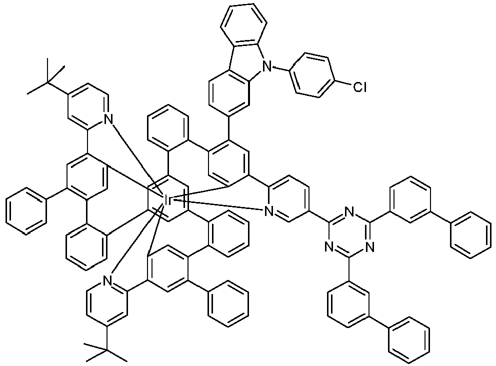 | |
| | Ir(L112-1Br) | |
| | 1151816-79-3 | |

### 2.7 Borylierung der einkernigen Metallkomplexe mit Chlorfunktion

Ein Gemisch von 10 mmol des Komplexes mit Chlorfunktion, 11 mmol Bis-(pinacolato)diboran [73183-34-3] pro Chlorfunktion, 30 mmol Kaliumacetat, wasserfrei pro Chlorfunktion, 0.13 mmol SPhos, 0.1 mmol Palladium(II)acetat und 300 ml Lösungsmittel (Dioxan, DMSO, NMP, Toluol, etc.) wird 4-16 h bei 80-160 °C gerührt. Nach Entfernen des Lösungsmittels im Vakuum wird der Rückstand in 300 ml Dichlormethan, THF oder Ethylacetat aufgenommen, über ein Celite-Bett filtriert, das Filtrat wird bis zur beginnenden Kristallisation im Vakuum eingeengt und abschließend noch tropfenweise mit ca. 100 ml Methanol versetzt, um die Kristallisation zu vervollständigen. Die Verbindungen können aus Dichlormethan, Ethylacetat oder THF unter Zusatz von Methanol umkristallisiert werden.

### Synthese von Ir(L200-2BE):

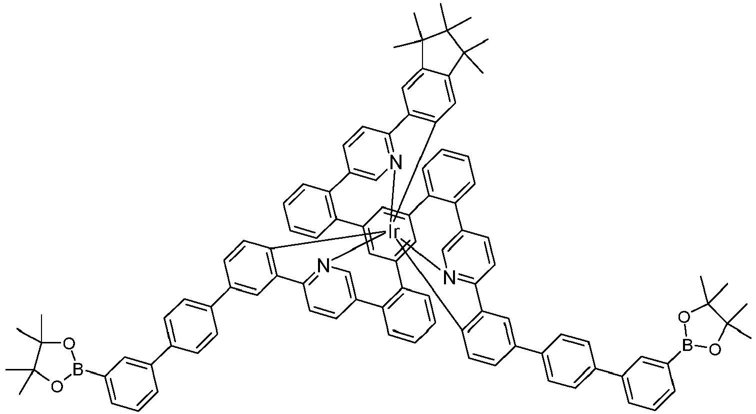

Es werden 12.4 g (10 mmol) Ir(L200-2Cl), und 5.6 g (22 mmol) Bis-(pinacolato)diboran [73183-34-3] in 300 ml Dioxan eingesetzt und 16 h bei 120 °C gerührt. Der Rückstand wird in DMC aufgenommen und über Celite filtriert. Die weitere Reinigung erfolgt durch Umkristallisation aus Ethylacetat/Methanol. Ausbeute: 14.9 g (9.1 mmol) 91 %; Reinheit: ca. 99 %ig nach HPLC.

Analog können golgende Verbindungen dargestellt werden:

| Bsp. | Produkt Edukt | Ausbeute |
|---|---|---|
| Diborylierung | | |
| Ir(L201-2BE) | 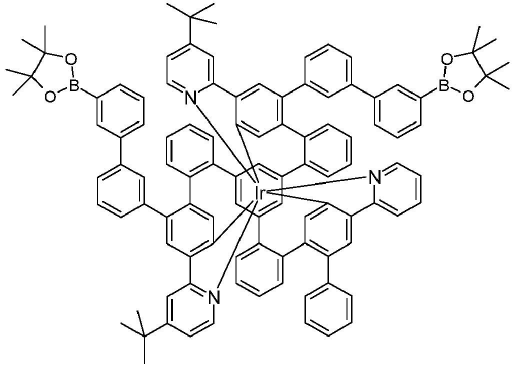 | 87 % |
| | Ir(L201-2Cl) | |
| Ir(L202-BE) | 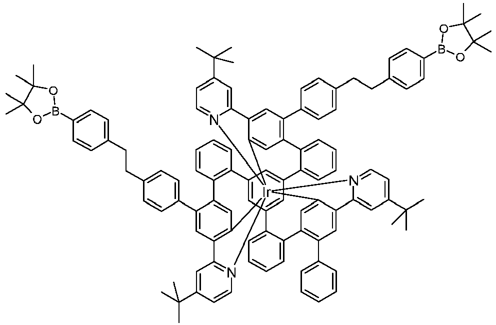 | 89% |
| | Ir(L202-2Cl) | |

| Monoborylierung | | |
|---|---|---|
| Ir(L250-1BE) | 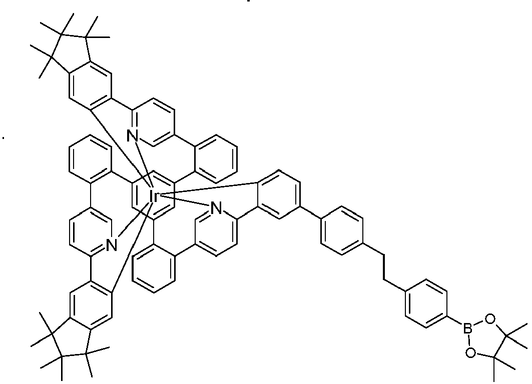 | 83 % |
| | Ir(L250-1Cl) | |
| Ir(L251-1BE) | 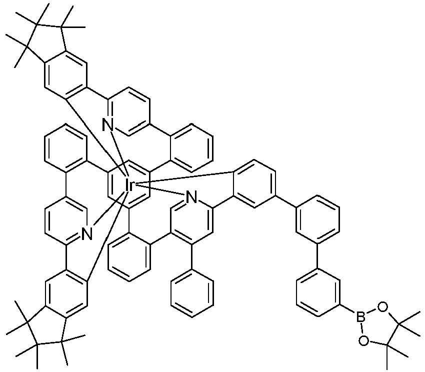 | 80 % |
| | Ir(L251-1Cl) | |
| Ir(L252-1BE) | 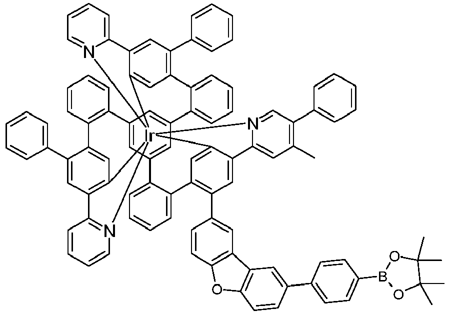 | 85% |
| | Ir(L252-1Cl) | |
| Ir(L253-1BE) | 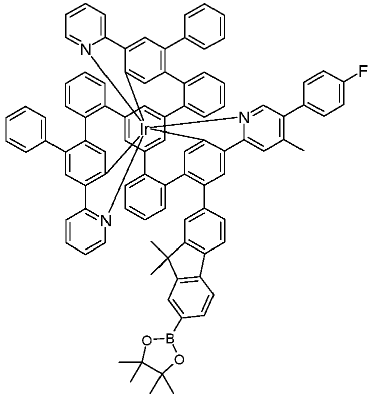 | 84% |
| | Ir(L253-1Cl) | |
| Ir(L254-1BE) | 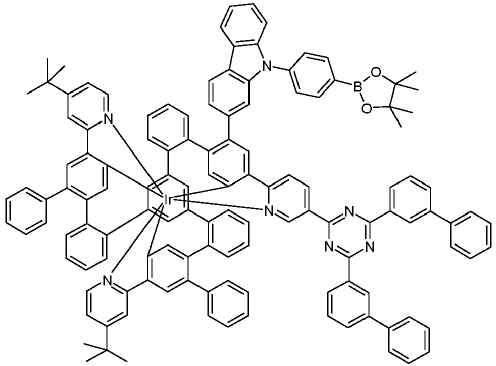 | 81 % |
| | Ir(L254-1Cl) | |

### 3. Darstellung der erfindungsgemäßen Metallkomplexe:

### Formale Benennung der Produkte:

In den nachfolgenden Beispielen werden die erfindungsgemäßen Metallkomplexe fortlaufend nummeriert. Zusätzlich wird jeder Komplex durch eine Formel beschrieben, die sich aus den in der Reaktion eingesetzen Bausteinen, im entsprechenden molaren Verhältnis, ergibt. Die Lage der Verknüpfung und damit die Konstitiution wird durch die Position reaktiven Gruppen vorgegeben.

Namensgebung an einem allg. Beispiel der Kupplungsreaktion: 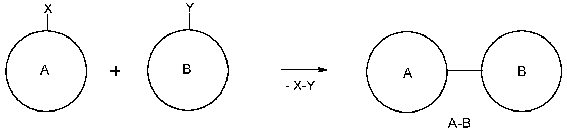 oder

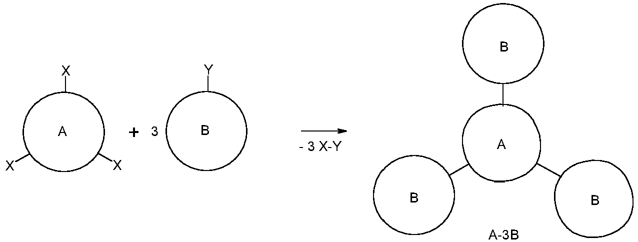

### Stereochemie:

Üblicherweise werden die einkernigen Komplex-Synthesebausteine als Racemat der Δ- und Λ-Isomeren eingesetzt. Dies führt in den mehrkernigen erfindungsgemäßen Verbindungen zu Diastereomerengemischen, z. B. für zweikernige Verbindungen zu Δ,Δ-/Λ,Λ- und (meso)Δ,Λ-Formen. Diese werden, sofern nicht anderes vermerkt, als Diastereomerengemisch weiter um- bzw. eingesetzt. Daneben besteht die Möglichkeit, diese durch chomatographische Methoden oder durch fraktionierte Kristallisation zu trennen.

### 3.1 Durch Suzuki-Kupplung aus bromierten Metallkomplexen und Boronestern

### Variante A: Suzuki-Kupplung im zweiphasigem, wässrig-organischen Medium

Die molaren Verhältnisse von bromierten Komplexen und Boronsäuren können der nachfolgenden Tabelle entnommen werden. Ein Gemisch der/des bromierten Metallkomplexe/s und der Boronester, 3 Äquivalenten Trikaliumphosphat [7778-53-2] pro Bromfunktion, 300 ml Toluol, 100 ml Dioxan und 100 ml Wasser wird mit 0.06 Äquivalenten Tri-o-tolylphosphin [6163-58-2] und 0.01 Äquivalenten Palladium(II)acetat [3975-31-3] pro Bromfunktion versetzt und 18 h unter Rückfluss gut gerührt. Nach Erkalten saugt man vom ausgefallenen Feststoff ab. Fällt kein Festsoff aus, trennt man die organische Phase ab, wäscht diese zweimal mit je 300 ml Wasser und einmal mit 300 ml gesättigter Kochsalzlösung, trocknet über Magnesiumsulfat, filtriert vom Magnesiumsulfat ab und engt das Filtrat zur Tockene ein. Das so erhaltene Rohprodukt wird chromatographisch oder Flash-chromatographisch (CombiFlash Torrent der Fa. Axel Semrau) gereinigt. Die weitere Reinigung erfolgt durch wiederholte kontinuierliche Heißextraktion, wobei das Produkt in einem Heißextraktor in einer Cellulosehülse (Fa. Whatman) vorgelegt und mit einem geeigneten Heißextraktionsmittel, z. B. Toluol, Chlorbenzol, Anisol, Ethylacetat, Butylacetat, Acetonitril, Dichlormethan, etc. (Vorlagemenge ca. 150-200 ml) wiederholt (typischerweise 3-6 mal) heißextrahiert wird, bis eine Reinheit > 99.5 %, bevorzugt > 99.9 % erreicht wird.

### Variante B: Suzuki-Kupplung im einphasigen dipolar-aprotischen Medium

Die molaren Verhältnisse von bromierten Komplexen und Boronsäuren können der nachfolgenden Tabelle entnommen werden. Ein Gemisch der/des bromierten Metallkomplexe/s und der Boronester, 3 Äquivalenten Trikaliumphosphat-Trihydrat [22763-03-7] pro Bromfunktion und 200 ml DMSO wird mit 0.01 Äquivalenten Tetrakis(triphenyl-phosphino)-palladium(0) [14221-01-3] pro Bromfunktion und 50 g Glaskugeln (Durchmesser 3 mm) versetzt und 18 h bei 80 °C gut gerührt. Nach Erkalten entfernt man das DMSO weitgehend im Vakuum, nimmt den Rückstand in 1000 ml Dichlormethan auf, filtriert über ein mit Dichlormethan vorgeschlämmtes Kieselgelbett ab, wäscht dieses mit 500 ml Dichlormethan nach und engt dann die organische Phase im Vakuum zur Trockene ein. Die weitere Reinigung des so erhaltenen Rohprodukts erfolgt wie unter A beschrieben.

### Variante C: Kupplung von Komplexen mit Chlorfunktion

Durchführung wie Variante 2, jedoch wird als Katalysatorsystem 0.026 Äquivalente SPhos [657408-07-6] und 0.02 Äquivalente Palladium-(II)acetat pro Chlorfunktion verwendet.

### Beispiel Ir100: Ir100 = Ir(L1)-Ir(L1)

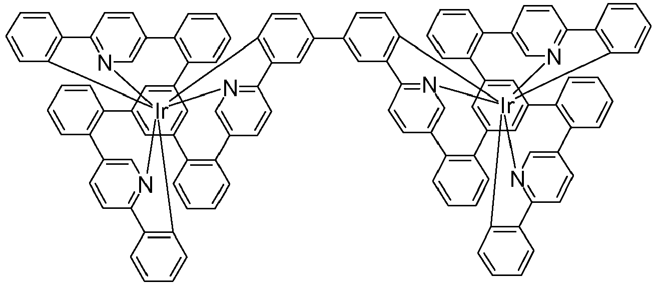

Durchführung nach Variante B. Einsatz von 10.34 g (10.0 mmol) Ir(L1-1Br), 10.81 g (10 mmol) Ir(L1-1BE), 8.0 g (30 mmol) Trikaliumphosphat-Trihydrat, 116 mg (0.1 mmol) Tetrakis(triphenylphosphino)-palladium(0). Heißextraktion: 5 x aus Chlorbenzol. Ausbeute: 7.44 g (3.9 mmol), 39 %. Reinheit: > 99.8 % n. HPLC.

Analog können folgende Verbindungen dargestellt werden:

| Bsp. | Produkt Edukte Variante / Heißextraktionsmittel* | Ausbeute |
|---|---|---|
| Bimetallische Komplexe | | |
| Ir101 | 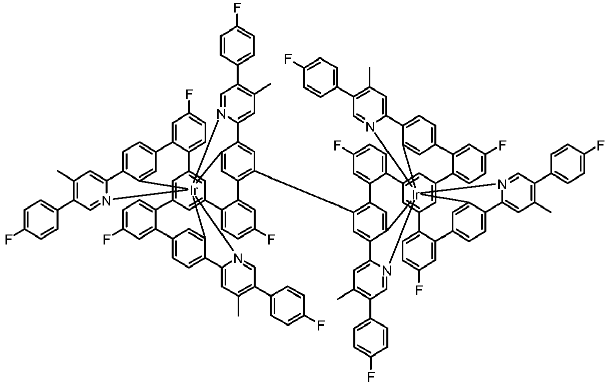 | 30 % |
| | Ir101 = Ir(L5)-Ir(L5) | |
| | 5 mmol Ir(L5-1Br) + 5 mmol Ir(L5-1BE) | |
| | A / Toluol | |
| Ir102 | Ir102 = Ir(L101)-Ir(L101) | 34 % |
| | 5 mmol Ir(L101-1Br) + 5 mmol Ir(L101-1BE) | |
| | A / Toluol | |
| Ir103 | 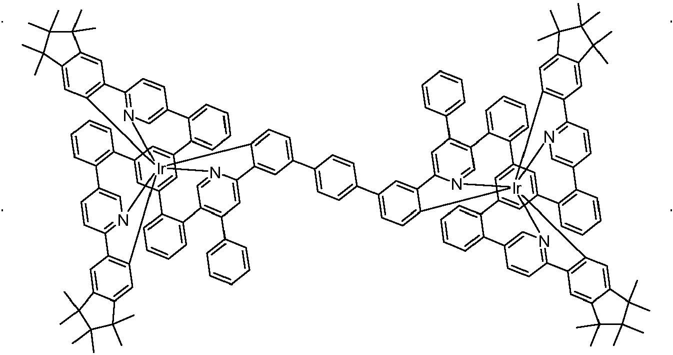 | 51 % |
| | Ir103 = LS1-2Ir(L102) | |
| | 5 mmol LS1 + 10 mmol Ir(L102-1Br) | |
| | A / Toluol | |
| Ir104 | Ir104 = LS7-2Ir(L102) | 57 % |
| | 5 mmol LS7 + 10 mmol Ir(L102-1Br) | |
| | A / Toluol | |
| Ir105 | Ir105 = LS8-2Ir(L102) | 54 % |
| | 5 mmol LS8 + 10 mmol Ir(L102-1Br) | |
| | A / Toluol | |
| Ir106 | 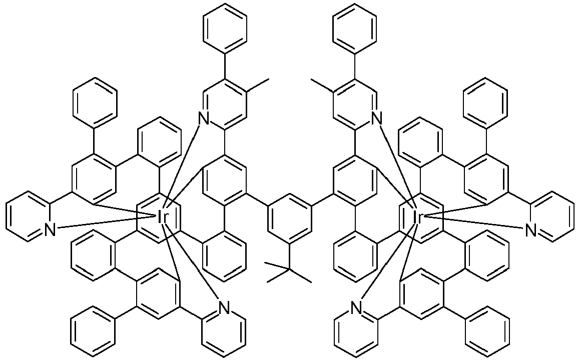 | 33 % |
| | Ir106 = LS5-2Ir(L109) | |
| | 5 mmol LS5 + 10 mmol Ir(L109-1Br) | |
| | A / Toluol | |
| Ir107 | Ir107 = LS10-2Ir(L112) | 37 % |
| | 5 mmol LS10 + 10 mmol Ir(L112-1Br) | |
| | A / Toluol | |
| Ir108 | Ir108 = LS15-2Ir(L112) | 56 % |
| | 5 mmol LS15 + 10 mmol Ir(L112-1Br) | |
| | A / Toluol | |
| Ir109 | Ir109 = LS17-2Ir(L3) | 41 % |
| | 5 mmol LS17 + 10 mmol Ir(L3-1Br) | |
| | A / Toluol | |
| Ir110 | Ir110 = LS20-2Ir(L4) | 39 % |
| | 5 mmol LS20 + 10 mmol Ir(L4-1Br) | |
| | A / Toluol | |
| Ir111 | Ir111 = LS3-2Ir(L100) | 27 % |
| | 5 mmol LS3 + 10 mmol Ir(L100-1Br) | |
| | A / Toluol | |
| Ir112 | Ir112 = LS13-2Ir(L110) | 55 % |
| | 5 mmol LS13 + 10 mmol Ir(L110-1Br) | |
| | A / Toluol | |
| Ir113 | Ir113 = LS19-2Ir(L112) | 49 % |
| | 5 mmol LS19 + 10 mmol Ir(L112-1Br) | |
| | A / Toluol | |
| Ir114 | 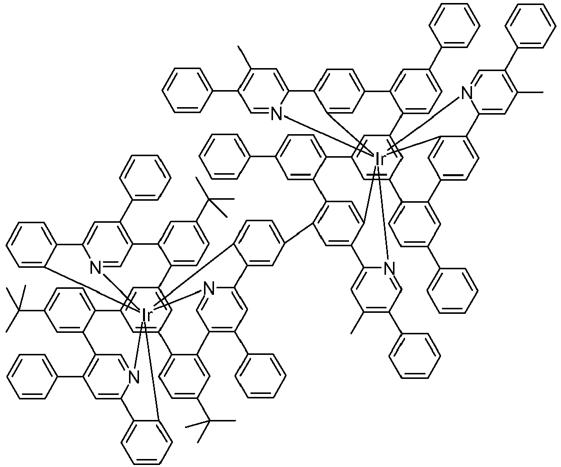 | 26 % |
| | Ir114 = Ir(L3)-Ir(L4) | |
| | 5 mmol Ir(L3-1 Br) + 5 mmol Ir(L4-1 BE) | |
| | A / Toluol | |
| Ir115 | Ir115 = Ir(L3)-Ir(L112) | 32 % |
| | 5 mmol Ir(L3-1 Br) + 5 mmol Ir(L112-1BE) | |
| | A / Toluol | |
| Ir116 | Ir116 = Ir(L109)-Ir(L250) | 53 % |
| | 5 mmol Ir(L109-1Br) + 5 mmol Ir(L250-1BE) | |
| | A / Toluol | |
| Ir117 | Ir117 = Ir(L252)-Ir(L254) | 48 % |
| | 5 mmol Ir(L252-1 Cl) + 5 mmol Ir(L254-1BE) | |
| | C / Butylacetat | |
| Ir118 | Ir118 = Ir(L254)-Ir(L254) | 45 % |
| | 5 mmol Ir(L254-1Cl) + 5 mmol Ir(L254-1BE) | |
| | C / o-Xylol | |

| | Trimetallische Komplexe | |
|---|---|---|
| Ir200 | 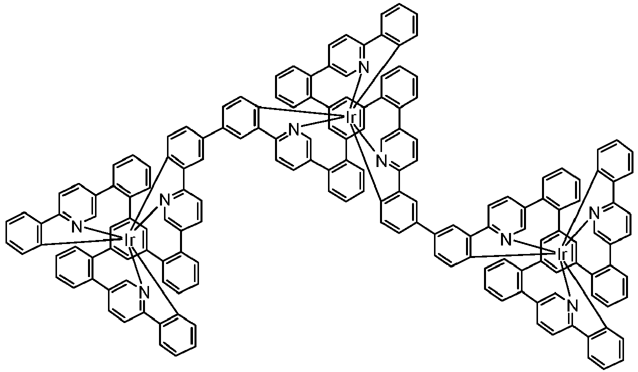 | 27 % |
| | Ir200 = Ir(L1)-2Ir(L1) | |
| | 4 mmol Ir(L1 -2Br) + 8 mmol Ir(L1 -1BE) | |
| | B / Chlorbenzol | |
| Ir201 | Ir201 = Ir(L111)-2Ir(L112) | 23 % |
| | 4 mmol Ir(L111-2Br) + 8 mmol Ir(L112-1BE) | |
| | A / o-Xylol | |
| Ir202 | Ir202 = Ir(L111)-2Ir(L102) | 33 % |
| | 4 mmol Ir(L111-2Br) + 8 mmol Ir(L102-1BE) | |
| | A / Toluol | |
| Ir203 | Ir203 = Ir(L104)-2Ir(L112) | 31 % |
| | 4 mmol Ir(L104-2Br) + 8 mmol Ir(L112-1BE) | |
| | A / Toluol | |
| Ir204 | Ir204 = Ir(L201)-2Ir(L253) | 29 % |
| | 4 mmol Ir(L201-2CI) + 8 mmol Ir(L253-1BE) | |
| | C / Toluol | |
| Ir205 | Ir205 = LS24-3Ir(L110) | 36 % |
| | 3 mmol LS24 + 9 mmol Ir(L110-1Br) | |
| | A / Toluol | |
| Ir206 | Ir206 = LS23-3Ir(L251) | 27 % |
| | 3 mmol LS23 + 9 mmol Ir(L251-1CI) | |
| | C / Toluol | |
| Ir207 | Ir207 = LS25-3Ir(L250) | 25 % |
| | 3 mmol LS25 + 9 mmol Ir(L250-1CI) | |
| | C / Toluol | |
| Ir208 | Ir208 = LS26-3Ir(L101) | 37 % |
| | 3 mmol LS26 + 9 mmol Ir(L101-1Br) | |
| | A / Toluol | |
| Ir209 | Ir209 = LS27-3Ir(L254) | 30 % |
| | 3 mmol LS27 + 9 mmol Ir(L254-1Cl) | |
| | C / Toluol | |
| Ir210 | Ir210 = LS28-3Ir(L110) | 34 % |
| | 3 mmol LS28 + 9 mmol Ir(L110-1Br) | |
| | A / Toluol | |
| Ir211 | Ir211 = LS29-3Ir(L253) | 29 % |
| | 3 mmol LS29 + 9 mmol Ir(L253-1CI) | |
| | C / Toluol | |
| Ir212 | Ir212 = Ir(L111)-2Ir(L252) | 31 % |
| | 3 mmol Ir(L111-2Br) + 6 mmol Ir(L252-1BE) | |
| | A / Toluol | |

| Tetrametallische Komplexe | | |
|---|---|---|
| Ir300 | 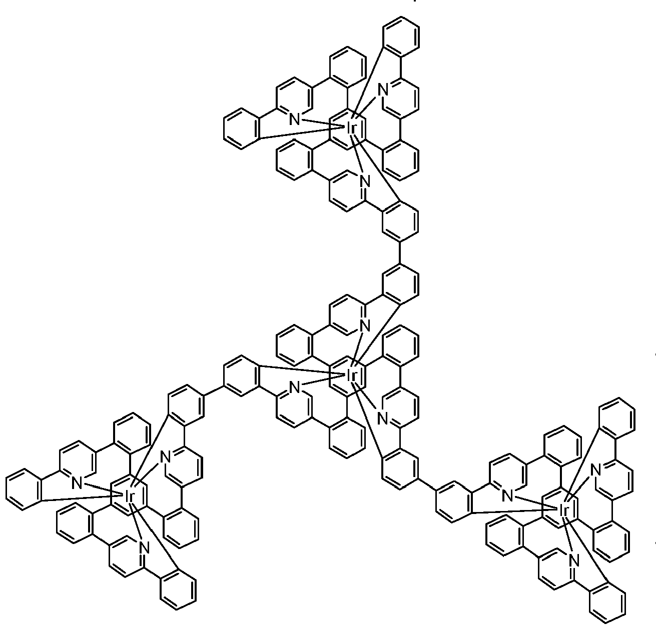 | 19 % |
| | Ir300 = Ir(L1)-3Ir(L1) | |
| | 2 mmol Ir(L1 -3Br) + 6 mmol Ir(L1 -1BE) | |
| | B / Chlorbenzol | |
| Ir301 | Ir301 = LS30-4Ir(L102) | 21 % |
| | 2 mmol LS30 + 8 mmol Ir(L102-1Br) | |
| | A / Toluol | |
| Ir302 | Ir302 = LS30-4Ir(L109) | 26 % |
| | 2 mmol LS30 + 8 mmol Ir(L109-1Br) | |
| | A / Toluol | |
| Ir303 | Ir303 = LS31-4Ir(L251) | 22 % |
| | 2 mmol LS31 + 8 mmol Ir(251-1CI) | |
| | C / o-Xylol | |
| Ir304 | Ir304 = LS31-4Ir(L254) | 18 % |
| | 2 mmol LS31 + 8 mmol Ir(254-1CI) | |
| | C / o-Xylol | |

| | | |
|---|---|---|
| *: sofern abweichend von Beispiel Ir100 | | |

### 5) Oligomere und polymere Metallkomplexe

### Allgemeine Polymerisationsvorschrift für die Bromide bzw. Boronsäure-Derivate als polymerisierbare Gruppe, Suzuki-Polymerisation Variante A: Zweiphasiges Reaktionsgemisch

Die Durchführung erfolgt in Anlehnung an WO 2002/077060 und WO 2003/048225 unter inerten Bedingungen mit sorgfältig entgasten Lösungsmitteln. Die Monomere (Bromide und Boronsäuren bzw. Boronsäureester, Reinheit nach HPLC > 99.8 %ig) werden in der in der Tabelle angegebenen Zusammensetzung in einer Gesamtkonzentration von ca. 100 mmol/L in einem Gemisch aus 3 Volumenteilen Toluol: 6 Volumenteilen Dioxan : 2 Volumenteil Wasser umgesetzt. Dabei wird das Monomer M1 und das Monomer M3 stets vollständig vorgelegt. Dann gibt man 2 mol Äquivalente Trikaliumphosphat pro insgesamt eingesetzter Br-Funktionalität zu, rührt 5 min. nach, fügt 0.06 mol Äquivalente Tri-ortho-tolylphosphin und dann 0.01 mol Äquivalente Palladium(II)-acetat pro eingesetzter Br-Funktionalität zu und erhitzt unter sehr gutem Rühren unter Rückfluss. Nach 1 h fügt man die restlichen Monomere gemäß Tabelle auf einmal zu und erhitzt für weitere 4 h unter Rückfluss. Falls die Viskosität der Mischung zu stark ansteigt, kann mit einem Gemisch aus 2 Volumenteilen Toluol: 3 Volumenteilen Dioxan verdünnt werden. Nach insgesamt 4-6 h Reaktionszeit fügt man zum End-capping 0.05 mol Aquivalente pro eingesetzter Boronsäure-Funktionalität eines Monobromaromaten, hier 3-Brombiphenyl [2113-57-7], und dann 30 min. danach 0.05 mol Äquivalente pro eingesetzter Br-Funktionalität einer Monoboronsäure bzw. eines Monoboronsäureesters, hier Biphenyl-3-pinacolboronester [912844-88-3], zu und kocht weitere 1 h nach. Nach Erkalten verdünnt man mit 500 ml Toluol, trennt die wässrige Phase ab und wäscht die organische Phase zweimal mit je 300 ml Wasser. Man rührt die organische Phase 16 h bei 80 °C mit 300 ml einer wässrigen 5 Gew.-%igen N-Acetylcystein-Lösung, trennt die organische Phase ab, trocknet über Magnesiumsulfat, filtriert über ein Celite-Bett ab und engt dann zur Trockene ein. Man löst das Rohpolymer in THF (Konzentration ca. 10 - 30 g/L) und lässt die Lösung unter sehr gutem Rühren langsam in das doppelte Volumen Methanol einlaufen. Das Polymer wird abgesaugt und dreimal mit Methanol gewaschen und getrocknet. Der Umfällvorgang wird fünfmal wiederholt, danach wird das Polymer im Vakuum bis zur Gewichtskonstanz bei 30 - 50 °C getrocknet.

### Variante B - Einphasiges Reaktionsgemisch

Die Monomere (Bromide und Boronsäuren bzw. Boronsäureester, Reinheit nach HPLC > 99.8 %ig) werden in der in der Tabelle angegebenen Zusammensetzung in einer Gesamtkonzentration von ca. 100 mmol/L in einem Lösemittel (THF, Dioxan, Xylol, Mesitylen, Dimethylacetamid, NMP, DMSO, etc.) gelöst bzw. suspendiert. Dann gibt man 3 mol Äquivalente Base (Kaliumfluorid, Trikaliumphosphat (wasserfrei, Monohydrat oder Trihydrat), Kaliumcarbonat, Cäsiumcarbonat, etc., jeweils wasserfrei) pro Br-Funktionalität und das Gewichtsäquivalent Glaskugeln (3 mm Durchmesser) zu, rührt 5 min. nach, fügt 0.03 bis 0.003 mol Äquivalente Tri-ortho-tolylphosphin und dann 0.005 bis 0.0005 mol Äquivalente Palladium(II)acetat (Verhältnis Phosphin zu Pd bevorzugt 6:1) pro Br-Funktionalität zu und erhitzt unter sehr gutem Rühren 2-3 h auf 80 °C bis unter Rückfluss. Alternativ können andere Phosphine wir Tri-tert-butylphosphin, SPhos, XPhos, RuPhos, XanthPhos, etc. eingesetzt werden, wobei bei diesen Phosphinen das bevorzugte Phosphin : Palladium Verhältnis 2:1 bis 1.3:1 beträgt. Nach insgesamt 4-12 h Reaktionszeit fügt man zum End-capping 0.05 mol Äquivalente eines Monobromaromaten (siehe oben) und dann nach 30 min. 0.05 mol Äquivalente einer Monoboronsäure bzw. eines Monoboronsäureesters (siehe oben) zu und kocht 1 h weiter. Man entfernt das Lösungsmittel weitgehend im Vakuum, nimmt den Rückstand in Toluol auf und reinigt das Polymer wie unter Variante A beschrieben.

Oliogomer / Polymer P und deren Zusammensetzung aus den Monomeren M1 bis M5. Angaben in mmol:

| Bsp. | M1 | M2 | M3 | M4 | Aus- |
|---|---|---|---|---|---|
| | | | | | beute |
| IrP1 | Ir(L3-1 Br) | LS101 | LS7 | --- | 84% |
| | 2 mmol | 10 mmol | 11 mmol | | |
| IrP2 | Ir(L102-1Br) | LS106 | LS8 | --- | 88 % |
| | 2 mmol | 10 mmol | 11 mmol | | |
| IrP3 | Ir(L109-1Br) | LS107 | LS15 | LS110 | 91 % |
| | 2 mmol | 8 mmol | 11 mmol | 2 mmol | |
| IrP4 | Ir(L112-1Br) | LS106 | LS19 | --- | 90 % |
| | 2 mmol | 20 mmol | 21 mmol | | |
| IrP5 | Ir(L112-1Br) | LS113 | LS22 | --- | 83 % |
| | 2 mmol | 20 mmol | 21 mmol | | |
| IrP6 | Ir(L250-1BE) | LS3 | LS101 | --- | 85 % |
| | 2 mmol | 10 mmol | 11 mmol | | |
| IrP7 | Ir(L250-1BE) | LS7 | LS102 | Ir(L102-1Br) | 87% |
| | 2 mmol | 10 mmol | 10 mmol | 2 mmol | |
| IrP8 | Ir(254-1BE) | LS21 | LS107 | Ir(L100-2Br) | 81 % |
| | 2 mmol | 6 mmol | 4 mmol | 3 mmol | |

### Beispiel: Herstellung der OLED-Devices

### A: Lösungs-prozessierte Devices aus niedermolekularen löslichen Funktionsmaterialien

Die erfindungsgemäßen Iridium-Komplexe können aus Lösung verarbeitet werden und führen dort zu OLEDs mit sehr guten Eigenschaften. Die Herstellung solcher Bauteile lehnt sich an die Herstellung polymerer Leuchtdioden (PLEDs) an, die in der Literatur bereits vielfach beschrieben ist (z. B. in der WO 2004/037887). Der Aufbau setzt sich aus Substrat / ITO / Lochinjektionsschicht (60 nm) / Interlayer (20 nm) / Emissionsschicht (60 nm) / Lochblockierschicht (10 nm) / Elektronentransportschicht (40 nm) / Kathode zusammen. Dazu werden Substrate der Firma Technoprint (Sodalimeglas) verwendet, auf weiche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 20 nm Lochinjektionsschicht durch Spin-Coating aufgebracht. Die benötigte Spinrate hängt vom Verdünnungsgrad und der spezifischen Spin-Coater-Geometrie ab. Um Restwasser aus der Schicht zu entfernen, werden die Substrate für 30 Minuten bei 200 °C auf einer Heizplatte ausgeheizt. Die verwendete Interlayer dient dem Lochtransport, in diesem Fall wird HLX von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Triplettemitter zusammen mit den Matrixmaterialien in Toluol oder Chlorbenzol gelöst. Der typische Feststoffgehalt solcher Lösungen liegt zwischen 16-25 g/L für Devices vom Typ 1 und 2, wenn eine Device typische Schichtdicke von ca. 60 nm und 10-15 g/L für Devices vom Typ 3 wenn eine Device typische Schichtdicke von ca. 40 nm mittels Spincoating erzielt werden soll. Die lösungsprozessierten Devices vom Typ1 enthalten eine Emissionsschicht aus M1:M2:IrL (20%:60%:20%), die vom Typ2 enthalten eine Emissionsschicht aus M1:M2:IrLa:IrLb (30%:35%:30%:5%), d.h. sie enthalten zwei verschiedene Ir-Komplexe, die vom Typ 3 enthalten eine Emissionsschicht aus M1:IrL (40:60%). Die Emissionsschicht wird in einer Inertgasatmosphäre, im vorliegenden Fall Argon, aufgeschleudert und 10 min bei 160 °C ausgeheizt. Darüber wird die Lochblockierschicht (10 nm ETM1) und die Elektronentransportschicht (40 nm ETM1 (50%) / ETM2 (50%)) aufgedampft (Aufdampfanlagen von Lesker o.a., typischer Aufdampfdruck 5 x 10⁻⁶ mbar). Zuletzt wird eine Kathode aus Aluminium (100 nm) (hochreines Metall von Aldrich) aufgedampft. Um das Device vor Luft und Luftfeuchtigkeit zu schützen, wird die Vorrichtung abschließend verkapselt und dann charakterisiert. Die genannten OLED-Beispiele sind noch nicht optimiert. Tabelle 1 fasst die erhaltenen Daten zusammen.

**Tabelle 1: Ergebnisse mit aus Lösung prozessierten Materialien**

| **Bsp.** | **Emitter IrLa IrLb Device** | **EQE (%) 1000 cd/m²** | **Spannung (V) 1000 cd/m²** | **CIE x/y** | **LD50 (h) 1000 cd/m²** |
|---|---|---|---|---|---|
| organge - rote Devices | | | | | |
| Sol-Ref-Red1 | IrRef1 | 17.3 | 6.4 | 0.61/0.39 | 240000 |
| | IrRef2 | | | | |
| | Typ2 | | | | |
| Sol-RedD1 | IrRef1 | 19.7 | 6.0 | 0.64/0.36 | 300000 |
| | Ir107 | | | | |
| | Typ2 | | | | |
| Sol-RedD2 | IrRef1 | 20.0 | 5.7 | 0.64/0.36 | 320000 |
| | Ir108 | | | | |
| | Typ2 | | | | |
| Sol-RedD3 | Ir103 | 20.3 | 5.9 | 0.63/0.37 | 380000 |
| | Ir108 | | | | |
| | Typ2 | | | | |
| Sol-RedD4 | Ir103 | 20.2 | 5.7 | 0.64/0.35 | 350000 |
| | Ir118 | | | | |
| | Typ2 | | | | |
| Sol-RedD5 | Ir212 | 20.1 | 5.6 | 0.65/0.35 | 390000 |
| | Typ1 | | | | |
| Sol-RedD5 | IrP4 | 19.2 | 6.2 | 0.63/0.37 | 200000 |
| | Typ3 | | | | |

| grüne - gelbe Devices | | | | | |
|---|---|---|---|---|---|
| Sol-Ref-Green1 | IrRef1 | 19.7 | 4.8 | 0.34/0.62 | 200000 |
| | Typ1 | | | | |
| Sol-GreenD1 | Ir101 | 20.7 | 4.9 | 0.35/0.62 | 260000 |
| | Typ1 | | | | |
| Sol-GreenD2 | Ir103 | 21.4 | 4.7 | 0.42/0.57 | 330000 |
| | Typ1 | | | | |
| Sol-GreenD3 | Ir106 | 21.2 | 4.8 | 0.35/0.63 | 270000 |
| | Typ1 | | | | |
| Sol-GreenD4 | Ir116 | 22.0 | 4.8 | 0.36/0.60 | 300000 |
| | Typ1 | | | | |
| Sol-GreenD5 | Ir204 | 21.7 | 4.7 | 0.35/0.62 | 290000 |
| | Typ1 | | | | |
| Sol-GreenD6 | Ir210 | 21.5 | 4.5 | 0.36/0.61 | 330000 |
| | Typ1 | | | | |
| Sol-GreenD7 | Ir303 | 21.8 | 4.7 | 0.42/0.57 | 340000 |
| | Typ1 | | | | |
| Sol-GreenD8 | IrP3 | 19.8 | 4.9 | 0.36/0.61 | 210000 |
| | Typ1 | | | | |

Unter Einsatz der Emitter Ir113, Ir201, Ir202, Ir203, Ir209, Ir304 und IrP8 können analog zu den oben beschriebenen Beispielen orange bis rot emittierende Devices erhalten werden, die vergleichbare Leistungsdaten bezüglich EQE, Spannung, CIE und LD50 aufweisen, wie die in Tabelle 1 aufgeführten.

Unter Einsatz der Emitter Ir100, Ir102, Ir104, Ir105, Ir109, Ir110, Ir111, Ir112, Ir114, Ir200, Ir205, Ir206, Ir207, Ir208, Ir300, Ir301, Ir302, IrP1, IrP2, IrP5, IrP6 und IrP7 können analog zu den oben beschriebenen Beispielen grün bis gelb emittierende Devices erhalten werden, die vergleichbare Leistungsdaten bezüglich EQE, Spannung, CIE und LD50 aufweisen, wie die in Tabelle 1 aufgeführten.

**Tabelle 2: Strukturformeln der verwendeten Materialien**

| | |
|---|---|
| 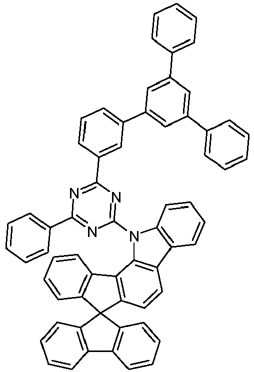 M1 1616231-60-7 | 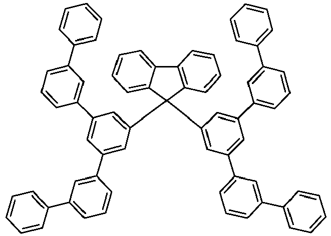 M2 1246496-85-4 |
| 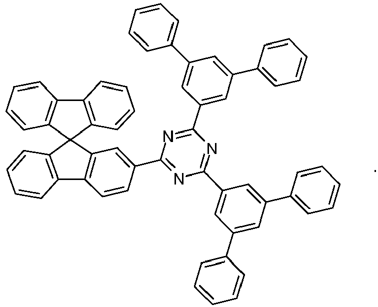 ETM1 1233200-52-6 | 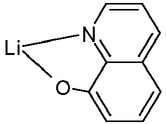 ETM2 25387-93-3 |
| 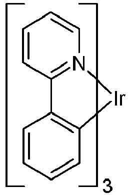 IrPPy 693794-98-8 | 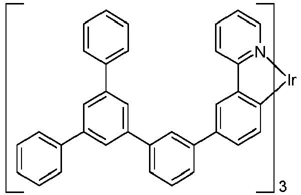 IrRef1 1269508-30-6 |
| 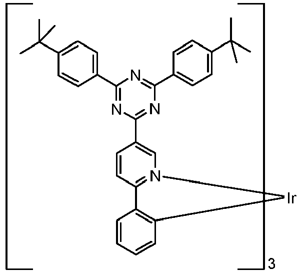 IrRef2 1202823-72-0 | |

## Patentansprüche

1. Verbindung gemäß Formel (1), 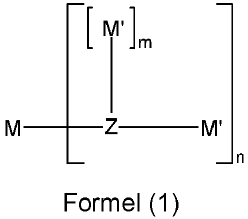 wobei für die verwendeten Symbole und Indizes gilt:
M ist ein Iridiumkomplex der folgenden Struktur 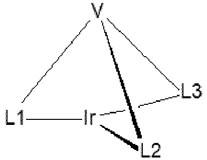
enthaltend einen hexadentaten tripodalen Liganden, in dem drei bidentate Teilliganden L1, L2 und L3 an ein Iridiumatom koordinieren und die drei bidentaten Teilliganden, die gleich oder verschieden sein können, über eine Brücke V der folgenden Formel (5a")verknüpft sind: 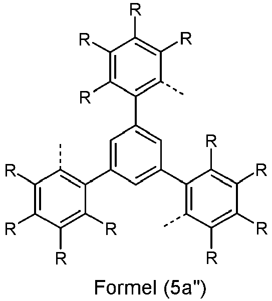
wobei die gestrichelte Bindung die Bindung der bidentaten Teilliganden an diese Struktur darstellt;
und wobei die bidentaten Teilliganden L1, L2 und L3 gleich oder verschieden bei jedem Auftreten ausgewählt sind aus den Strukturen der Formeln (L-1-1), (L-1-2), (L-2-1), (L-2-2), (L-2-3) oder (L-4) bis (L-31), 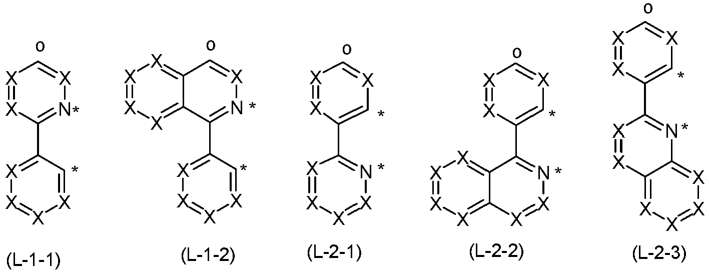 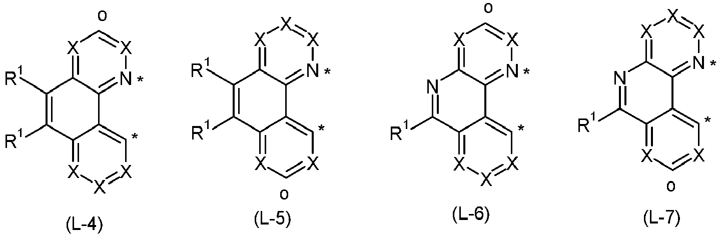 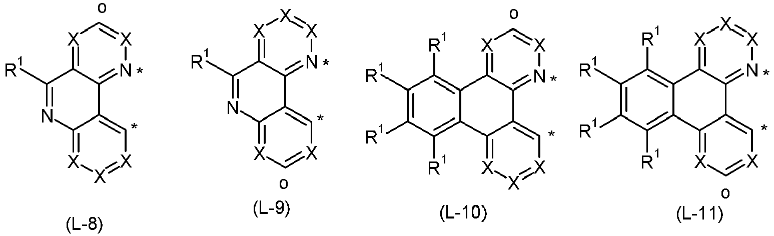 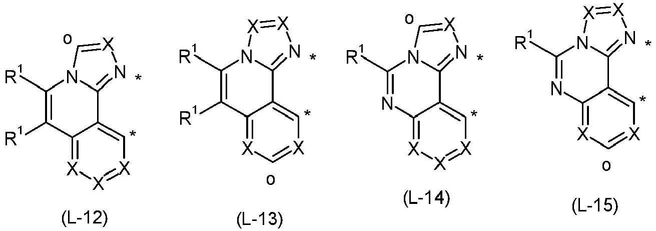 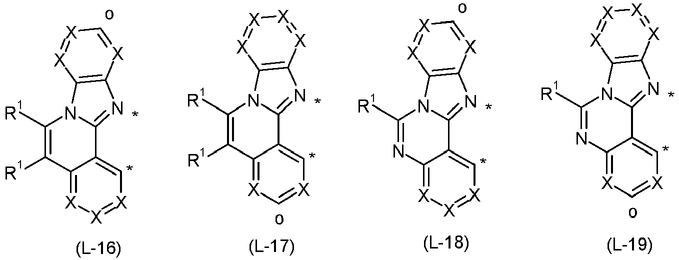 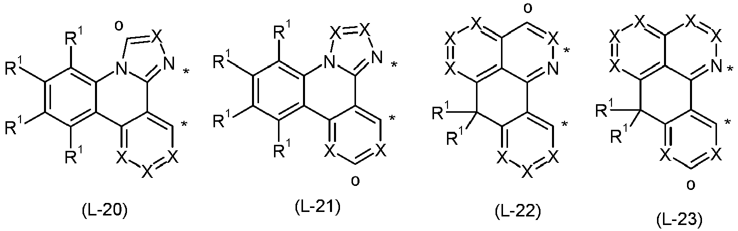 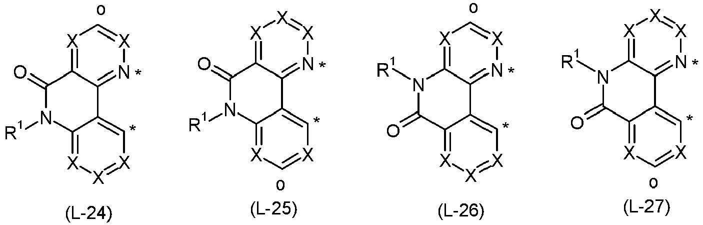 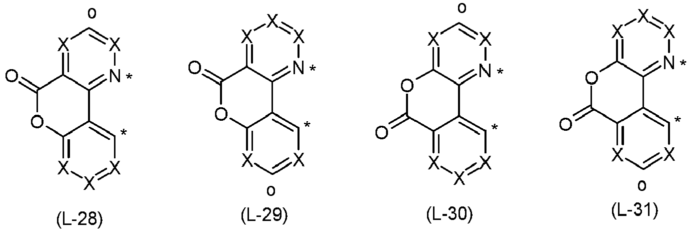
wobei X bei jedem Auftreten gleich oder verschieden CR oder N ist mit der Maßgabe, dass maximal zwei Symbole X pro Cyclus für N stehen, und wobei * die Position der Koordination an das Iridium andeutet und "o" die Position der Bindung an die Brücke der Formel (5a") andeutet, mit der Maßgabe, dass, wenn Z an den Teilliganden gebunden ist, ein Symbol X für C steht und Z an dieses Kohlenstoffatom gebunden ist;
M' ist bei jedem Auftreten gleich oder verschieden M oder ein Iridiumkomplex, in dem drei bidentate Liganden, die gleich oder verschieden sein können, an ein Iridiumatom koordinieren; dabei sind die bidentaten Liganden ausgewählt aus den oben aufgeführten Strukturen (L-1-1), (L-1-2), (L-2-1), (L-2-2), (L-2-3) oder (L-4) bis (L31), mit dem Unterschied, dass die Liganden nicht an eine Brücke der Formel (5a") gebunden sind;
R ist bei jedem Auftreten gleich oder verschieden H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R¹ substituiert sein kann, wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann, oder eine Aryloxy- oder Heteroaryloxygruppe mit 5 bis 40 aromatischen Ringatomen, die durch einen oder mehrere Reste R¹ substituiert sein kann; dabei können zwei Reste R auch miteinander ein Ringsystem bilden;
R' ist bei jedem Auftreten gleich oder verschieden H, D, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten R¹ substituiert sein kann und wobei eine oder mehrere nicht benachbarte CH₂-Gruppen durch Si(R¹)₂ ersetzt sein können, oder ein aromatisches oder heteroaromatisches Ringsystem mit 5 bis 40 aromatischen Ringatomen, das jeweils durch einen oder mehrere Reste R¹ substituiert sein kann;
R¹ ist bei jedem Auftreten gleich oder verschieden H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R² substituiert sein kann, wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann; dabei können zwei oder mehrere Reste R¹ miteinander ein Ringsystem bilden;
R² ist bei jedem Auftreten gleich oder verschieden H, D, F oder ein aliphatischer, aromatischer und heteroaromatischer organischer Rest, insbesondere ein Kohlenwasserstoffrest, mit 1 bis 20 CAtomen, in dem auch ein oder mehrere H-Atome durch F ersetzt sein können;
Z ist bei jedem Auftreten gleich oder verschieden eine Einfachbindung oder ein Linker, der zwei oder mehrere Komplexe M und M' miteinander kovalent verknüpft, wobei der Linker ausgewählt ist aus der Gruppe bestehend aus einem aromatischen oder heteroaromatischen Ringsystem mit 5 bis 30 aromatischen Ringatomen, das jeweils durch einen oder mehrere Reste R¹ substituiert sein kann, oder einer Gruppe -Ar-[Alkylen-Ar]ₚ- mit p = 1, 2 oder 3, wobei Ar gleich oder verschieden bei jedem Auftreten jeweils für ein aromatisches oder heteroaromatisches Ringsystem mit 5 bis 30 aromatischen Ringatomen steht, welches durch einen oder mehrere Reste R¹ substituiert sein kann, und Alkylen für eine Alkylengruppe mit 1 bis 20 C-Atomen steht;
n ist 1, 2 oder 3;
m ist bei jedem Auftreten gleich oder verschieden 0, 1 oder 2.

2. Verbindung nach Anspruch 1, **dadurch gekennzeichnet, dass** n = 1 oder 2 und m = 0 oder 1 ist.

3. Verbindung nach Anspruch 1 oder 2, **dadurch gekennzeichnet, dass** Z gleich oder verschieden bei jedem Auftreten ausgewählt ist aus einer Einfachbindung oder den Gruppen der Formeln (Z-1) bis (Z-8), 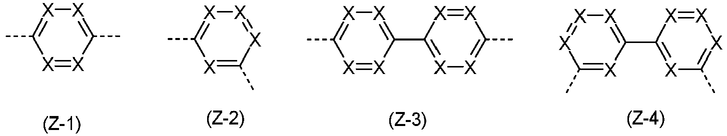 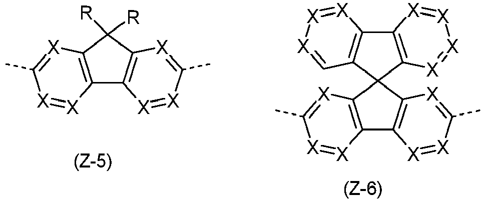 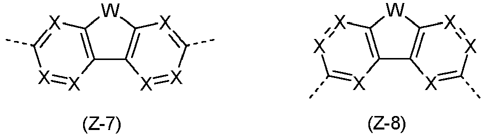 wobei die gestrichelten Bindungen die Verknüpfung dieser Gruppe andeuten, R die in Anspruch 1 genannten Bedeutungen aufweist und weiterhin gilt:
X ist gleich oder verschieden bei jedem Auftreten CR oder N;
W ist gleich oder verschieden bei jedem Auftreten NR, O oder S.

4. Verbindung nach einem oder mehreren der Ansprüche 1 bis 3, **dadurch gekennzeichnet, dass** die drei bidentaten Teilliganden in M entweder gleich gewählt sind oder dass zwei der bidentaten Teilliganden gleich gewählt sind und der dritte bidentate Teilligand unterschiedlich von den ersten beiden bidentaten Teilliganden ist und dass jeder der bidentaten Teilliganden monoanionisch ist.

5. Formulierung, enthaltend mindestens eine Verbindung nach einem oder mehreren der Ansprüche 1 bis 4 und mindestens eine weitere Verbindung, insbesondere mindestens ein Lösemittel.

6. Verwendung einer Verbindung nach einem oder mehreren der Ansprüche 1 bis 5 in einer elektronischen Vorrichtung oder als Sauerstoff-Sensibilisator oder in der Photokatalyse.

7. Elektronische Vorrichtung enthaltend mindestens eine Verbindung nach einem oder mehreren der Ansprüche 1 bis 4, bevorzugt ausgewählt aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen, Sauerstoff-Sensoren oder organischen Laserdioden.

8. Elektronische Vorrichtung nach Anspruch 7, wobei es sich um eine organische Elektrolumineszenzvorrichtung handelt, **dadurch gekennzeichnet, dass** die Verbindung nach einem oder mehreren der Ansprüche 1 bis 4 in einer oder mehreren emittierenden Schichten eingesetzt wird.

## Claims

1. Compound according to formula (1), 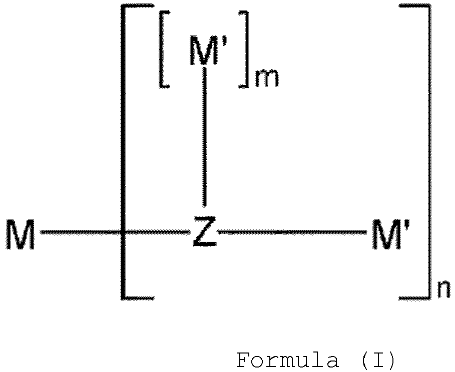 in which the following are valid as regards the symbols and indices used:
M is an iridium complex of the following structure 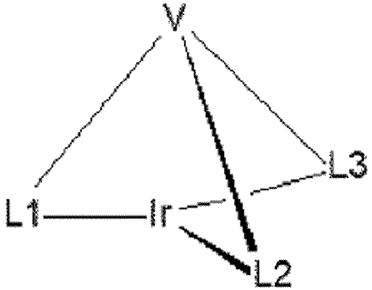
comprising a hexadentate tripodal ligand, in which three bidentate partial ligands L1, L2 and L3 coordinate to an iridium atom and the three bidentate partial ligands, which can be identical or different, are linked via a bridge V of the following formula (5a"): 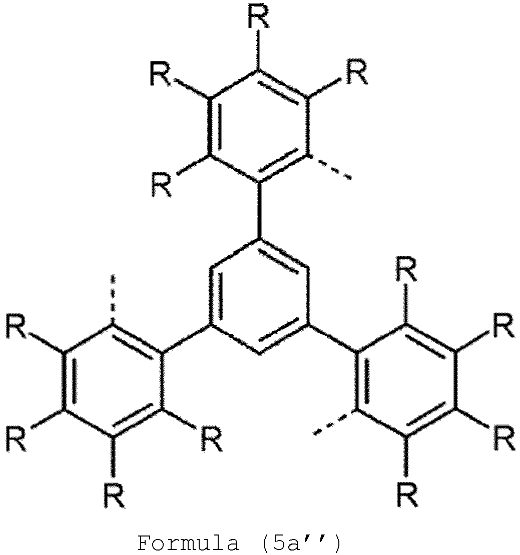
in which the dotted bond is the bond of the bidentate partial ligands to this structure;
and in which the bidentate partial ligands L1, L2 and L3 are chosen identically or differently
at each occurrence from the structures of the formulae (L-1-1), (L-1-2), (L-2-1), (L-2-2), (L-2-3) or (L-4) to (L-31), 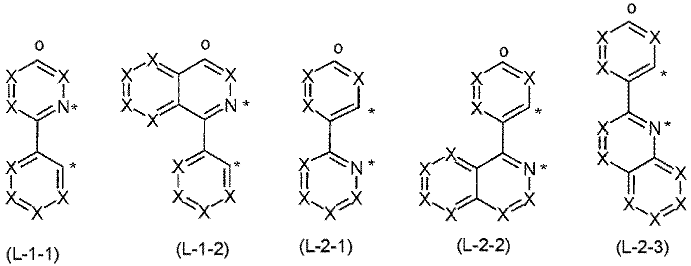 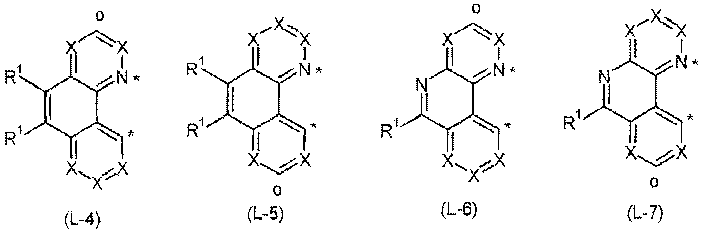 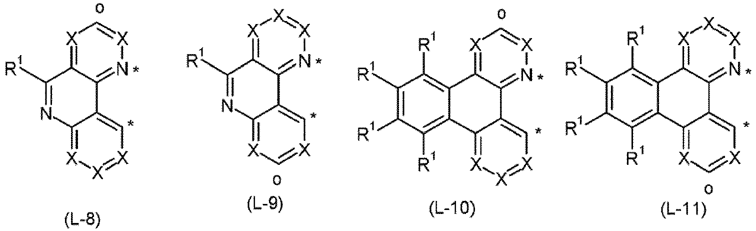 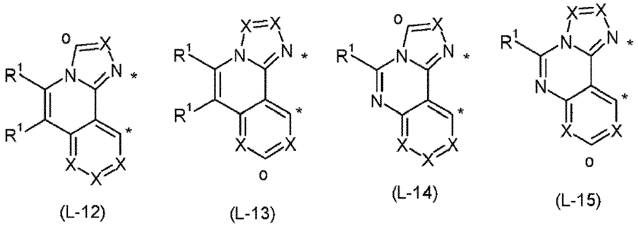 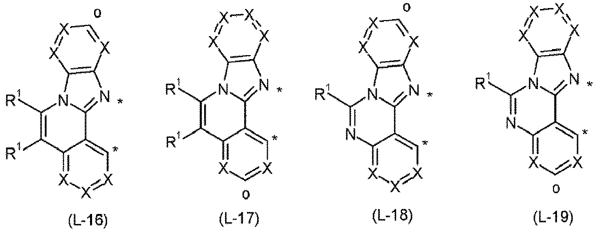 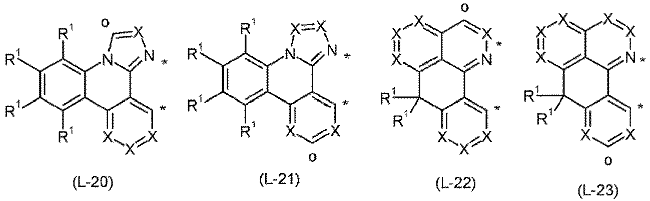 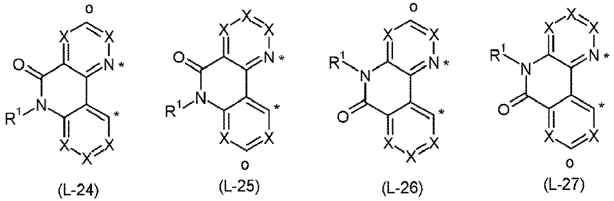 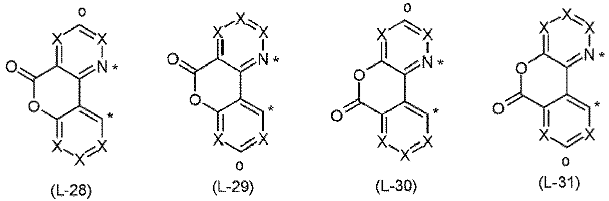
in which X is at each occurrence identially or differently CR or N, with the proviso that a maximum of two symbols X per ring are N, and in which * is the position of the coordination to the iridium and "o" is the position of the bond to the bridge of the formula (5a"), with the proviso that, if Z is bonded to the partial ligands, a symbol X is C and Z is bonded to this carbon atom;
M' is at each occurrence identically or differently M or an iridium complex, in which three bidentate ligands, which can be identical or different, coordinate to an iridium atom; in this connection, the bidentate ligands are chosen from the above-listed structures (L-1-1), (L-1-2), (L-2-1), (L-2-2), (L-2-3) or (L-4) to (L-31), with the difference that the ligands are not bonded to a bridge of the formula (5a");
R is at each occurrence identically or differently H, D, F, Cl, Br, I, N(R¹)₂, CN, NO₂, OH, COOH, C(=O)N(R¹)₂, Si(R¹)₃, B(OR¹)₂, C(=O)R¹, P(=O) (R¹)₂, S(=O)R¹, S(=O)₂R¹, OSO₂R¹, a straight-chain alkyl, alkoxy or thioalkoxy group with 1 to 20 carbon atoms or an alkenyl or alkynyl group with 2 to 20 carbon atoms or a branched or cyclic alkyl, alkoxy or thioalkoxy group with 3 to 20 carbon atoms, in which the alkyl, alkoxy, thioalkoxy, alkenyl or alkynyl group can each be substituted with one or more radicals R¹, in which one or more non-neighbouring CH₂ groups can be replaced by Si(R¹)₂, C=O, NR¹, O, S or CONR¹, or an aromatic or heteroaromatic ring system with 5 to 40 aromatic ring atoms, which can each be substituted by one or more radicals R¹, or an aryloxy or heteroaryloxy group with 5 to 40 aromatic ring atoms, which can be substituted by one or more radicals R¹; in this connection, two radicals R can also, with one another, form a ring system;
R' is at each occurrence identically or differently H, D, a straight-chain alkyl group with 1 to 20 carbon atoms or a branched or cyclic alkyl group with 3 to 20 carbon atoms, in which the alkyl group can each time be substituted with one or more radicals R¹ and in which one or more nonneighbouring CH₂ groups can be replaced by Si(R¹)₂, or an aromatic or heteroaromatic ring system with 5 to 40 aromatic ring atoms, which can each be substituted by one or more radicals R¹;
R¹ is at each occurrence identically or differently H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², a straight-chain alkyl, alkoxy or thioalkoxy group with 1 to 20 carbon atoms or an alkenyl or alkynyl group with 2 to 20 carbon atoms or a branched or cyclic alkyl, alkoxy or thioalkoxy group with 3 to 20 carbon atoms, in which the alkyl, alkoxy, thioalkoxy, alkenyl or alkynyl group can each be substituted with one or more radicals R² in which one or more nonneighbouring CH₂ groups can be replaced by Si(R²)₂, C=O, NR², O, S or CONR², or an aromatic or heteroaromatic ring system with 5 to 40 aromatic ring atoms, which can each be substituted by one or more radicals R², or an aryloxy or heteroaryloxy group with 5 to 40 aromatic ring atoms, which can be substituted by one or more radicals R²; in this connection, two or more radicals R¹ can, with one another, form a ring system;
R² is at each occurrence identically or differently H, D, F or an aliphatic, aromatic or heteroaromatic organic radical, in particular a hydrocarbon radical, with 1 to 20 carbon atoms, in which one or more H atoms can also be replaced by F;
Z is at each occurrence identically or differently a single bond or a linker, which covalently links together two or more complexes M and M', in which the linker is chosen from the group consisting of an aromatic or heteroaromatic ring system with 5 to 30 aromatic ring atoms, which can each be substituted by one or more radicals R¹, or an -Ar-[alkylene-Ar]ₚ- group with p = 1, 2 or 3, in which Ar identically or differently at each occurrence is each time an aromatic or heteroaromatic ring system with 5 to 30 aromatic ring atoms, which can be substituted by one or more radicals R¹, and alkylene is an alkylene group with 1 to 20 carbon atoms;
n is 1, 2 or 3;
m is at each occurrence identically or differently 0, 1 or 2.

2. Compound according to Claim 1, **characterized in that** n = 1 or 2 and m = 0 or 1.

3. Compound according to Claim 1 or 2, **characterized in that** Z is identically or differently at each occurrence chosen from a single bond or the groups of the formulae (Z-1) to (Z-8), 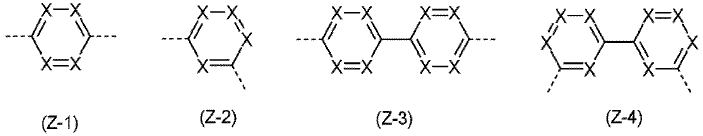 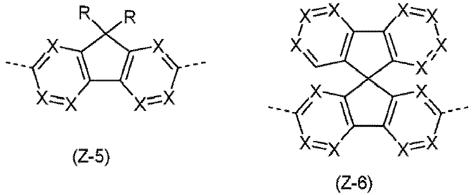 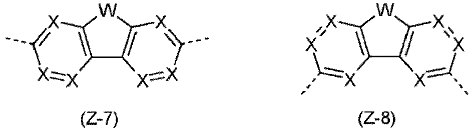 in which the dotted bonds represent the linkage of this group, R exhibits the meanings mentioned in Claim 1 and furthermore:
X is identically or differently at each occurrence CR or N;
W is identically or differently at each occurrence NR, O or S.

4. Compound according to one or more of Claims 1 to 3, **characterized in that** the three bidentate partial ligands in M are either chosen identically or that two of the bidentate partial ligands are chosen identically and the third bidentate partial ligand is different from the first two bidentate partial ligands and that each of the bidentate partial ligands is monoanionic.

5. Formulation, comprising at least one compound according to one or more of Claims 1 to 4 and at least one additional compound, in particular at least one solvent.

6. Use of a compound according to one or more of Claims 1 to 5 in an electronic device or as oxygen sensitizer or in photocatalysis.

7. Electronic device comprising at least one compound according to one or more of Claims 1 to 4, preferably chosen from the group consisting of organic electroluminescent devices, organic integrated circuits, organic field-effect transistors, organic thin-film transistors, organic light-emitting transistors, organic solar cells, organic optical detectors, organic photoreceptors, organic fieldquench devices, light-emitting electrochemical cells, oxygen sensors and organic laser diodes.

8. Electronic device according to Claim 7, in which an organic electroluminescent device is concerned, **characterized in that** the compound according to one or more of Claims 1 to 4 is used in one or more emitting layers.

## Revendications

1. Composé selon la formule (1) 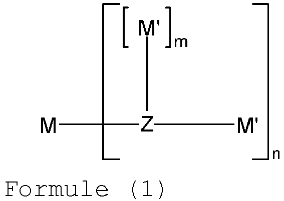 où, pour les symboles et indices utilisés, ce qui suit est d'application :
M représente un complexe d'iridium de la structure suivante 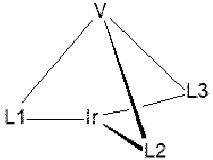
contenant un ligand tripode hexadentate, dans lequel trois ligands partiels bidentates L1, L2 et L3 se coordonnent à un atome d'iridium et les trois ligands partiels bidentates, qui peuvent être identiques ou différents, sont liés par l'intermédiaire d'un pont V de la formule suivante (5a") : 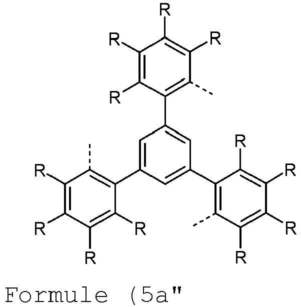
la liaison en pointillés représentant la liaison des ligands partiels bidentates à cette structure ;
et les ligands partiels bidentates L1, L2 et L3 étant choisis de manière identique ou différente en chaque occurrence parmi les structures des formules (L-1-1), (L-1-2), (L-2-1), (L-2-2), (L-2-3) ou (L-4) à (L-31), 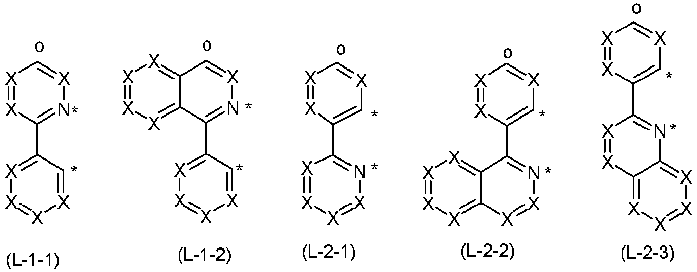 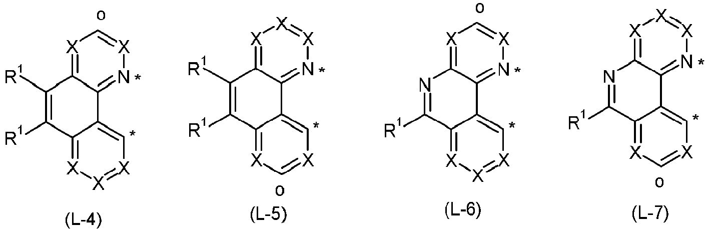 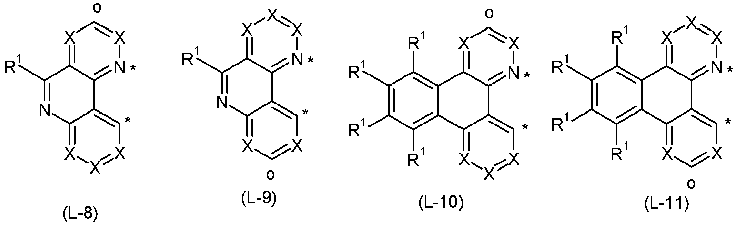 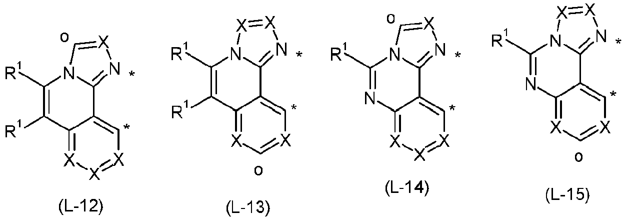 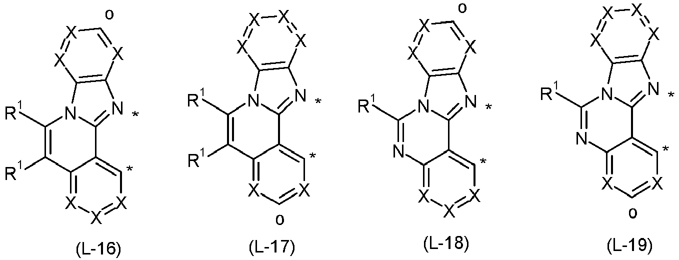 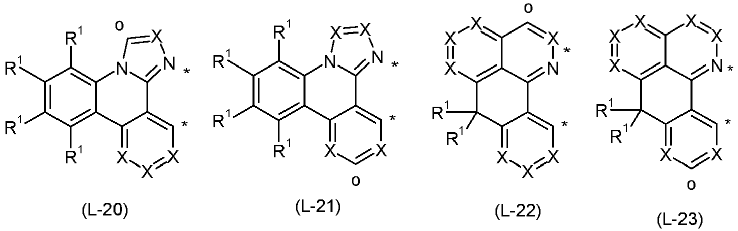 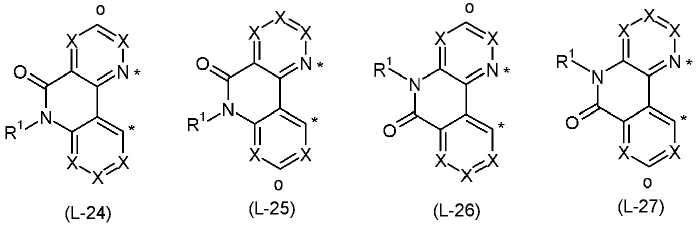 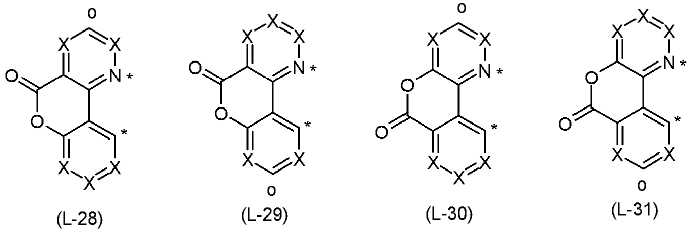
X en chaque occurrence étant identique ou différent et représentant CR ou N, à condition qu'au maximum deux symboles X par cycle représentent N et * indiquant la position de coordination sur l'iridium et "o" indiquant la position de la liaison au pont de formule (5a"), à condition que, lorsque Z est lié aux ligands partiels, un symbole X représente C et Z est lié à cet atome de carbone ;
M' représente, en chaque occurrence, de manière identique ou différente, M ou un complexe d'iridium, dans lequel trois ligands bidentates, qui peuvent être identiques ou différents, se coordonnent à un atome d'iridium ; les ligands bidentates étant choisis parmi les structures indiquées ci-dessus (L1-1), (L-1-2), (L-2-1), (L-2-2), (L-2-3) ou (L-4) à (L-31), avec comme différence que les ligands ne sont pas liés à un pont de formule (5a") ;
R représente, en chaque occurrence, de manière identique ou différente, H, D, F, Cl, Br, I, N(R¹)₂, CN, NO₂, OH, COOH, C(=O)N(R¹)₂, Si(R¹)₃, B(OR¹)₂, C(=O)R¹, P(=O) (R¹)₂, S(=O)R¹, S(=O)₂R¹, OSO₂R¹, un groupe alkyle, alcoxy ou thioalcoxy linéaire comprenant 1 à 20 atomes de carbone ou un groupe alcényle ou alcynyle comprenant 2 à 20 atomes de carbone ou un groupe alkyle, alcoxy ou thioalcoxy ramifié ou cyclique comprenant 3 à 20 atomes de carbone, le groupe alkyle, alcoxy, thioalcoxy, alcényle ou alcynyle pouvant à chaque fois être substitué par un ou plusieurs radicaux R¹, un ou plusieurs groupes CH₂ non adjacents pouvant être remplacés par Si(R¹)₂, C=O, NR¹, O, S ou CONR¹, ou un système cyclique aromatique ou hétéroaromatique comprenant 5 à 40 atomes de cycle aromatique, qui peut à chaque fois être substitué par un ou plusieurs radicaux R¹ ou un groupe aryloxy ou hétéroaryloxy comprenant 5 à 40 atomes de cycle aromatique, qui peut être substitué par un ou plusieurs radicaux R¹ ; deux radicaux R pouvant également former ensemble un système cyclique ;
R' représente, en chaque occurrence, de manière identique ou différente, H, D, un groupe alkyle linéaire comprenant 1 à 20 atomes de carbone ou un groupe alkyle ramifié ou cyclique comprenant 3 à 20 atomes de carbone, le groupe alkyle pouvant à chaque fois être substitué par un ou plusieurs radicaux R¹ et un ou plusieurs groupes CH₂ non adjacents pouvant être remplacés par Si(R¹)₂, ou un système cyclique aromatique ou hétéroaromatique comprenant 5 à 40 atomes de cycle aromatique, qui peut à chaque fois être substitué par un ou plusieurs radicaux R¹ ;
R¹ représente, en chaque occurrence, de manière identique ou différente, H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², un groupe alkyle, alcoxy ou thioalcoxy linéaire comprenant 1 à 20 atomes de carbone ou un groupe alcényle ou alcynyle comprenant 2 à 20 atomes de carbone ou un groupe alkyle, alcoxy ou thioalcoxy ramifié ou cyclique comprenant 3 à 20 atomes de carbone, le groupe alkyle, alcoxy, thioalcoxy, alcényle ou alcynyle pouvant à chaque fois être substitué par un ou plusieurs radicaux R², un ou plusieurs groupes CH₂ non adjacents pouvant être remplacés par Si(R²)₂, C=O, NR², O, S ou CONR², ou un système cyclique aromatique ou hétéroaromatique comprenant 5 à 40 atomes de cycle aromatique, qui peut à chaque fois être substitué par un ou plusieurs radicaux R² ou un groupe aryloxy ou hétéroaryloxy comprenant 5 à 40 atomes de cycle aromatique, qui peut être substitué par un ou plusieurs radicaux R² ; deux radicaux R¹ ou plus pouvant également former ensemble un système cyclique les uns avec les autres ;
R² représente, en chaque occurrence, de manière identique ou différente, H, D, F ou un radical organique, en particulier un radical hydrocarboné, aliphatique, aromatique et hétéroaromatique, comprenant 1 à 20 atomes de carbone, dans lequel un ou plusieurs atomes H peuvent également être remplacés par F ;
Z représente, en chaque occurrence, de manière identique ou différente, une simple liaison ou un lieur, qui relie deux complexes M et M' ou plus par covalence les uns aux autres, le lieur étant choisi dans le groupe constitué par un système cyclique aromatique ou hétéroaromatique comprenant 5 à 30 atomes de cycle aromatique, qui peut être substitué à chaque fois par un ou plusieurs radicaux R¹, ou un groupe -Ar-[alkylène-Ar]ₚ- avec p = 1, 2 ou 3, Ar représentant, de manière identique ou différente, en chaque occurrence, à chaque fois un système cyclique aromatique ou hétéroaromatique comprenant 5 à 30 atomes de cycle aromatique, qui peut être substitué par un ou plusieurs radicaux R¹ et alkylène représentant un groupe alkylène comprenant 1 à 20 atomes de carbone ;
n vaut 1, 2 ou 3 ;
m représente, en chaque occurrence, de manière identique ou différente, 0, 1 ou 2.

2. Composé selon la revendication 1, **caractérisé en ce que** n = 1 ou 2 et m = 0 ou 1.

3. Composé selon la revendication 1 ou 2, **caractérisé en ce que** Z est choisi, de manière identique ou différente, en chaque occurrence, parmi une simple liaison ou les groupes des formules (Z-1) à (Z-8), 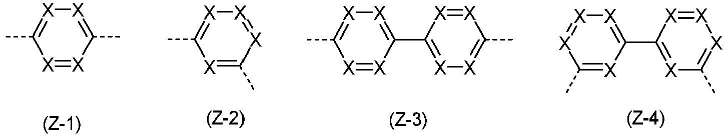 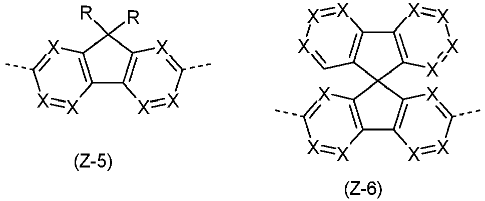 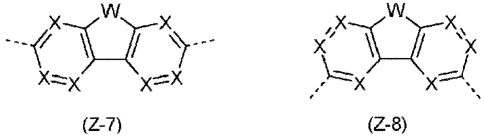 où les liaisons en pointillés indiquent la liaison de ces groupes, R présente les significations indiquées dans la revendication 1 et en outre :
X représente, en chaque occurrence, de manière identique ou différente, CR ou N ;
W représente, en chaque occurrence, de manière identique ou différente, NR, O ou S.

4. Composé selon l'une ou plusieurs des revendications 1 à 3, caractérisé soit en ce que les trois ligands partiels bidentates dans M sont choisis de manière identique soit en ce que deux des ligands partiels bidentates sont choisis de manière identique et le troisième ligand partiel bidentate est différent des deux premiers ligands partiels bidentates et en ce que chaque ligand partiel bidentate est monoanionique.

5. Formulation, contenant au moins un composé selon l'une ou plusieurs des revendications 1 à 4 et au moins un autre composé, en particulier un solvant.

6. Utilisation d'un composé selon l'une ou plusieurs des revendications 1 à 5 dans un dispositif électronique ou comme agent de sensibilisation à l'oxygène ou dans la photocatalyse.

7. Dispositif électronique, contenant au moins un composé selon l'une ou plusieurs des revendications 1 à 4, de préférence choisi dans le groupe constitué par les dispositifs organiques électroluminescents, les circuits organiques intégrés, les transistors organiques à effet de champ, les transistors organiques à film mince, les transistors organiques électroluminescents, les piles solaires organiques, les détecteurs organiques optiques, les photorécepteurs organiques, les dispositifs organiques à extinction de champ, les piles électrochimiques électroluminescentes, les capteurs d'oxygène ou les diodes laser organiques.

8. Dispositif électronique selon la revendication 7, le dispositif étant un dispositif organique électroluminescent, **caractérisé en ce que** le composé selon l'une ou plusieurs des revendications 1 à 4 est utilisé dans une ou plusieurs couches émettrices.
